(19) Europäisches Patentamt / European Patent Office / Office européen des brevets

(11) EP 3 173 435 B1

(12) # EUROPEAN PATENT SPECIFICATION

(45) Date of publication and mention of the grant of the patent:
**25.11.2020 Bulletin 2020/48**

(51) Int Cl.:
*C08G 61/12* (2006.01) *C08L 65/00* (2006.01)
*H01L 51/00* (2006.01) *H01L 51/30* (2006.01)
*H01L 51/46* (2006.01)

(21) Application number: **15003377.7**

(22) Date of filing: **26.11.2015**

(54) **SEMICONDUCTING MIXTURES**

HALBLEITENDE MISCHUNGEN

MÉLANGES DE SEMI-CONDUCTEURS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**31.05.2017 Bulletin 2017/22**

(73) Proprietors:
- **Raynergy Tek Inc.**
  **Hsinchu**
  **30075 (TW)**
- **Belectric OPV GmbH**
  **97509 Kolitzheim (DE)**
- **Le Centre National de la Recherche Scientifique**
  **75794 Paris (FR)**
- **Université de Pau et des Pays de l'Adour**
  **64012 Pau (FR)**

(72) Inventors:
- **MORSE, Graham**
  **SOUTHAMPTON SO14 5GP (GB)**
- **DISTLER, Andreas**
  **90443 NUERNBERG (DE)**
- **DOWLAND, Simon**
  **CAMBRIDGE CB4 3EW (GB)**
- **HIORNS, Roger**
  **64260 ARUDY (FR)**
- **BEGUE, Didier**
  **64160 SERRES MORLAAS (FR)**
- **SANTOS SILVA, Hugo**
  **64000 PAU (FR)**
- **RAMANITRA, Hasina**
  **64200 IVRY-SUR-SEINE (FR)**

(74) Representative: **Lawrie IP Limited**
**310 St. Vincent Street**
**Glasgow G2 5RG (GB)**

(56) References cited:
- **DATABASE WPI Week 201240 Thomson Scientific, London, GB; AN 2012-F11087 XP002754644, -& WO 2012/056904 A1 (SUMITOMO CHEM CO LTD) 3 May 2012 (2012-05-03)**
- **DATABASE WPI Week 201146 Thomson Scientific, London, GB; AN 2011-H34077 XP002754645, -& JP 2011 126993 A (TOKYO INST TECHNOLOGY NAT UNIV CORP) 30 June 2011 (2011-06-30)**
- **ROTAS G ET AL: "Regioselective triphenylamine-tether-directed synthesis of [60]fullerene bis-adducts", TETRAHEDRON LETTERS, PERGAMON, GB, vol. 50, no. 4, 28 January 2009 (2009-01-28), pages 398-401, XP025896559, ISSN: 0040-4039, DOI: 10.1016/J.TETLET.2008.11.022 [retrieved on 2008-11-12]**
- **MARTINEAU C ET AL: "SYNTHESIS AND ELECTRONIC PROPERTIES OF ADDUCTS OF OLIGOTHIENYLENEVINYLENES AND FULLERENE C60", ADVANCED MATERIALS, WILEY - V C H VERLAG GMBH & CO. KGAA, DE, vol. 14, no. 4, 19 February 2002 (2002-02-19), pages 283-287, XP001132507, ISSN: 0935-9648, DOI: 10.1002/1521-4095(20020219)14:4<283::AID-ADMA283>3.3.CO;2-D**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 173 435 B1

- GUBSKAYA V P ET AL: "Synthesis of new carbazole-containing fullerenopyrrolidines", RUSSIAN CHEMICAL BULLETIN, KLUWER ACADEMIC PUBLISHERS-PLENUM PUBLISHERS, NE, vol. 54, no. 2, 1 February 2005 (2005-02-01), pages 334-341, XP019224533, ISSN: 1573-9171, DOI: 10.1007/S11172-005-0256-X
- Roger C. Hiorns ET AL: "Alternatively linking fullerene and conjugated polymers", JOURNAL OF POLYMER SCIENCE, PART A: POLYMER CHEMISTRY, vol. 47, no. 9, 1 May 2009 (2009-05-01), pages 2304-2317, XP055326997, ISSN: 0887-624X, DOI: 10.1002/pola.23311

## Description

### Technical Field

The invention relates to novel semiconducting mixtures comprising a p-type organic semiconductor and a poly(pyrrolidinofullerene), to their use in organic photovoltaic (OPV) devices and organic photodetectors (OPD), and to OPV and OPD devices comprising these mixtures.

### Background

The photoactive layer in an organic photovoltaic (OPV) or an organic photodetector (OPD) device is composed of at least two components, a p-type semiconductor (or electron donor), such as a polymer, an oligomer or a defined molecular unit as first component, and a n-type semiconductor (or electron acceptor) such as a fullerene, substituted fullerene, graphene, metal oxide, or quantum dots as second component. In recent years, the stability of OPV devices has been investigated.

A promising type of OPV device is the bulk heterojunction (BHJ) OPV, wherein the p-type and the n-type semiconductor are mixed to form a blend. The p-type and n-type semiconductor in BHJ OPV devices should be selected such that they enable both effective charge generation and the creation of well-formed and stable bulk heterojunctions.

However, the properties of donor-acceptor blends hitherto available for BHJ OPV devices, such as solubility, light stability, power conversion efficiency and thermal stability limit their broad commercial application.

The interactions which take place during OPV operation are complicated which generates many pathways for OPV device degradation. Thus, various approaches to improving OPV operation stability have been attempted, which either focus on modification of the p-type semiconductor, modification of the n-type semiconductor, or modification by addition of a third component. Recent approaches to using modified n-type semiconductors for improvements towards operational stability have been limited to only a few selected candidates for the case of fullerene n-type materials, like for example PCBM-$C_{60}$.

As an alternative to the hitherto used substituted fullerenes it was recently proposed to use polymers containing fullerenes or fullerene derivatives in their side chain, as in Adv. Funct. Mater. 2011, 21, 1723-1732; Chem. Rev. 2006, 106, 5136-5190; Chem. Commun. 2010, 46, 6723-6725. However, current examples of such polymers have shown a tradeoff between device stability and device performance.

Thus there is still a need for improved combinations of p-type and n-type semiconductors which are suitable for use in OPV devices, and in particular in BHJ OPV devices, which show high light and thermal stability, good power conversion efficiency, good structural organization and film-forming properties, exhibit good electronic properties, especially a high charge carrier mobility, and good processability, especially a high solubility in organic solvents.

It was an aim of the present invention to provide a combination of a p-type and n-type semiconductor which provides one or more of the above-mentioned advantageous properties. Another aim of the invention was to extend the pool of p-type/n-type semiconductor combinations available to the expert. Other aims of the present invention are immediately evident to the expert from the following detailed description.

The inventors of the present invention have found that one or more of the above aims can be achieved by providing a semiconducting mixture as disclosed and claimed hereinafter, which contain a p-type semiconductor, which is for example a conjugated polymer, an n-type semiconductor which is a poly(pyrrolidinofullerene) that comprises in its backbone a fullerene repeat unit that is connected to adjacent units via pyrrolidino adducts, and optionally a second n-type semiconductor like for example PCBM-C60 fullerene. The poly(pyrrolidinofullerene) offers advantages in terms of solution rheology, film forming properties and film homogeneity, allowing them to be easily incorporated in printing processes. In addition, specific variation in the nature of the substituents at the poly(pyrrolidinofullerene) offer significant unexpected advantages in the stability of OPV devices over prior art material.

JP 2011-126993A1 and WO 2012/056904A1 disclose a C60 fullerene that is crosslinked via three or more pyrrolidine adducts formed by reaction of C60 with 2,4-diformyl-1,3,5-trialkoxybenzene and sarcosine (N-methyl glycine), and its use in organic electroluminescent devices. However, they do not disclose or suggest the mixture or its use in OPV or OPD devices as disclosed and claimed hereinafter. Hiorns et al. describe the preparation of alternating copolymers comprising poly(3-hexylthiophene) and bis(N-methylpyrrolidine) fullerene as constituents for use in photovoltaic devices in J. Polym. Sci. Pol. Chem., 2009, 47(9), 2304 - 2317.

### Summary

The present disclosure relates to a mixture comprising a polyfullerene consisting of di- or polyvalent units of formula I1 and divalent units of formula I2 (hereinafter referred to as "polyfullerene")

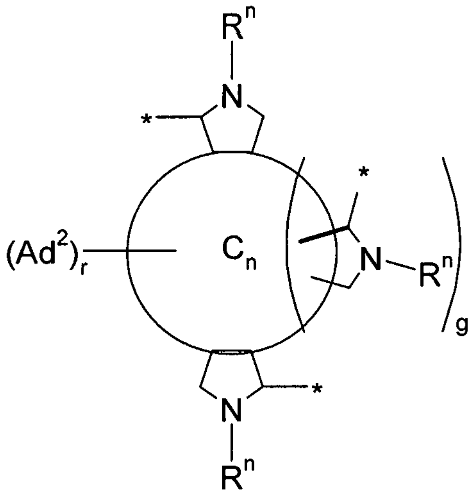

I1

*-Ar-* I2

wherein the individual radicals, independently of each other, and on each occurrence identically or differently, have the following meanings

| | |
|---|---|
| $C_n$ | a fullerene composed of n carbon atoms, optionally with one or more atoms trapped inside, |
| $R^n$ | alkyl with 1 to 12 C-atoms, preferably methyl, |
| g | 0 or an integer ≥1, preferably 0 or an integer from 1 to 6, |
| Ar | $-CX^1=CX^2-$, -C≡C-, a saturated or unsaturated carbo- or heterocyclic group, or an aryl, heteroaryl, aryloxy or heteroaryloxy group, wherein each of the aforementioned cyclic groups is mono- or polycyclic, does optionally contain fused rings, and is optionally substituted by one or more identical or different groups $R^A$ or L, |
| $X^1$ and $X^2$ | H, F, Cl, CN or alkyl with 1 to 12 C-atoms, |
| $R^A$ | H, halogen, CN an alkyl group with 1 to 50 C atoms, which is straight-chain, branched or cyclic, and in which one or more $CH_2$ groups are optionally replaced by -O-, -S-,-C(=O)-, -C(=S)-, -C(=O)-O-, -O-C(=O)-, $-NR^0-$, $-C(=O)-NR^0-$, $-NR^0-C(=O)-$, $-SiR^0R^{00}-$, $-CF_2-$, $-CR^0=CR^{00}-$,$-CR^0=N-$, -N=N- or -C≡C- in such a manner that O and/or S atoms are not linked directly to one another, and/or in which one or more H atoms are optionally replaced by F, Cl or CN, and/or in which one or more C or H atoms are optionally replaced by a cationic or anionic group, a saturated or unsaturated carbo- or heterocyclic group, or an aryl, heteroaryl, aryloxy or heteroaryloxy group, wherein each of the aforementioned cyclic groups is mono- or polycyclic, does optionally contain fused rings, and is optionally substituted by one or more identical or different groups L, |
| L | F, Cl, -CN, or an alkyl group with 1 to 20 C atoms, which is straight-chain, branched or cyclic, and in which one or more $CH_2$ groups are optionally replaced by -O-, -S-,-C(=O)-, -C(=S)-, -C(=O)-O-, -O-C(=O)-, $-NR^0-$, $-C(=O)-NR^0-$, $-NR^0-C(=O)-$, $-SiR^0R^{00}-$, $-CF_2-$, $-CR^0=CR^{00}-$,$-CR^0=N-$, -N=N- or -C≡C- in such a manner that O and/or S atoms are not linked directly to one another, and/or in which one or more H atoms are optionally replaced by F, Cl or CN, and/or in which one or more C or H atoms are optionally replaced by a cationic or anionic group, |
| $R^0$ and $R^{00}$ | H or alkyl with 1 to 12 C-atoms, |
| $Ad^2$ | a second adduct, or a combination of second adducts, appended to the fullerene $C_n$ with any connectivity, |
| r | 0, an integer ≥ 1, or a non-integer > 0, |

said mixture further comprising a p-type organic semiconductor, and optionally further comprising a fullerene or fullerene derivative that is different from the polyfullerene. The mixtures of the present invention as claimed are specified in the appended claims.

The invention further relates to novel polyfullerenes, wherein the unit Ar of formula I2 is phenylene-1,4-diyl as further specified in the appended claims.

The invention further relates to the use of a polyfullerene or mixture as described above and below in the photoactive layer of an organic electronic (OE) device that converts light into electric current, preferably in an organic photovoltaic device (OPV) or an organic photodetector (OPD).

The invention further relates to a formulation comprising a polyfullerene or mixture as described above and below, and further comprising one or more solvents, preferably selected from organic solvents, very preferably from non-chlorinated organic solvents, most preferably from non-halogenated organic solvents.

The invention further relates to a bulk heterojunction (BHJ) which comprises, or is being formed from, a polyfullerene, mixture or formulation as described above and below.

The invention further relates to a photoactive layer in an OE device that converts light into electric current, preferably in an OPV or OPD device, wherein said photoactive layer comprises a polyfullerene, mixture, formulation or BHJ as described above and below.

The invention further relates to an OE device that converts light into electric current, preferably an OPV or OPD, which comprises in its photoactive layer a polyfullerene, mixture or BHJ as described above and below.

The invention further relates to an OE device that converts light into electric current, preferably an OPV or OPD device, wherein the photoactive layer is prepared using a polyfullerene, mixture or formulation as described above and below.

The OE, OPV and OPD devices include, without limitation, organic solar cells, dye sensitized solar cells (DSSC), perovskite-based solar cells, laser diodes, Schottky diodes, organic sensors and photoconductors.

## Brief Description of the Drawings

**Fig. 1** shows the power conversion efficiency as a function of time for an OPV device according to Examples C1 and D1.

**Fig. 2** shows the power conversion efficiency as a function of time for an OPV device according to Examples C2 and D2-D4.

## Terms and Definitions

As used herein, any reference to "formula I" or "formula I and its subformulae" is understood to be inclusive of any specific subformula of formula I as shown hereinafter.

As used herein, the term "fullerene" will be understood to mean a compound composed of an even number of carbon atoms, which form a cage-like fused-ring having a surface which comprises six-membered rings and five-membered rings, usually with twelve five-membered rings and the rest six-membered rings, optionally with one or more atoms trapped inside. The surface of the fullerene may also contain hetero atoms like B or N.

As used herein, the term "endohedral fullerene" will be understood to mean a fullerene with one or more atoms trapped inside.

As used herein, the term "metallofullerene" will be understood to mean an endohedral fullerene wherein the atoms trapped inside are selected from metal atoms.

As used herein, the term "carbon based fullerene" will be understood to mean a fullerene without any atoms trapped inside, and wherein the surface is comprised only of carbon atoms.

As used herein, the term "polymer" will be understood to mean a molecule of high relative molecular mass, the structure of which essentially comprises the multiple repetition of units derived, actually or conceptually, from molecules of low relative molecular mass (Pure Appl. Chem., 1996, 68, 2291). The term "oligomer" will be understood to mean a molecule of intermediate relative molecular mass, the structure of which essentially comprises a small plurality of units derived, actually or conceptually, from molecules of lower relative molecular mass (Pure Appl. Chem., 1996, 68, 2291). In the present invention, a polymer will be understood to mean a compound having $> 1$, i.e. at least 2 repeat units, preferably $\geq 5$ repeat units, and an oligomer will be understood to mean a compound with $> 1$ and $< 10$, preferably $< 5$, repeat units.

Further, as used herein, the term "polymer" will be understood to mean a molecule that encompasses a backbone (also referred to as "main chain") of one or more distinct types of repeat units (the smallest constitutional unit of the

molecule) and is inclusive of the commonly known terms "oligomer", "copolymer", "homopolymer" and the like. Further, it will be understood that the term polymer is inclusive of, in addition to the polymer itself, residues from initiators, catalysts and other elements attendant to the synthesis of such a polymer, where such residues are understood as not being covalently incorporated thereto. Further, such residues and other elements, while normally removed during post polymerization purification processes, are typically mixed or co-mingled with the polymer such that they generally remain with the polymer when it is transferred between vessels or between solvents or dispersion media.

As used herein, in a formula showing a polymer or a repeat unit, an asterisk (*) will be understood to mean a chemical linkage to an adjacent unit or to a terminal group in the polymer backbone. In a ring, like for example a benzene or thiophene ring, an asterisk (*) will be understood to mean a C atom that is fused to an adjacent ring.

As used herein, the terms "repeat unit", "repeating unit" and "monomeric unit" are used interchangeably and will be understood to mean the constitutional repeating unit (CRU), which is the smallest constitutional unit the repetition of which constitutes a regular macromolecule, a regular oligomer molecule, a regular block or a regular chain (Pure Appl. Chem., 1996, 68, 2291). As further used herein, the term "unit" will be understood to mean a structural unit which can be a repeating unit on its own, or can together with other units form a constitutional repeating unit.

As used herein, a "terminal group" will be understood to mean a group that terminates a polymer backbone. The expression "in terminal position in the backbone" will be understood to mean a divalent unit or repeat unit that is linked at one side to such a terminal group and at the other side to another repeat unit. Such terminal groups include endcap groups, or reactive groups that are attached to a monomer forming the polymer backbone which did not participate in the polymerisation reaction, like for example a group having the meaning of $R^{23}$ or $R^{24}$ as defined below.

As used herein, the term "endcap group" will be understood to mean a group that is attached to, or replacing, a terminal group of the polymer backbone. The endcap group can be introduced into the polymer by an endcapping process. Endcapping can be carried out for example by reacting the terminal groups of the polymer backbone with a monofunctional compound ("endcapper") like for example an alkyl- or arylhalide, an alkyl- or arylstannane or an alkyl- or arylboronate. The endcapper can be added for example after the polymerisation reaction. Alternatively the endcapper can be added in situ to the reaction mixture before or during the polymerisation reaction. In situ addition of an endcapper can also be used to terminate the polymerisation reaction and thus control the molecular weight of the forming polymer. Typical endcap groups are for example H, phenyl and lower alkyl.

As used herein, the term "small molecule" will be understood to mean a monomeric compound which typically does not contain a reactive group by which it can be reacted to form a polymer, and which is designated to be used in monomeric form. In contrast thereto, the term "monomer" unless stated otherwise will be understood to mean a monomeric compound that carries one or more reactive functional groups by which it can be reacted to form a polymer.

As used herein, the terms "donor" or "donating" and "acceptor" or "accepting" will be understood to mean an electron donor or electron acceptor, respectively. "Electron donor" will be understood to mean a chemical entity that donates electrons to another compound or another group of atoms of a compound. "Electron acceptor" will be understood to mean a chemical entity that accepts electrons transferred to it from another compound or another group of atoms of a compound. See also International Union of Pure and Applied Chemistry, Compendium of Chemical Technology, Gold Book, Version 2.3.2, 19. August 2012, pages 477 and 480.

As used herein, the term "n-type" or "n-type semiconductor" will be understood to mean an extrinsic semiconductor in which the conduction electron density is in excess of the mobile hole density, and the term "p-type" or "p-type semiconductor" will be understood to mean an extrinsic semiconductor in which mobile hole density is in excess of the conduction electron density (see also, J. Thewlis, Concise Dictionary of Physics, Pergamon Press, Oxford, 1973).

As used herein, the term "leaving group" will be understood to mean an atom or group (which may be charged or uncharged) that becomes detached from an atom in what is considered to be the residual or main part of the molecule taking part in a specified reaction (see also Pure Appl. Chem., 1994, 66, 1134).

As used herein, the term "conjugated" will be understood to mean a compound (for example a polymer) that contains mainly C atoms with $sp^2$-hybridisation (or optionally also sp-hybridisation), and wherein these C atoms may also be replaced by hetero atoms. In the simplest case this is for example a compound with alternating C-C single and double (or triple) bonds, but is also inclusive of compounds with aromatic units like for example 1,4-phenylene. The term "mainly" in this connection will be understood to mean that a compound with naturally (spontaneously) occurring defects, or with defects included by design, which may lead to interruption of the conjugation, is still regarded as a conjugated compound.

As used herein, unless stated otherwise the molecular weight is given as the number average molecular weight Mn or weight average molecular weight Mw, which is determined by gel permeation chromatography (GPC) against polystyrene standards in eluent solvents such as tetrahydrofuran, trichloromethane (TCM, chloroform), chlorobenzene or 1,2,4-trichlorobenzene. Unless stated otherwise, 1,2,4-trichlorobenzene is used as solvent. The degree of polymerization, also referred to as total number of repeat units, n, will be understood to mean the number average degree of polymerization given as n = Mn/Mu, wherein Mn is the number average molecular weight and Mu is the molecular weight of the single repeat unit, see J. M. G. Cowie, Polymers: Chemistry & Physics of Modern Materials, Blackie, Glasgow, 1991.

As used herein, the term "dispersity", represented by the symbol "Đ", will be understood to mean the dispersion of distribution of molecular weights of a polymer or oligomer, expressed by the ratio $M_w/M_n$ (see also Pure Appl. Chem. 2009, 81, 351).

As used herein, the term "carbyl group" will be understood to mean any monovalent or multivalent organic moiety which comprises at least one carbon atom either without any non-carbon atoms (like for example -C≡C-), or optionally combined with at least one non-carbon atom such as B, N, O, S, P, Si, Se, As, Te or Ge (for example carbonyl etc.).

As used herein, the term "hydrocarbyl group" will be understood to mean a carbyl group that does additionally contain one or more H atoms and optionally contains one or more hetero atoms like for example B, N, O, S, P, Si, Se, As, Te or Ge.

As used herein, the term "hetero atom" will be understood to mean an atom in an organic compound that is not a H- or C-atom, and preferably will be understood to mean B, N, O, S, P, Si, Se, As, Te or Ge.

A carbyl or hydrocarbyl group comprising a chain of 3 or more C atoms may be straight-chain, branched and/or cyclic, and may include spiro-connected and/or fused rings.

Preferred carbyl and hydrocarbyl groups include alkyl, alkoxy, alkylcarbonyl, alkoxycarbonyl, alkylcarbonyloxy and alkoxycarbonyloxy, each of which is optionally substituted and has 1 to 40, preferably 1 to 25, very preferably 1 to 18 C atoms, furthermore optionally substituted aryl or aryloxy having 6 to 40, preferably 6 to 25 C atoms, furthermore alkylaryloxy, arylcarbonyl, aryloxycarbonyl, arylcarbonyloxy and aryloxycarbonyloxy, each of which is optionally substituted and has 6 to 40, preferably 7 to 40 C atoms, wherein all these groups do optionally contain one or more hetero atoms, preferably selected from B, N, O, S, P, Si, Se, As, Te and Ge.

Further preferred carbyl and hydrocarbyl group include for example: a $C_1$-$C_{40}$ alkyl group, a $C_1$-$C_{40}$ fluoroalkyl group, a $C_1$-$C_{40}$ alkoxy or oxaalkyl group, a $C_2$-$C_{40}$ alkenyl group, a $C_2$-$C_{40}$ alkynyl group, a $C_3$-$C_{40}$ allyl group, a $C_4$-$C_{40}$ alkyldienyl group, a $C_4$-$C_{40}$ polyenyl group, a $C_2$-$C_{40}$ ketone group, a $C_2$-$C_{40}$ ester group, a $C_6$-$C_{18}$ aryl group, a $C_6$-$C_{40}$ alkylaryl group, a $C_6$-$C_{40}$ arylalkyl group, a $C_4$-$C_{40}$ cycloalkyl group, a $C_4$-$C_{40}$ cycloalkenyl group, and the like. Preferred among the foregoing groups are a $C_1$-$C_{20}$ alkyl group, a $C_1$-$C_{20}$ fluoroalkyl group, a $C_2$-$C_{20}$ alkenyl group, a $C_2$ -$C_{20}$ alkynyl group, a $C_3$-$C_{20}$ allyl group, a $C_4$-$C_{20}$ alkyldienyl group, a $C_2$-$C_{20}$ ketone group, a $C_2$-$C_{20}$ ester group, a $C_6$-$C_{12}$ aryl group, and a $C_4$-$C_{20}$ polyenyl group, respectively.

Also included are combinations of groups having carbon atoms and groups having hetero atoms, like e.g. an alkynyl group, preferably ethynyl, that is substituted with a silyl group, preferably a trialkylsilyl group.

The carbyl or hydrocarbyl group may be an acyclic group or a cyclic group. Where the carbyl or hydrocarbyl group is an acyclic group, it may be straight-chain or branched. Where the carbyl or hydrocarbyl group is a cyclic group, it may be a non-aromatic carbocyclic or heterocyclic group, or an aryl or heteroaryl group.

A non-aromatic carbocyclic group as referred to above and below is saturated or unsaturated and preferably has 4 to 30 ring C atoms. A non-aromatic heterocyclic group as referred to above and below preferably has 4 to 30 ring C atoms, wherein one or more of the C ring atoms are optionally replaced by a hetero atom, preferably selected from N, O, S, Si and Se, or by a -S(O)- or $-S(O)_2-$ group. The non-aromatic carbo- and heterocyclic groups are mono- or polycyclic, may also contain fused rings, preferably contain 1, 2, 3 or 4 fused or unfused rings, and are optionally substituted with one or more groups $L^S$, wherein

$L^S$ is selected from halogen, -CN, -NC, -NCO, -NCS, -OCN, -SCN, $-C(=O)NR^0R^{00}$, $-C(=O)X^0$, $-C(=O)R^0$, $-NH_2$, $-NR^0R^{00}$, -SH, $-SR^0$, $-SO_3H$, $-SO_2R^0$, -OH, $-NO_2$, $-CF_3$, $-SF_5$, optionally substituted silyl, or carbyl or hydrocarbyl with 1 to 40 C atoms that is optionally substituted and optionally comprises one or more hetero atoms, and is preferably alkyl, alkoxy, thioalkyl, alkylcarbonyl, alkoxycarbonyl or alkoxycarbonyloxy with 1 to 20 C atoms that is optionally fluorinated, $X^0$ is halogen, preferably F, Cl or Br, and $R^0$, $R^{00}$ have the meanings given above and below, and preferably denote H or alkyl with 1 to 12 C atoms.

Preferred substituents $L^S$ are selected from halogen, most preferably F, or alkyl, alkoxy, oxaalkyl, thioalkyl, fluoroalkyl and fluoroalkoxy with 1 to 12 C atoms, or alkenyl or alkynyl with 2 to 12 C atoms.

Preferred non-aromatic carbocyclic or heterocyclic groups are tetrahydrofuran, indane, pyran, pyrrolidine, piperidine, cyclopentane, cyclohexane, cycloheptane, cyclopentanone, cyclohexanone, dihydro-furan-2-one, tetrahydro-pyran-2-one and oxepan-2-one.

An aryl group as referred to above and below preferably has 4 to 30 ring C atoms, is mono- or polycyclic and may also contain fused rings, preferably contains 1, 2, 3 or 4 fused or unfused rings, and is optionally substituted with one or more groups $L^S$ as defined above.

A heteroaryl group as referred to above and below preferably has 4 to 30 ring C atoms, wherein one or more of the C ring atoms are replaced by a hetero atom, preferably selected from N, O, S, Si and Se, is mono- or polycyclic and may also contain fused rings, preferably contains 1, 2, 3 or 4 fused or unfused rings, and is optionally substituted with one or more groups L as defined above.

As used herein, "arylene" will be understood to mean a divalent aryl group, and "heteroarylene" will be understood to mean a divalent heteroaryl group, including all preferred meanings of aryl and heteroaryl as given above and below.

Preferred aryl and heteroaryl groups are phenyl in which, in addition, one or more CH groups may be replaced by N, naphthalene, thiophene, selenophene, thienothiophene, dithienothiophene, fluorene and oxazole, all of which can be unsubstituted, mono- or polysubstituted with L as defined above. Very preferred rings are selected from pyrrole, preferably N-pyrrole, furan, pyridine, preferably 2- or 3-pyridine, pyrimidine, pyridazine, pyrazine, triazole, tetrazole, pyrazole, imidazole, isothiazole, thiazole, thiadiazole, isoxazole, oxazole, oxadiazole, thiophene, preferably 2-thiophene, selenophene, preferably 2-selenophene, thieno[3,2-b]thiophene, thieno[2,3-b]thiophene, furo[3,2-b]furan, furo[2,3-b]furan, seleno[3,2-b]selenophene, seleno[2,3-b]selenophene, thieno[3,2-b]selenophene, thieno[3,2-b]furan, indole, isoindole, benzo[b]furan, benzo[b]thiophene, benzo[1,2-b;4,5-b']dithiophene, benzo[2,1-b;3,4-b']dithiophene, quinole, 2-methylquinole, isoquinole, quinoxaline, quinazoline, benzotriazole, benzimidazole, benzothiazole, benzisothiazole, benzisoxazole, benzoxadiazole, benzoxazole, benzothiadiazole, 4H-cyclopenta[2,1-b;3,4-b']dithiophene, 7H-3,4-dithia-7-silacyclopenta[a]pentalene, all of which can be unsubstituted, mono- or polysubstituted with $L^S$ as defined above. Further examples of aryl and heteroaryl groups are those selected from the groups shown hereinafter.

An alkyl group or an alkoxy group, i.e., where the terminal $CH_2$ group is replaced by -O-, can be straight-chain or branched. It is preferably a straight-chain, has 2, 3, 4, 5, 6, 7, 8, 10, 12, 14, 16, 18, 20, 22 or 24 carbon atoms and accordingly is preferably ethyl, propyl, butyl, pentyl, hexyl, heptyl, octyl, decyl, dodecyl, tetradecyl, hexadecyl, octadecyl, eicosyl, docosyl, tetracosyl, ethoxy, propoxy, butoxy, pentoxy, hexoxy, heptoxy, octoxy, decoxy, dodecoxy, tetradecoxy, hexadecoxy, octadecoxy, eicosoxy, docosoxy, tetracosoxy, furthermore methyl, nonyl, undecyl, tridecyl, pentadecyl, nonoxy, undecoxy or tridecoxy, for example.

An alkenyl group, *i.e.,* wherein one or more $CH_2$ groups are replaced by - CH=CH- can be straight-chain or branched. It is preferably straight-chain, has 2 to 10 C atoms and accordingly is preferably vinyl, prop-1-, or prop-2-enyl, but-1-, 2- or but-3-enyl, pent-1-, 2-, 3- or pent-4-enyl, hex-1-, 2-, 3-, 4- or hex-5-enyl, hept-1-, 2-, 3-, 4-, 5- or hept-6-enyl, oct-1-, 2-, 3-, 4-, 5-, 6- or oct-7-enyl, non-1-, 2-, 3-, 4-, 5-, 6-, 7- or non-8-enyl, dec-1-, 2-, 3-, 4-, 5-, 6-, 7-, 8- or dec-9-enyl.

Especially preferred alkenyl groups are $C_2$-$C_7$-1E-alkenyl, $C_4$-$C_7$-3E-alkenyl, $C_5$-$C_7$-4-alkenyl, $C_6$-$C_7$-5-alkenyl and $C_7$-6-alkenyl, in particular $C_2$-$C_7$-1E-alkenyl, $C_4$-$C_7$-3E-alkenyl and $C_5$-$C_7$-4-alkenyl. Examples for particularly preferred alkenyl groups are vinyl, 1E-propenyl, 1E-butenyl, 1E-pentenyl, 1E-hexenyl, 1E-heptenyl, 3-butenyl, 3E-pentenyl, 3E-hexenyl, 3E-heptenyl, 4-pentenyl, 4Z-hexenyl, 4E-hexenyl, 4Z-heptenyl, 5-hexenyl, 6-heptenyl and the like. Groups having up to 5 C atoms are generally preferred.

An oxaalkyl group, *i.e.,* where one $CH_2$ group is replaced by -O-, is preferably straight-chain 2-oxapropyl (=methoxymethyl), 2-(=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.

In an alkyl group wherein one $CH_2$ group is replaced by -O- and one $CH_2$ group is replaced by -C(O)-, these radicals are preferably neighboured. Accordingly these radicals together form a carbonyloxy group -C(O)-O- or an oxycarbonyl group -O-C(O)-. Preferably this group is straight-chain and has 2 to 6 C atoms. It is accordingly preferably acetyloxy, propionyloxy, butyryloxy, pentanoyloxy, hexanoyloxy, acetyloxymethyl, propionyloxymethyl, butyryloxymethyl, pentanoyloxymethyl, 2-acetyloxyethyl, 2-propionyloxyethyl, 2-butyryloxyethyl, 3-acetyloxypropyl, 3-propionyloxypropyl, 4-acetyloxybutyl, methoxycarbonyl, ethoxycarbonyl, propoxycarbonyl, butoxycarbonyl, pentoxycarbonyl, methoxycarbonylmethyl, ethoxycarbonylmethyl, propoxycarbonylmethyl, butoxycarbonylmethyl, 2-(methoxycarbonyl)ethyl, 2-(ethoxycarbonyl)ethyl, 2-(propoxycarbonyl)ethyl, 3-(methoxycarbonyl)propyl, 3-(ethoxycarbonyl)propyl, 4-(methoxycarbonyl)-butyl.

An alkyl group wherein two or more $CH_2$ groups are replaced by -O- and/or -C(O)O- can be straight-chain or branched. It is preferably straight-chain and has 3 to 12 C atoms. Accordingly it is preferably bis-carboxymethyl, 2,2-bis-carboxy-ethyl, 3,3-bis-carboxy-propyl, 4,4-bis-carboxybutyl, 5,5-bis-carboxy-pentyl, 6,6-bis-carboxy-hexyl, 7,7-bis-carboxyheptyl, 8,8-bis-carboxy-octyl, 9,9-bis-carboxy-nonyl, 10,10-bis-carboxydecyl, bis-(methoxycarbonyl)-methyl, 2,2-bis-(methoxycarbonyl)-ethyl, 3,3-bis-(methoxycarbonyl)-propyl, 4,4-bis-(methoxycarbonyl)-butyl, 5,5-bis-(methoxycarbonyl)-pentyl, 6,6-bis-(methoxycarbonyl)-hexyl, 7,7-bis-(methoxycarbonyl)-heptyl, 8,8-bis-(methoxycarbonyl)-octyl, bis-(ethoxycarbonyl)-methyl, 2,2-bis-(ethoxycarbonyl)-ethyl, 3,3-bis-(ethoxycarbonyl)-propyl, 4,4-bis-(ethoxycarbonyl)-butyl, 5,5-bis-(ethoxycarbonyl)-hexyl.

A thioalkyl group, i.e., where one $CH_2$ group is replaced by -S-, is preferably straight-chain thiomethyl ($-SCH_3$), 1-thioethyl ($-SCH_2CH_3$), 1-thiopropyl (= $-SCH_2CH_2CH_3$), 1- (thiobutyl), 1-(thiopentyl), 1-(thiohexyl), 1-(thioheptyl), 1-(thiooctyl), 1-(thiononyl), 1-(thiodecyl), 1-(thioundecyl) or 1-(thiododecyl), wherein preferably the $CH_2$ group adjacent to the $sp^2$ hybridised vinyl carbon atom is replaced.

A fluoroalkyl group is perfluoroalkyl $C_iF_{2i+1}$, wherein i is an integer from 1 to 15, in particular $CF_3$, $C_2F_5$, $C_3F_7$, $C_4F_9$, $C_5F_{11}$, $C_6F_{13}$, $C_7F_{15}$ or $C_8F_{17}$, very preferably $C_6F_{13}$, or partially fluorinated alkyl, preferably with 1 to 15 C atoms, in particular 1,1-difluoroalkyl, all of the aforementioned being straight-chain or branched.

Preferably "fluoroalkyl" means a partially fluorinated (i.e. not perfluorinated) alkyl group.

Alkyl, alkoxy, alkenyl, oxaalkyl, thioalkyl, carbonyl and carbonyloxy groups can be achiral or chiral groups. Particularly preferred chiral groups are 2-butyl (=1-methylpropyl), 2-methylbutyl, 2-methylpentyl, 3-methylpentyl, 2-ethylhexyl, 2-butyloctyl, 2-hexyldecyl, 2-octyldodecyl, 2-propylpentyl, in particular 2-methylbutyl, 2-methylbutoxy, 2-methylpentoxy, 3-methylpentoxy, 2-ethyl-hexoxy, 2-butyloctoxyo, 2-hexyldecoxy, 2-octyldodecoxy, 1-methylhexoxy, 2-octyloxy, 2-oxa-3-methylbutyl, 3-oxa-4-methyl-pentyl, 4-methylhexyl, 2-hexyl, 2-octyl, 2-nonyl, 2-decyl, 2-dodecyl, 6-methoxyoctoxy, 6-methyloctoxy, 6-methyloctanoyloxy, 5-methylheptyloxy-carbonyl, 2-methylbutyryloxy, 3-methylvaleroyloxy, 4-methylhexanoyloxy, 2-chloropropionyloxy, 2-chloro-3-methylbutyryloxy, 2-chloro-4-methyl-valeryl-oxy, 2-chloro-3-methylvaleryloxy, 2-methyl-3-oxapentyl, 2-methyl-3-oxa-hexyl, 1-methoxypropyl-2-oxy, 1-ethoxypropyl-2-oxy, 1-propoxypropyl-2-oxy, 1-butoxypropyl-2-oxy, 2-fluorooctyloxy, 2-fluorodecyloxy, 1,1,1-trifluoro-2-octyloxy, 1,1,1-trifluoro-2-octyl, 2-fluoromethyloctyloxy for example. Very preferred are 2-ethylhexyl, 2-butyloctyl, 2-hexyldecyl, 2-octyldodecyl, 2-hexyl, 2-octyl, 2-octyloxy, 1,1,1-trifluoro-2-hexyl, 1,1,1-trifluoro-2-octyl and 1,1,1-trifluoro-2-octyloxy.

Preferred achiral branched groups are isopropyl, isobutyl (=methylpropyl), isopentyl (=3-methylbutyl), tert. butyl, isopropoxy, 2-methyl-propoxy and 3-methylbutoxy.

In a preferred embodiment, the alkyl groups are independently of each other selected from primary, secondary or tertiary alkyl or alkoxy with 1 to 30 C atoms, wherein one or more H atoms are optionally replaced by F, or aryl, aryloxy, heteroaryl or heteroaryloxy that is optionally alkylated or alkoxylated and has 4 to 30 ring atoms. Very preferred groups of this type are selected from the group consisting of the following formulae

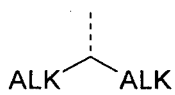
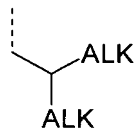
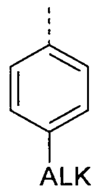
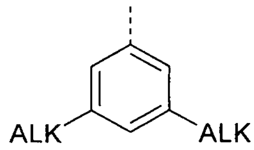

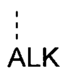
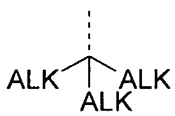
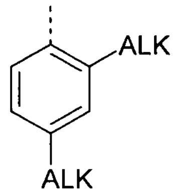
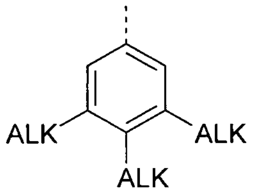

wherein "ALK" denotes optionally fluorinated, preferably linear, alkyl or alkoxy with 1 to 20, preferably 1 to 12 C-atoms, in case of tertiary groups very preferably 1 to 9 C atoms, and the dashed line denotes the link to the ring to which these groups are attached. Especially preferred among these groups are those wherein all ALK subgroups are identical.

As used herein, "halogen" or "hal" includes F, Cl, Br or I, preferably F, Cl or Br.

As used herein, -CO-, -C(=O)- and -C(O)- will be understood to mean a carbonyl group, i.e. a group having the structure

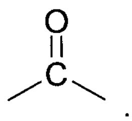

As used herein, $C=CR^1R^2$ will be understood to mean an ylidene group, i.e. a group having the structure

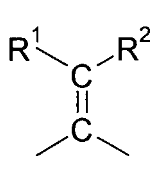

Detailed Description

The polyfullerenes are easy to synthesize, especially by methods suitable for mass production, and exhibit advantageous properties, for example good structural organization and film-forming properties, good electronic properties, especially high charge carrier mobility, good processability, especially high solubility in organic solvents, and high light and thermal stability.

The polyfullerenes are easy to make, purify, solubilise and handle by way of their limited crosslinking through the use of bulky groups Ar and/or $(Ad^2)_r$.

The polyfullerenes are especially suitable as electron acceptor or n-type semiconductor, especially in semiconducting materials containing both donor and acceptor components, and for the preparation of a mixture of p-type and n-type semiconductors which are suitable for use in BHJ OPV devices and OPD devices.

For OPV and OPD application, the polyfullerene, or a mixture comprising two or more fullerene derivatives, at least one of which is a polyfullerene according to the present invention, is blended with a further p-type semiconductor such as a polymer, an oligomer or a defined molecular unit to form the active layer in the OPV/OPD device (also referred to as "photoactive layer").

The OPV/OPD device is usually further composed of a first, transparent or semi-transparent electrode, typically provided on a transparent or semi-transparent substrate, on one side of the active layer, and a second metallic or semi-transparent electrode on the other side of the active layer. Additional interfacial layer(s) acting as hole blocking layer, hole transporting layer, electron blocking layer and/or electron transporting layer, typically comprising a metal oxide (for example, ZnOx, $TiO_x$, ZTO, $MoO_x$, $NiO_x$), a salt (example: LiF, NaF), a conjugated polymer electrolyte (for example: PEDOT:PSS or PFN), a conjugated polymer (for example: PTAA) or an organic compound (for example: NPB, $Alq_3$, TPD), can be inserted between the active layer and an electrode.

The polyfullerenes demonstrate the following improved properties compared to previously disclosed fullerene derivatives for OPV/OPD application:

i) The polyfullerenes can enable greater light stability of the bulk heterojunction through mediation of the fullerene cycloaddition dimerisation reaction, as described, for example in Adv. Energy Mater. 2014, 4, 1300693.

ii) The polyfullerenes can enable greater stability towards light illumination of the bulk heterojunction through mediation of the fullerene crystallisation and/or phase separation kinetic, thus stabilising the initial equilibrium thermodynamics in the BHJ.

iii) The polyfullerenes can enable greater thermal stability of the bulk heterojunction through mediation of the fullerene crystallisation and/or phase separation kinetic, thus stabilising the initial equilibrium thermodynamics in the BHJ.

iv) Electron accepting and/or donating groups in the position of group Ar or its substituents may reduce the polyfullerene band-gap and therefore the potential for improved light absorption.

v) Additional fine-tuning of the electronic energies (HOMO/LUMO levels) may result by careful selection of the electron accepting and/or donating groups in the position of group Ar or R or $R^n$ to increase the open circuit potential ($V_{oc}$).

vi) Additional fine-tuning of the electronic energies (HOMO/LUMO levels) may result by careful selection of the electron accepting and/or groups in the position of group Ar or R to reduce the energy loss in the electron transfer process between the fullerene and the p-type material (i.e. polymer, oligomer, a define molecular unit) in the active layer.

vii) The substituents R, which can each possess more than one solubilising group, may enable higher polyfullerene solubility in non-halogenated solvents due to the increased number of solubilising groups.

viii) The Ar group and its substituents, by way of their steric size may improve the solubility, ease of purification, and increase the chain-length of the polyfullerene by their reducing g to 0 in the unit of formula 11.

ix) The use of bulky groups Ar and/or $(Ad^2)_r$ helps to increase the chain-length of the polyfullerenes, reduce their degree of crosslinking, and thereby make purification easier and solubility higher.

The polyfullerene according to the present invention is preferably terminated by a group T that denotes -CH=O or an endcap group.

Preferred endcap groups T are H, $C_{1-20}$ alkyl, or optionally substituted $C_{6-12}$ aryl or $C_{2-10}$ heteroaryl, very preferably H or phenyl.

In the polyfullerene according to the present invention the units of formula 11 and formula I2 are present in alternating sequence, i.e. each di- or polyvalent fullerene unit of formula I1 is linked, via its pyrrolidine adducts, to two or more units of formula I2 or terminal groups, and each divalent unit of formula I2 is linked to two units of formula 11, or to a unit of formula I1 and a terminal group.

In the unit of formula I1 g is preferably 0 or an integer from 1 to 3.

The polyfullerene can be a linear polymer that contains only units of formula I1 wherein g is 0. The polyfullerene can also be a crosslinked polymer that contains one or more units of formula I1 wherein g is at least 1, which form crosslinking points in the polyfullerene.

Preferably the polyfullerene contains both units of formula 11 wherein g is 0 and units of formula I1 wherein g is ≥ 1, very preferably wherein g is 1.

In another preferred embodiment the polyfullerene contains both units of formula 11 wherein g is 1 and units of formula 11 wherein g is ≥ 1.

In another preferred embodiment the polyfullerene consist of units of formula I1 wherein g is 0 or g is close to zero such that $0 < g < 1$.

In the units of formula I1 the fullerene $C_n$ may be composed of any number n of carbon atoms Preferably, in the units of formula 11 the number of carbon atoms n of which the fullerene $C_n$ is composed is 60, 70, 76, 78, 82, 84, 90, 94 or 96, very preferably 60 or 70.

The fullerene Cn is preferably selected from carbon based fullerenes, endohedral fullerenes, or mixtures thereof, very preferably from carbon based fullerenes.

Suitable and preferred carbon based fullerenes include, without limitation, $(C_{60\text{-}1h})$[5,6]fullerene, $(C_{70\text{-}D5h})$[5,6]fullerene, $(C_{76\text{-}D2*})$[5,6]fullerene, $(C_{84\text{-}D2*})$[5,6]fullerene, $(C_{84\text{-}D2d})$[5,6]fullerene, or a mixture of two or more of the aforementioned carbon based fullerenes.

The endohedral fullerenes are preferably metallofullerenes. Suitable and preferred metallofullerenes include, without limitation, $La@C_{60}$, $La@C_{82}$, $Y@C_{82}$, $Sc_3N@C_{80}$, $Y_3N@C_{80}$, $Sc_3C_2@C_{80}$, $Lu_3N@C_{80}$ or a mixture of two or more of the aforementioned metallofullerenes.

Preferably the fullerene Cn is substituted at a [6,6] and/or [5,6] bond, preferably substituted on at least one [6,6] bond.

In a preferred embodiment of the present disclosure, the unit Ar of formula I2 denotes $-CX^1=CX^2-$ or $-C\equiv C-$, preferably $-CX^1=CX^2-$, wherein $X^1$ and $X^2$ are as defined in formula I, and preferably denote H.

In another preferred embodiment of the present disclosure, the unit Ar of formula I2 is selected from the group consisting of the following formulae:

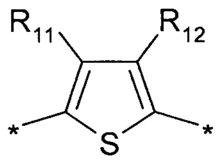

1

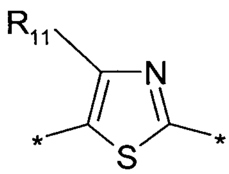

2

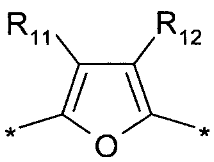

3

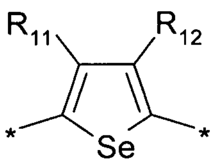

4

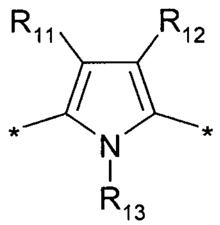

5

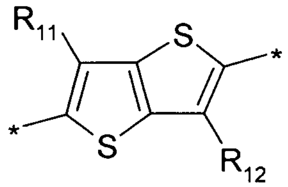

6

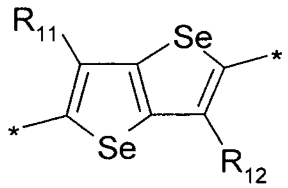

7

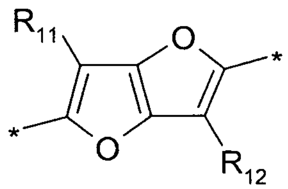

8

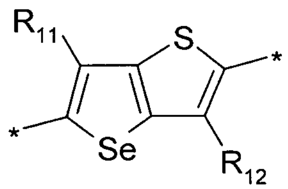

9

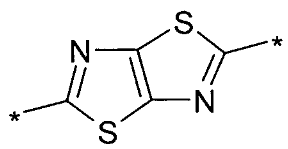

10

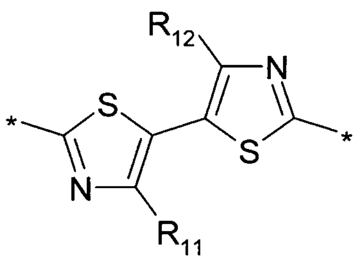

11

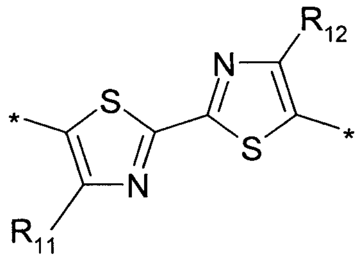

12

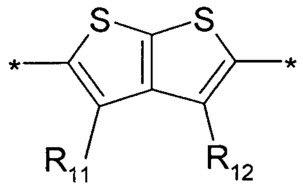

13

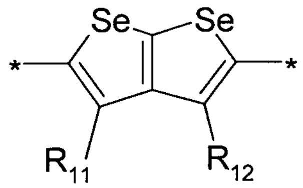

14

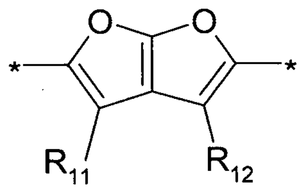

15

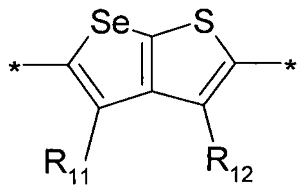

16

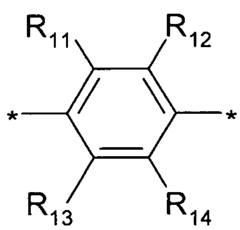

17

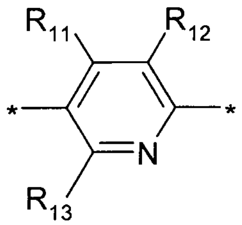

18

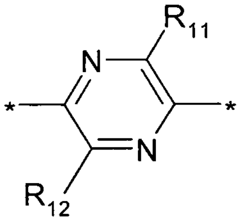

19

wherein $R^{11}$, $R^{12}$, $R^{13}$ and $R^{14}$ independently of each other denote H, halogen, CN an alkyl group with 1 to 50 C atoms, which is straight-chain, branched or cyclic, and in which one or more $CH_2$ groups are optionally replaced by -O-, -S-, -C(=O)-, -C(=S)-, -C(=O)-O-, -O-C(=O)-, $-NR^0-$, - $C(=O)-NR^0-$, $-NR^0-C(=O)-$, $-SiR^0R^{00}-$, $-CF_2-$, $-CR^0=CR^{00}-$, $-CR^0=N-$, -N=Nor -C≡C- in such a manner that O and/or S atoms are not linked directly to one another, and/or in which one or more H atoms are optionally replaced by F, Cl or CN, and/or in which one or more C or H atoms are optionally replaced by a cationic or anionic group, a saturated or unsaturated carbo- or heterocyclic group, or an aryl, heteroaryl, aryloxy or heteroaryloxy group, wherein each of the aforementioned cyclic groups is mono- or polycyclic, does optionally contain fused rings, and is optionally substituted by one or more identical or different groups L as defined in formula I1.

Preferably $R^A$ and $R^{11}$ to $R^{14}$ are selected from the group consisting of the following formulae

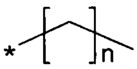

C-1

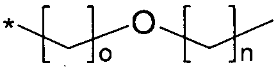

C-2

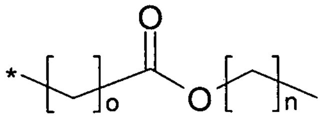

C-3

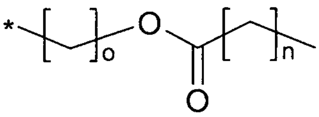

C-4

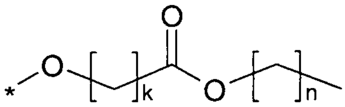

C-5

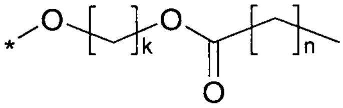

C-6

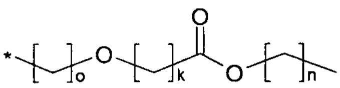

C-7

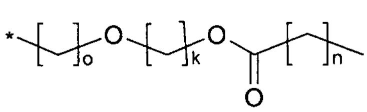

C-8

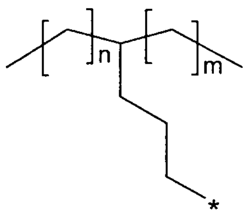

C-9

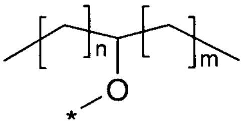

C-10

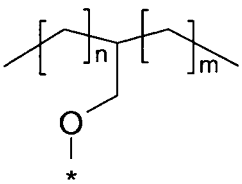

C-11

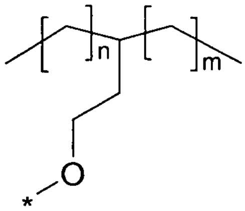

C-12

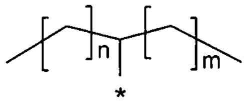

C-13

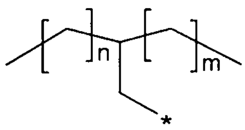

C-14

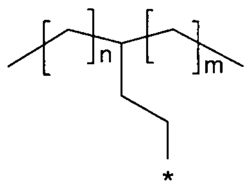

C-15

wherein

k is an integer from 1 to 20, preferably from 2 to 12,
m is 0 or an integer from 1 to 20, preferably from 2 to 12,
n is 0 or an integer from 1 to 30, preferably from 6 to 24,
o is 0 or an integer from 1 to 20, preferably from 2 to 12,

and wherein one or more H atoms are optionally replaced by F.

Very preferred are groups of formulae C-1 and C-2, in particular wherein o is 0 and n is an integer from 5 to 23.

Preferred groups of formulae C-2, C-3 and C-4 are those wherein n is an integer from 6 to 24.

Further preferred groups of formulae C-2, C-3 and C-4 are those wherein o is 0.

Further preferred groups of formulae C-2, C-3 and C-4 are those wherein o is an integer from 2 to 12.

Preferred groups of formula C-8 are those wherein o is 0, k is an integer from 2 to 12, and n is an integer from 6 to 24.

Further preferred groups of formula C-8 are those wherein o is an integer from 1 to 6, k is an integer from 2 to 12, and n is an integer from 6 to 24. Very preferably $R^A$ and $R^{11}$ to $R^{14}$ are selected from F, Cl, CN, alkyl, alkoxy, thioalkyl, alkylcarbonyl, alkxoycarbonyl and alkylcarbonyloxy with 1 to 30, preferably 12 to 30 C atoms, which are optionally mono-, poly- or perfluorinated.

Preferably Ar is selected from formulae 1-17 wherein at least two of the substituents $R^{11}$, $R^{12}$, $R^{13}$, and $R^{14}$ are different from H, and are preferably selected from formulae C-1 to C-15 or the preferred groups above.

Very preferably Ar is of formula 17, and at least two of $R^{11}$, $R^{12}$, $R^{13}$, and $R^{14}$ are different from H, and are preferably selected from alkoxy, thioalkyl, alkylcarbonyl, alkxoycarbonyl and alkylcarbonyloxy, very preferably alkoxy, with 1 to 30, preferably 6 to 30, most preferably 16 to 30, C atoms, which are optionally mono-, poly- or perfluorinated. In the present invention, $R^{12}$, $R^{13}$ are different from H and $R^{11}$, $R^{14}$ are H.

In another preferred embodiment one or more of $R^A$ and $R^{11}$ to $R^{14}$ denote a straight-chain, branched or cyclic alkyl group with 1 to 30, preferably 6 to 20, C atoms, in which one or more $CH_2$ or $CH_3$ groups are replaced by a cationic or anionic group.

The cationic group is preferably selected from the group consisting of phosphonium, sulfonium, ammonium, uronium, thiouronium, guanidinium or heterocyclic cations such as imidazolium, pyridinium, pyrrolidinium, triazolium, morpholinium or piperidinium cation.

Preferred cationic groups are selected from the group consisting of tetraalkylammonium, tetraalkylphosphonium, N-alkylpyridinium, N,N-dialkylpyrrolidinium, 1,3-dialkylimidazolium, wherein "alkyl" preferably denotes a straight-chain or branched alkyl group with 1 to 12 C atoms.

Further preferred cationic groups are selected from the group consisting of the following formulae

imidazolium

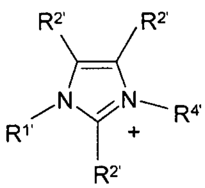

,

1H-pyrazolium

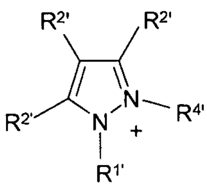

,

3H-pyrazolium

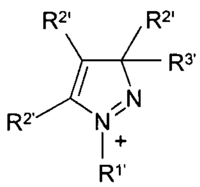

,

4H-pyrazolium

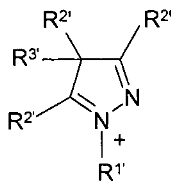

,

1-pyrazolinium

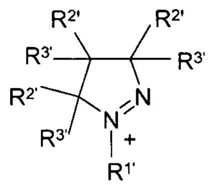

,

2-pyrazolinium
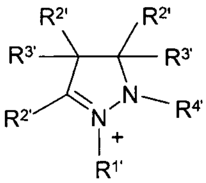
,
3-pyrazolinium
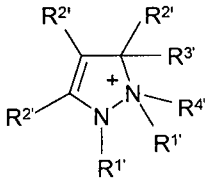
,
2,3-dihydroimidazolinium
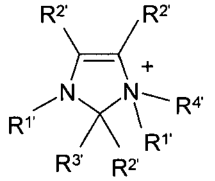
,
4,5-dihydroimidazolinium
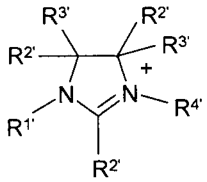
,
2,5-dihydroimidazolinium
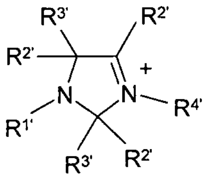
,
pyrrolidinium
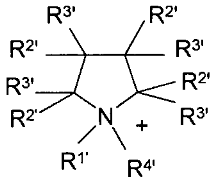
,
1,2,4-triazolium
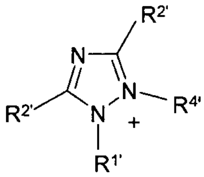
,
1,2,4-triazolium
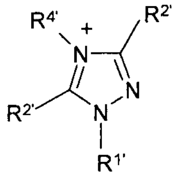
,
1,2,3-triazolium
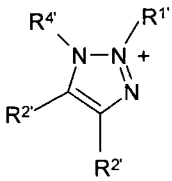
,
1,2,3-triazolium
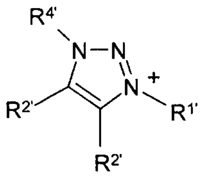
,
pyridinium
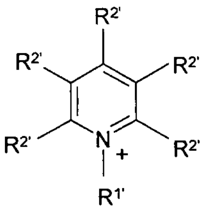
,
pyridazinium
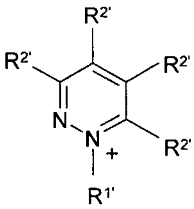
,
pyrimidinium
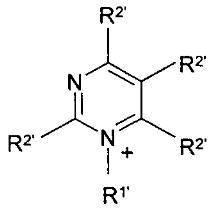
,
piperidinium
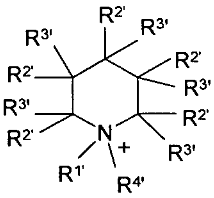
,
morpholinium
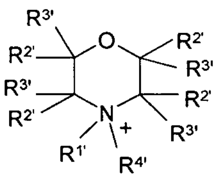
,
piperazinium
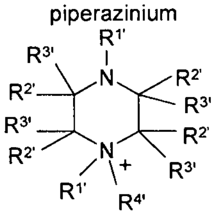
,
piperazinium
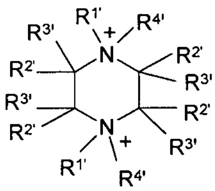
,
pyrazinium
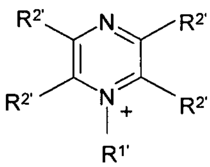
,
thiazolium
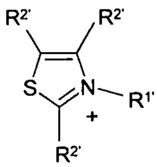
,
oxazolium
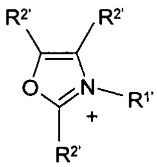
,
indolium
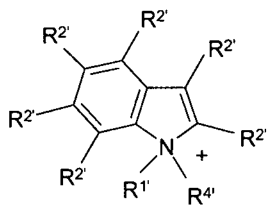
,
quinolinium
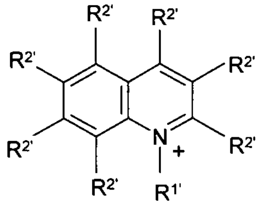
,
isoquinolinium
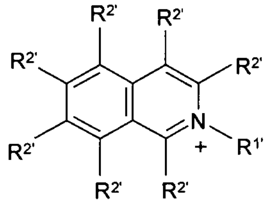
,
quinoxalinium
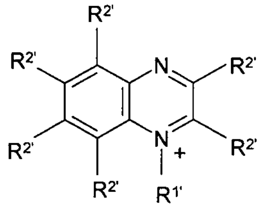

or

indolinium

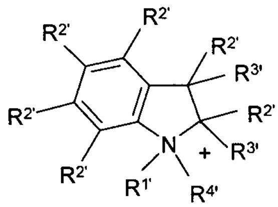

wherein $R^{1'}$, $R^{2'}$, $R^{3'}$ and $R^{4'}$ denote, independently of each other, H, a straight-chain or branched alkyl group with 1 to 12 C atoms or non-aromatic carbo- or heterocyclic group or an aryl or heteroaryl group, each of the aforementioned groups having 3 to 20, preferably 5 to 15, ring atoms, being mono- or polycyclic, and optionally being substituted by one or more identical or different substituents $R^8$ as defined above, or denote a link to the group $R^1$, $R^2$, $R^3$, $R^4$, $R^5$ or $R^6$, respectively.

In the above cationic groups of the above-mentioned formulae any one of the groups $R^{1'}$, $R^{2'}$, $R^{3'}$ and $R^{4'}$ (if they replace a $CH_3$ group) can denote a link to the respective group $R^1$, $R^2$, $R^3$, $R^4$, $R^5$ or $R^6$, or two neighbored groups $R^{1'}$, $R^{2'}$, $R^{3'}$ or $R^{4'}$ (if they replace a $CH_2$ group) can denote a link to the respective group $R^1$, $R^2$, $R^3$, $R^4$, $R^5$ or $R^6$.

The anionic group is preferably selected from the group consisting of borate, imide, phosphate, sulfonate, sulfate, succinate, naphthenate or carboxylate, very preferably from phosphate, sulfonate or carboxylate.

In addition to the pyrrolidino adducts shown in formula 11, the fullerene $C_n$ may have any number (r) of second adducts $Ad^2$ that are different from the pyrrolidino adducts. The second adduct $Ad^2$ may be any possible adduct or combination of adducts with any connectivity to the fullerene.

The adduct $Ad^2$ is preferably appended to the fullerene $C_n$ by the [6,6]-bond and/or [5,6]-bond, preferably on at least one [6,6]-bond.

In the units of formula I1 and its subformulae, the number r of second adducts $Ad^2$ appended to the fullerene $C_n$ is 0, an integer ≥ 1, or a non-integer > 0 like 0.5 or 1.5, and is preferably 0, 1 or 2.

In a preferred embodiment the number r of the second adducts $Ad^2$ appended to the fullerene $C_n$ is 0.

In another preferred embodiment the number r of the second adducts $Ad^2$ appended to the fullerene $C_n$ is >0, preferably 1 or 2.

The second adduct $Ad^2$ in formula 11 and its subformulae is preferably selected from the following formulae

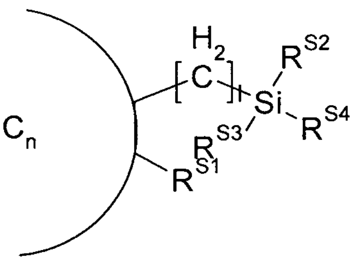

S-1

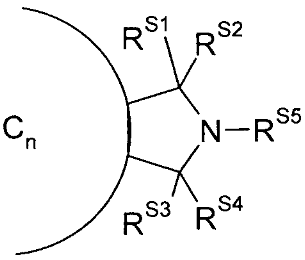

S-2

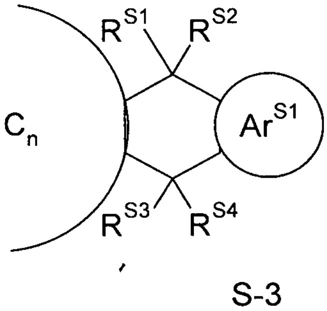

S-3

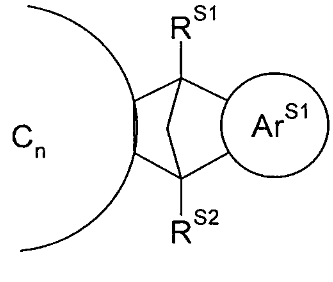

S-4

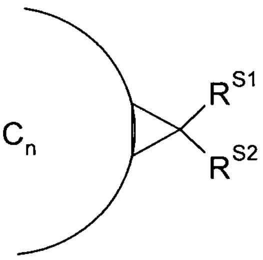

S-5

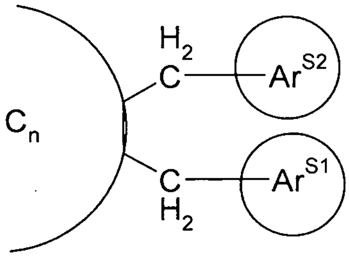

S-6

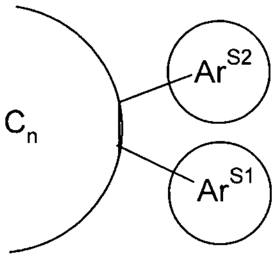

S-7

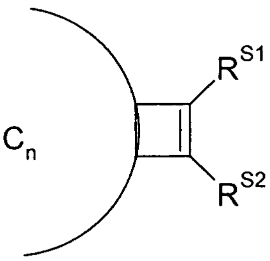

S-8

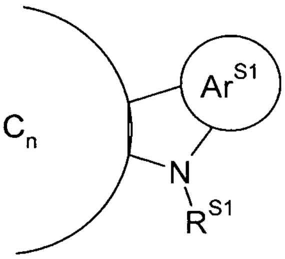

S-9

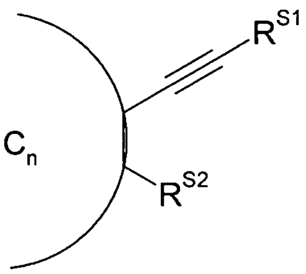

S-10

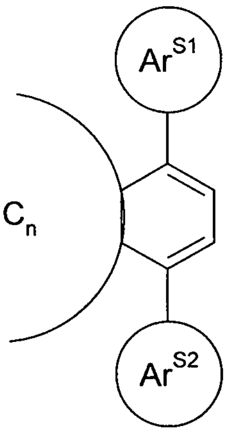

S-11

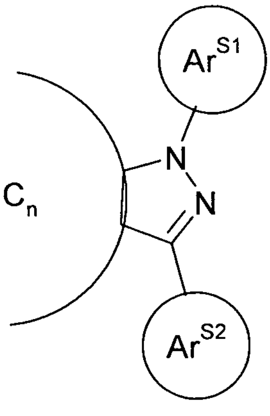

S-12

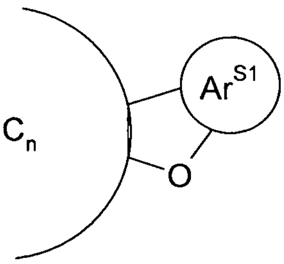

S-13

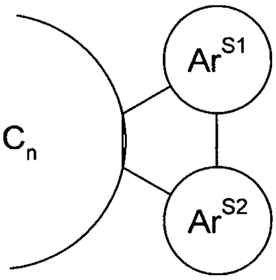

S-14

wherein

$R^{S1}$, $R^{S2}$, $R^{S3}$, $R^{S4}$ and $R^{S5}$ independently of each other denote H, halogen or CN, or have one of the meanings of $R^A$ or $R^{11}$ as given above and below, and $Ar^{S1}$ and $Ar^{S2}$ denote independently of each other a double bond, a saturated or unsaturated, non-aromatic carbo- or heterocyclic group, or an aryl, heteroaryl, aryloxy or heteroaryloxy group, wherein

each of the aforementioned groups has 5 to 20 ring atoms, is mono- or polycyclic, does optionally contain fused rings, and is optionally substituted by one or more identical or different groups L as defined in formula I1.

Very preferred are second adducts $Ad^2$ of formula S-5.

Preferred substituents $R^{S1}$, $R^{S2}$, $R^{S3}$, $R^{S4}$ and $R^{S5}$ are independently of each other selected from alkyl, alkoxy, thioalkyl, alkoxycarbonyl and alkylcarbonyloxy with 1 to 30, preferably 2 to 20 C atoms, which are optionally mono-, poly- or perfluorinated, furthermore aryl, aryloxy, aryloxycarbonyl, arylcarbonyloxy, heteroaryl, heteroaryloxy, heteroaryloxycarbonyl and heteroarylcarbonyloxy with 5 to 15 ring atoms which are optionally substituted by one or more groups L as defined above and below.

In another preferred embodiment one or more of $R^{S1}$, $R^{S2}$, $R^{S3}$, $R^{S4}$ and $R^{S5}$ denote a straight-chain, branched or cyclic alkyl group with 1 to 20, preferably 2 to 15, C atoms, in which one or more $CH_2$ or $CH_3$ groups are replaced by a cationic or anionic group as defined above.

In the adducts $Ad^2$, $Ar^{S1}$ and $Ar^{S2}$ preferably denote, independently of each other, an aryl or heteroaryl group with 5 to 20, preferably 5 to 15, ring atoms, which is mono- or polycyclic, and which is preferably substituted by one or more, preferably two or more, identical or different substituents $R^A$, $R^{11}$ or L that are preferably selected from halogen, very preferably F, straight-chain, branched or cyclic alkyl with 1 to 30, preferably 4 to 20, very preferably 5 to 15, C atoms, in which one or more $CH_2$ groups are optionally replaced by -O-, -S-, -C(O)-, -C(S)-, -C(O)-O-, -O-C(O)-, $-S(O)_2-$, $-NR^0-$, $-SiR^0R^{00}-$, $-CF_2-$, wherein $R^0$ and $R^{00}$ have one of the meanings given above and below.

Very preferably $Ar^{S1}$ and $Ar^{S2}$ are selected from the following groups:

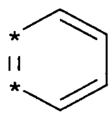

(P-F-C-1)

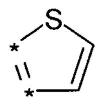

(P-F-C-2)

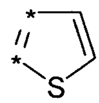

(P-F-C-3)

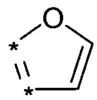

(P-F-C-4)

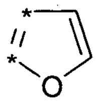

(P-F-C-5)

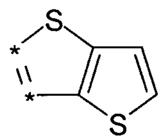

(P-F-C-6)

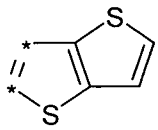

(P-F-C-7)

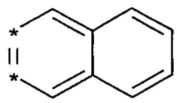

(P-F-C-8)

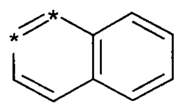

(P-F-C-9)

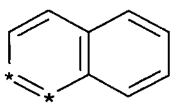

(P-F-C-10)

which are optionally substituted by one or more groups $R^{11}$ or L as defined above and below.

Most preferably $Ar^{S1}$ and $Ar^{S2}$ denote benzene, thiophene or naphthalene that is optionally substituted by one or more groups R, $R^{11}$ or L as defined above.

Very preferred are units of formula 11, preferably wherein r is >1, very preferably 1 or 2, and wherein the second adducts $Ad^2$ are of formula S-5 wherein one substituent R is benzene, thiophene or naphthalene which are optionally substituted by one or more groups $R^{11}$, and the other substituent R is an ester group, preferably selected from formula C-3.

Further preferred are units of formula 11, preferably wherein r is >1, very preferably 1 or 2, and wherein the second adducts $Ad^2$ are of formula S-5 wherein one substituent R is benzene, thiophene or naphthalene, and the other

substituent R is an ester group of formula C-3, wherein o is 1, 2, 3, 4, 5, or 6, very preferably 3, and n is an integer from 1 to 12, preferably 1, 2, 3, 4, 5 or 6.

Very preferred are units of formula I1 wherein r is 1 or 2, and wherein the second adduct $Ad^2$ is of formula S-5 wherein one substituent R is benzene, and the other substituent R is butyric acid methyl ester, butyric acid ethyl ester, butyric acid propyl ester, butyric acid butyl ester, butyric acid pentyl ester or butyric acid hexyl ester.

In the compounds of formula II and its subformulae, all adducts $Ad^1$ and $Ad^2$ may be connected to one another in any combination in the finished product or during synthesis, to facilitate preferred properties in the finished product.

The invention further relates to novel polyfullerenes consisting of units of formula I1 and units of formula I2. In the polyfullerenes of the present invention, the unit Ar is of formula 17, wherein $R^{11}$ and $R^{14}$ are H and $R^{12}$ and $R^{13}$ are different from H.

In case $R^{11}$ to $R^{14}$ in the units Ar of formula 17 are different from H, they are preferably selected from F, Cl, CN, alkyl, alkoxy, thioalkyl, alkylcarbonyl, alkxoycarbonyl and alkylcarbonyloxy with 1 to 30, preferably 2 to 20 C atoms, which are optionally mono-, poly- or perfluorinated, very preferably alkoxy with 1 to 30 C atoms.

Further preferred are polyfullerenes wherein the unit of formula 11 contains at least one, preferably one or two second adducts $Ad^2$, preferably selected of formula S-5, wherein the substituents R have the preferred meanings given above.

The polyfullerenes according to the present invention can be synthesized according to or in analogy to methods that are known to the skilled person and are described in the literature. Further synthesis methods can be taken from the examples.

A preferred method of preparing polyfullerenes includes the steps of reacting sarcosine **1** with an aromatic dione **2**, wherein Ar is as defined in formula 12, and reacting the resulting intermediate with a fullerene Cn as defined in formula I1 by a 4+2 cycloaddition such as the Diels-Alder reaction to give the polyfullerene **3**. This preferred method is exemplarily illustrated in Scheme 1 below, wherein the individual radicals have the meanings given in formula I1 and I2.

<u>Scheme 1</u>

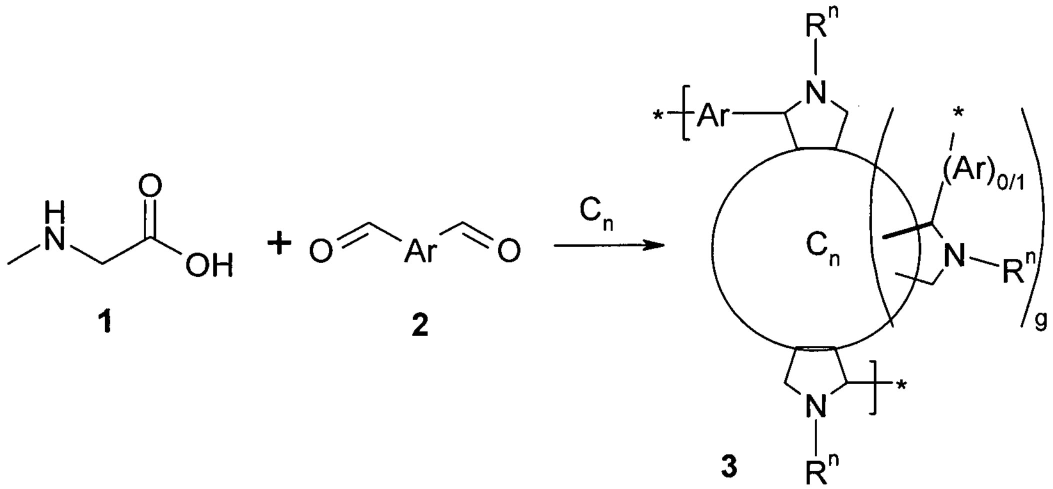


1 2 3

The reaction is preferably carried out at a temperature of 110 to 150°C. The reaction is preferably performed with anhydrous solvents. Preferably the reaction is carried out in the solvent toluene or dichlorobenzene, very preferably dichlorobenzene. The concentration of the fullerene is preferably in the range from 0.9 to 20 mg·cm$^{-3}$. The ratio of reagents aromatic dione:$C_n$:N-methylglycine is preferably 1:1:2. The reaction time is preferably from 6 to 24, very preferably from 20 to 24 hours. The reaction is preferably performed under a nitrogen or argon atmosphere.

The novel methods of preparing polyfullerenes as described above and below, and the intermediates used therein, are another aspect of the present invention.

In preferred embodiment of the present invention the semiconducting mixture comprises, in addition to the polyfullerene, a fullerene or fullerene derivative that is different from the polyfullerene.

The additional fullerene or fullerene derivative is preferably not polymerized, but a monomeric compound.

The additional fullerene or fullerene derivative is preferably selected of formula II

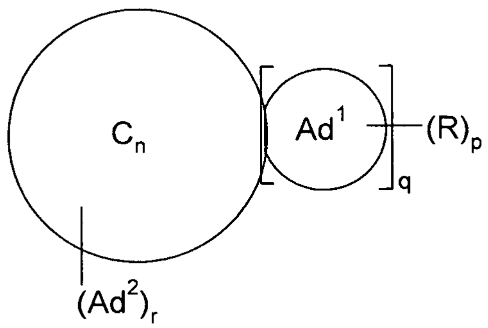

II

wherein the individual radicals, independently of each other, and on each occurrence identically or differently, have the following meanings

$C_n$ a fullerene composed of n carbon atoms, optionally with one or more atoms trapped inside,

$Ad^1$ a first adduct selected from formulae 1-8, which is preferably a [6,6]-adduct or [5,6]-adduct to the fullerene

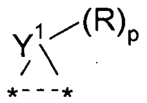

1

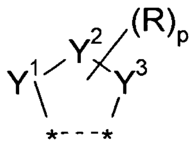

2

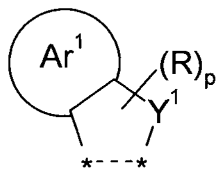

3

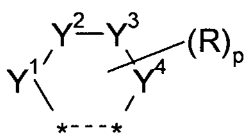

4

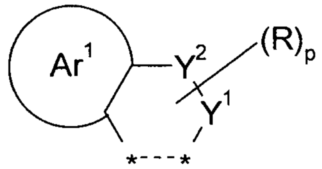

5

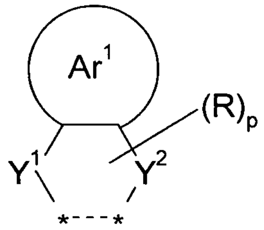

6

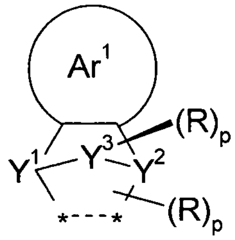

7

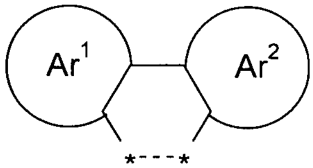

8

| | |
|---|---|
| q | an integer ≥ 1 or a non-integer > 1, |
| R | halogen, CN, an alkyl group with 1 to 50 C atoms, which is straight-chain, branched or cyclic, and in which one or more $CH_2$ groups are optionally replaced by -O-, -S-,-C(=O)-, -C(=S)-, -C(=O)-O-, -O-C(=O)-, $-NR^0-$, $-C(=O)-NR^0-$, $-NR^0-C(=O)-$, $-SiR^0R^{00}-$, $-CF_2-$, $-CR^0=CR^{00}-$,$-CR^0=N-$, -N=N- or -C≡C- in such a manner that O and/or S atoms are not linked directly to one another, and/or in which one or more H atoms are optionally replaced by F, Cl, Br, I or CN, a saturated or unsaturated, non-aromatic carbo- or heterocyclic group, or an aryl, heteroaryl, aryloxy or heteroaryloxy group, wherein each of the aforementioned groups has 5 to 20 ring atoms, is mono- or polycyclic, does optionally contain fused rings, and is optionally substituted by one or more identical or different groups $L^R$, |
| p | 0 or an integer ≥ 1, |
| $L^R$ | halogen, -CN, -NC, -NCO, -NCS, -OCN, -SCN,$-C(=O)NR^0R^{00}$, $-C(=O)X^0$, $-C(=O)R^0$, $-NH_2$, $-NR^0R^{00}$, -SH,$-SR^0$, $-SO_3H$, $-SO_2R^0$, -OH, $-NO_2$, $-CF_3$, $-SF_5$, optionally substituted silyl, or carbyl or hydrocarbyl with 1 to 40 C atoms that is optionally substituted and optionally comprises one or more hetero atoms, preferably alkyl, alkoxy, thioalkyl, alkylcarbonyl, alkylcarbonyloxy, alkoxycarbonyl or alkoxycarbonyloxy with 1 to 20 C atoms that is optionally fluorinated, |
| $R^0$, $R^{00}$ | H or alkyl with 1 to 12 C atom, |
| $X^0$ | halogen, preferably F, Cl or Br, |
| *---* | a linkage to the fullerene, |
| $Y^1$, $Y^2$, $Y^3$, $Y^4$ | C, Si, Ge, Sn, N, P, B, Al, Ga, S, O or Se, which can be further substituted by one or more groups L and can posses any bond configuration, |
| $Ar^1$, $Ar^2$ | a double bond, a saturated or unsaturated, non-aromatic carbo- or heterocyclic group, or an aryl, heteroaryl, aryloxy or heteroaryloxy group, wherein each of the aforementioned groups has 5 to 20 ring atoms, is mono- or polycyclic, does optionally contain fused rings, and is optionally substituted by one or more identical or different groups $L^R$, |

Ad2 a second adduct, or a combination of second adducts, appended to the fullerene $C_n$ with any connectivity,

r 0, an integer ≥ 1, or a non-integer > 0.

The fullerene $C_n$ in formula II and its subformulae is preferably selected from carbon based fullerenes, endohedral fullerenes, or mixtures thereof, very preferably from carbon based fullerenes.

Suitable and preferred carbon based fullerenes include, without limitation, ($C_{60\text{-}Ih}$)[5,6]fullerene, ($C_{70\text{-}D5h}$)[5,6]fullerene, ($C_{76\text{-}D2*}$)[5,6]fullerene, ($C_{84\text{-}D2*}$)[5,6]fullerene, ($C_{84\text{-}D2d}$)[5,6]fullerene, or a mixture of two or more of the aforementioned carbon based fullerenes.

The endohedral fullerenes are preferably metallofullerenes. Suitable and preferred metallofullerenes include, without limitation, La@$C_{60}$, La@$C_{82}$, Y@$C_{82}$, $Sc_3N$@$C_{80}$, $Y_3N$@$C_{80}$, $Sc_3C_2$@$C_{80}$, $Lu_3N$@$C_{80}$ or a mixture of two or more of the aforementioned metallofullerenes.

The adduct $Ad^1$ is preferably appended to the fullerene $C_n$ by a [6,6]-bond and/or [5,6]-bond, preferably by a [6,6]-bond.

In case $C_n$ is a less symmetric fullerene, like for example C70, the compound of formula II may also comprise a mixture of regioisomers in which the adduct $Ad^1$ is appended to different bonds of the fullerene, as disclosed for example in C. Thilgen and F. Diederich, Top. Curr. Chem. 1999, 199, 135-171.

The fullerene compounds of formula II may also undergo fullerene cycloaddition dimerisation/oligomerisation reaction, as described, for example in Adv. Energy Mater. 2014, 4, 1300693 and ACS Nano 2014, 8 (2), 1297-1308.

In the compounds of formula II and its subformulae, q preferably denotes 1, 2, 3 or 4, very preferably 1 or 2. In another preferred embodiment, q is a non-integer > 1 like 1.5.

In the compounds of formula I and its subformulae, p preferably denotes 0, 1, 2, 3 or 4, very preferably 1 or 2.

Especially preferred are adducts $Ad^1$ selected from formula 1 and 2, very preferably from formula 1.

Preferred adducts $Ad^1$ are selected from the following formulae

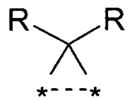

1-1

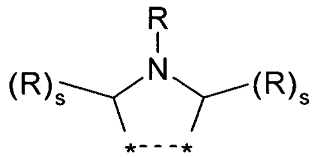

2-1

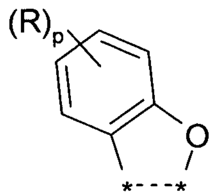

3-1

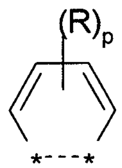

4-1

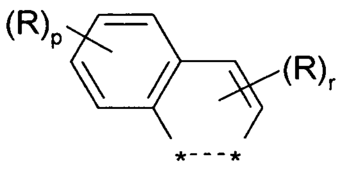

5-1

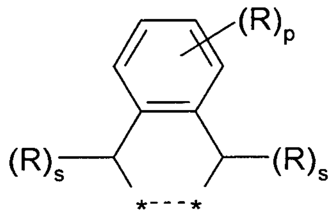

6-1

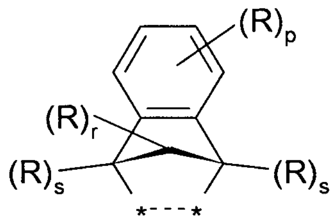

7-1

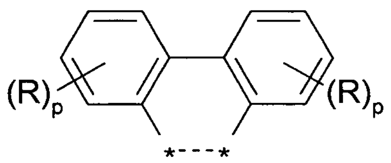

8-1

wherein R and p have the meanings of formula I or one of the preferred meanings as given above and below, p is preferably 0, 1, 2, 3 or 4, r is 0, 1 or 2 and s is 0 or 1.

In formulae 3-1, 4-1 and 8-1 preferably at least one p is different from 0 and is preferably 1 or 2. In formula 2-1 preferably at least one s is 1. In formula 5-1 preferably at least one of p and r is different from 0 and is preferably 1 or 2. In formulae 6-1 and 7-1 preferably at least one of p and s is different from 0, and preferably s is 1 and/or p is 1 or 2.

In the compounds of formula II and its subformulae the substituents R on the adduct $Ad^1$ are preferably selected from the following groups:

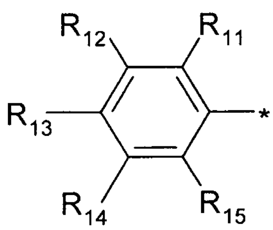

C-1

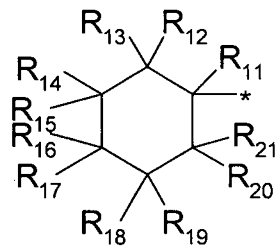

C-2

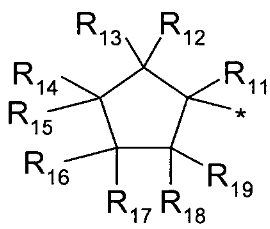

C-3

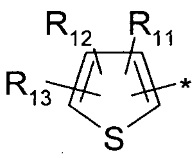

C-4

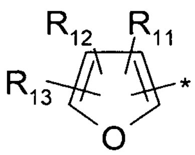

C-5

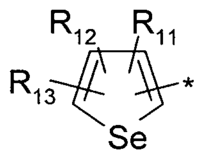

C-6

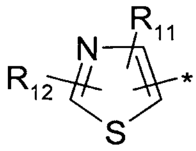

C-7

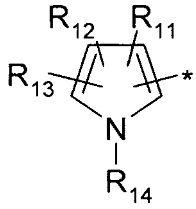

C-8

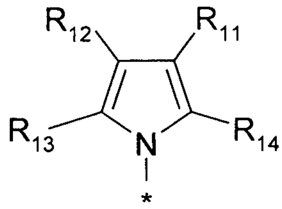

C-9

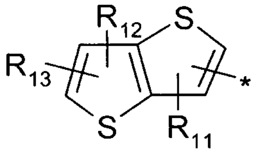

C-10

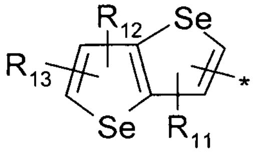

C-11

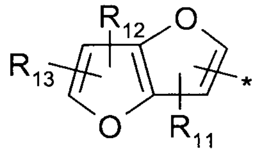

C-12

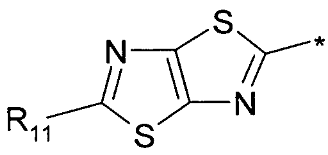

C-13

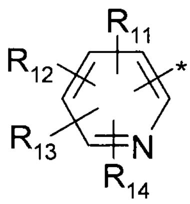

C-14

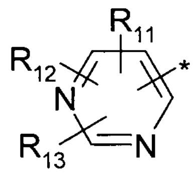

C-15

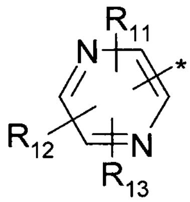

C-16

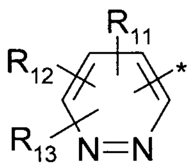

C-17

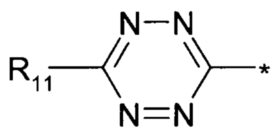

C-18

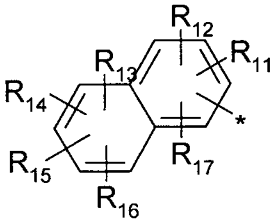

C-19

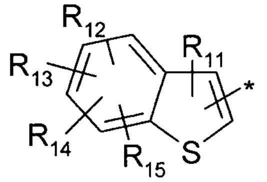

C-20

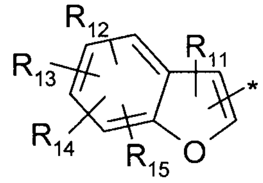

C-21

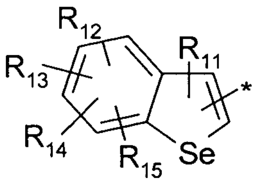

C-22

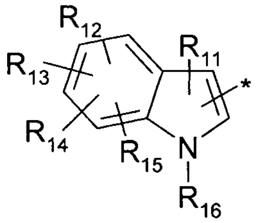

C-23

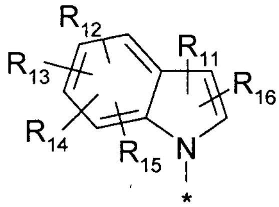

C-24

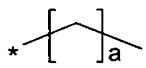

C-25

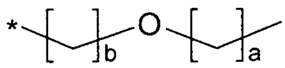

C-26

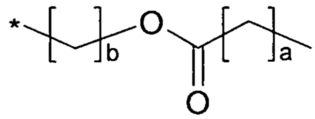

C-27

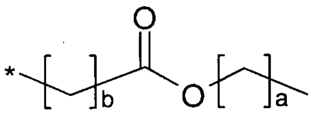

C-28

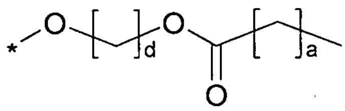

C-29

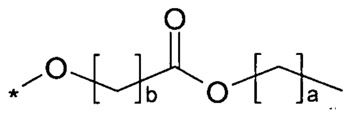

C-30

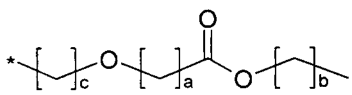

C-31

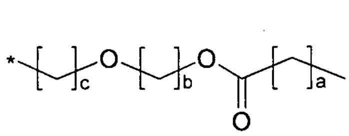

C-32

wherein

$R^{11}$ to $R^{19}$ independently of each other denote halogen, CN an alkyl group with 1 to 50 C atoms, which is straight-chain, branched or cyclic, and in which one or more $CH_2$ groups are optionally replaced by -O-, -S-, -C(=O)-, -C(=S)-, -C(=O)-O-, -O-C(=O)-, $-NR^0-$, $-C(=O)-NR^0-$, $-NR^0-C(=O)-$, - $SiR^0R^{00}-$, $-CF_2-$, $-CR^0=CR^{00}-$, $-CR^0=N-$, -N=N- or -C≡C- in such a manner that O and/or S atoms are not linked directly to one another, and/or in which one or more H atoms are optionally replaced by F, Cl or CN, and/or in which one or more C or H atoms are optionally replaced by a cationic or anionic group, a saturated or unsaturated carbo- or heterocyclic group, or an aryl, heteroaryl, aryloxy or heteroaryloxy group, wherein each of the aforementioned cyclic groups is mono- or polycyclic, does optionally contain fused rings, and is optionally substituted by one or more identical or different groups $L^R$ as defined in formula I, and $R^0$ and $R^{00}$ are as defined in formula II,

a is 0 or an integer from 1 to 20, preferably from 1 to 12,

b is 0 or an integer from 1 to 20, preferably from 1 to 12,

c is 0 or an integer from 1 to 20, preferably from 1 to 12,

d is an integer from 1 to 20, preferably from 1 to 12,

and wherein one or more H atoms are optionally replaced by F.

Preferred groups of formulae C-26, C-27 and C-28 are those wherein b is 0.

Preferred groups of formulae C-26, C-27 and C-28 are those wherein b is is an integer from 1 to 6.

Preferred substituents $R^{11-19}$ are independently of each other selected from alkyl, alkoxy, thioalkyl, alkoxycarbonyl and alkylcarbonyloxy with 1 to 30, preferably 2 to 20 C atoms, which are optionally mono-, poly- or perfluorinated, furthermore aryl, aryloxy, aryloxycarbonyl, arylcarbonyloxy, heteroaryl, heteroaryloxy, heteroaryloxycarbonyl and heteroarylcarbonyloxy with 5 to 15 ring atoms which are optionally substituted by one or more groups $L^R$ as defined above and below.

In another preferred embodiment one or more of $R^{11}$ to $R^{19}$ denote a straight-chain, branched or cyclic alkyl group with 1 to 20, preferably 2 to 15, C atoms, in which one or more $CH_2$ or $CH_3$ groups are replaced by a cationic or anionic group as defined above.

In the adducts $Ad^1$ of formulae 3 and 5 to 8, $Ar^1$ and $Ar^2$ preferably denote, independently of each other, an aryl or heteroaryl group with 5 to 20, preferably 5 to 15, ring atoms, which is mono- or polycyclic, and which is preferably substituted by one or more, preferably two or more, identical or different substituents R, $R^{11}$ or $L^R$ that are preferably selected from halogen, very preferably F, straight-chain, branched or cyclic alkyl with 1 to 30, preferably 4 to 20, very preferably 5 to 15, C atoms, in which one or more $CH_2$ groups are optionally replaced by -O-, -S-, -C(O)-, -C(S)-, -C(O)-O-, -O-C(O)-, $-S(O)_2-$, $-NR^0-$, $-SiR^0R^{00}-$, $-CF_2-$, wherein $R^0$ and $R^{00}$ have one of the meanings given above and below.

Very preferably $Ar^1$ and $Ar^2$ are selected from the following groups:

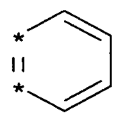

(P-F-C-1)

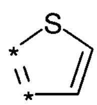

(P-F-C-2)

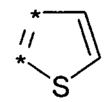

(P-F-C-3)

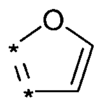

(P-F-C-4)

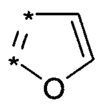

(P-F-C-5)

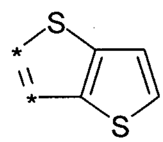

(P-F-C-6)

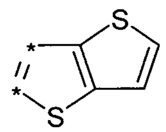

(P-F-C-7)

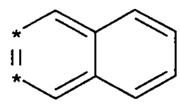

(P-F-C-8)

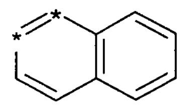

(P-F-C-9)

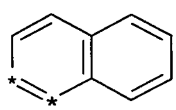

(P-F-C-10)

which are optionally substituted by one or more groups $R^{11}$ or $L^R$ as defined above and below.

Most preferably $Ar^1$ and $Ar^2$ denote benzene, thiophene or naphthalene that is optionally substituted by one or more groups R, $R^{11}$ or $L^R$ as defined above.

In addition to the first adduct $Ad^1$ in formula II, the fullerene $C_n$ may have any number (m) of second adducts $Ad^2$ different from $Ad^1$. The second adduct $Ad^2$ may be any possible adduct or combination of adducts with any connectivity to the fullerene.

The adduct $Ad^2$ is preferably appended to the fullerene $C_n$ by the [6,6]-bond and/or [5,6]-bond, preferably on at least one [6,6]-bond.

In the compounds of formula II and its subformulae, the number r of second adducts $Ad^2$ appended to the fullerene $C_n$ is 0, an integer $\geq 1$, or a non-integer > 0 like 0.5 or 1.5, and is preferably 0, 1 or 2.

In a preferred embodiment the number r of the second adducts $Ad^2$ appended to the fullerene $C_n$ is 0.

In another preferred embodiment the number r of the second adducts $Ad^2$ appended to the fullerene $C_n$ is >0,

preferably 1 or 2.

The second adduct $Ad^2$ in formula I and its subformulae is preferably selected from the following formulae

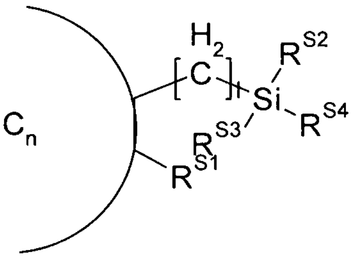

S-1

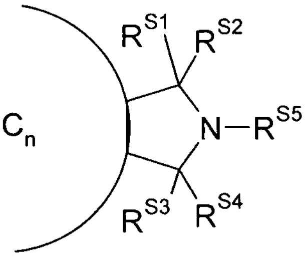

S-2

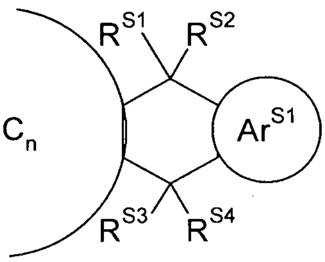

S-3

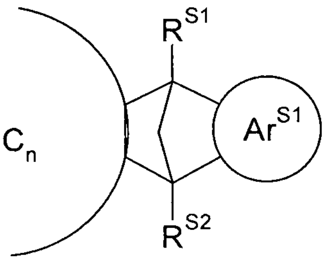

S-4

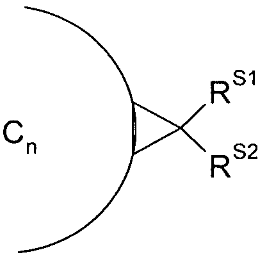

S-5

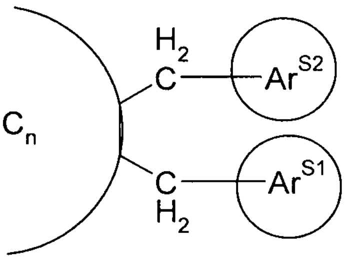

S-6

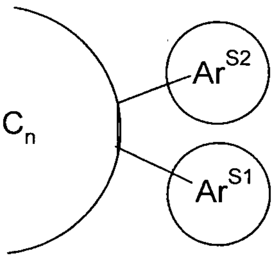

S-7

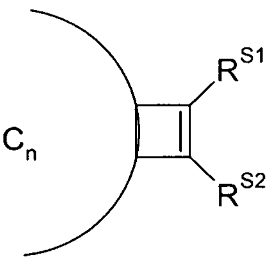

S-8

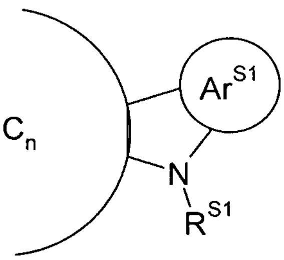

S-9

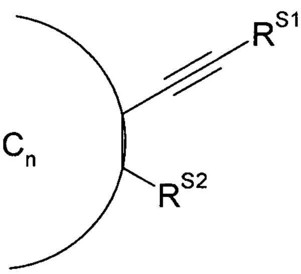

S-10

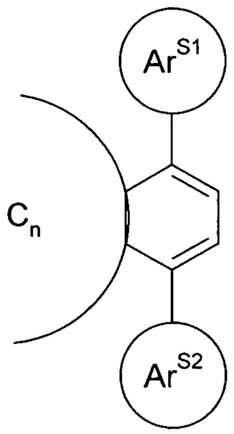

S-11

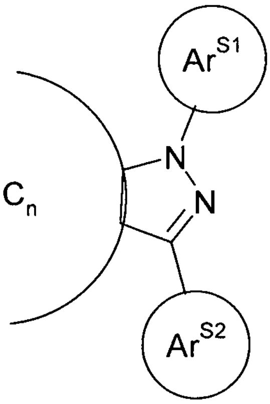

S-12

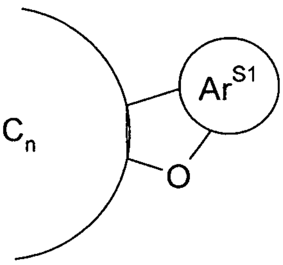

S-13

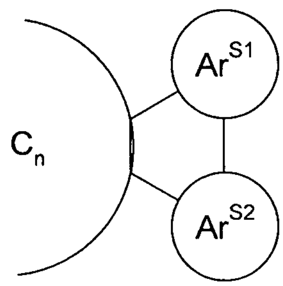

S-14

wherein
$R^{S1}$, $R^{S2}$, $R^{S3}$, $R^{S4}$ and $R^{S5}$ independently of each other denote H, halogen or CN, or have one of the meanings of $R^{11}$ or $L^R$ as given above and below, and $Ar^{S1}$ and $Ar^{S2}$ have independently of each other one of the meanings of $Ar^1$ in formula 3 or one of its preferred meanings as given above and below.

In the compounds of formula II and its subformulae, all adducts $Ad^1$ and $Ad^2$ may be connected to one another in any combination in the finished product or during synthesis, to facilitate preferred properties in the finished product.

Preferred fullerenes of formula II are selected from methanofullerene derivatives, Prato fullerene derivatives, Bingel fullerene derivatives, diazoline fullerene derivatives, and Diels-Alder fullerene derivatives, all of which are known from and disclosed in prior art, for example in US 2013/0306944 A1 and the literature cited therein.

Very preferred compounds of formula II and its subformulae are selected from the following preferred embodiments, including any combination thereof:

- r is 0,
- q is 1 or 2,
- r is 0 and o is 1 or 2,
- p is 0, 1, 2, 3 or 4,
- n is 60 or 70,
- n is 60,
- $Ad^1$ is selected of formula 1,
- $Ar^1$ and $Ar^2$ denote benzene, thiophene or naphthalene that is optionally substituted by one or more groups $R^{11}$ or $L^R$,

- R is selected from benzene, thiophene or naphthalene that is optionally fluorinated, alkylated or alkoxylated, or from alkyl, fluorinated alkyl, alkoxy, thioalkyl, -COO-alkyl, alkyl-COO-alkyl, -CO-alkyl, with "alkyl" in each occurrence having from 1 to 20, preferably from 1 to 12 C atoms.

Preferred compounds of formula II are selected from the following subformulae

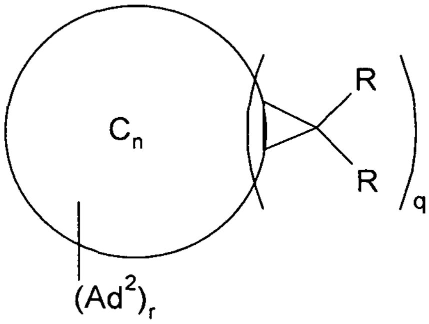

II1

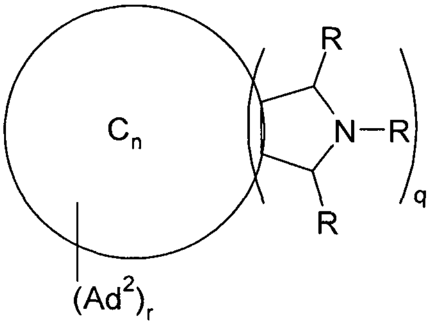

II2

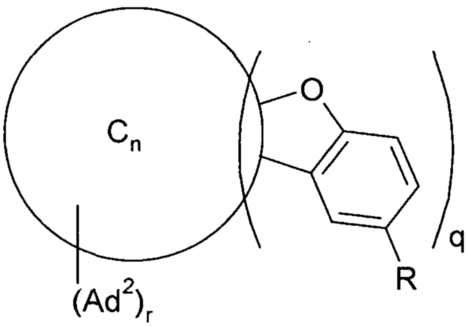

II3

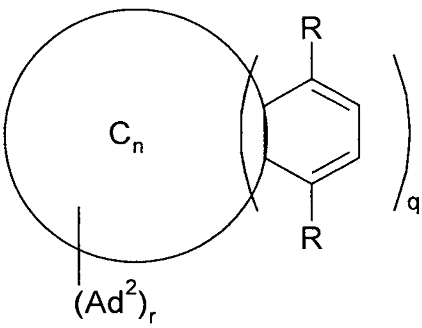

II4

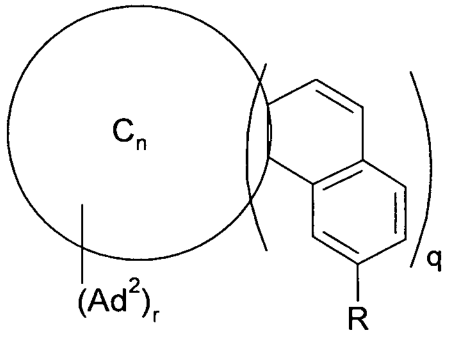

II5

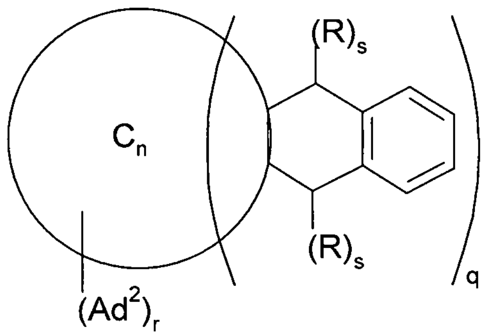

II6

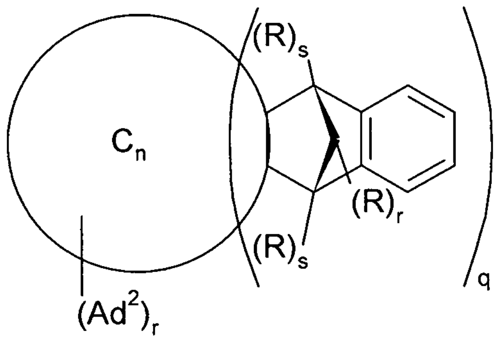

II7

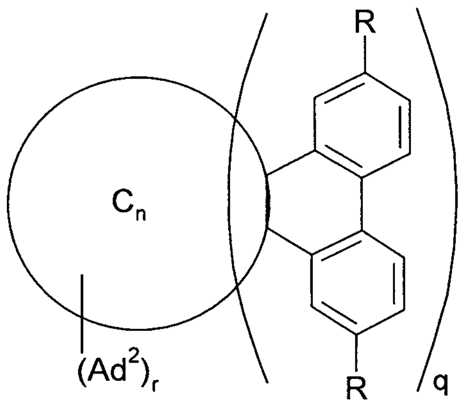

II8

wherein $C_n$, r, $Ad^2$, R, q and s have the meanings given in formula II and formulae 1-1 to 8-1, or one of the preferred meanings as given above and below, r is preferably 0, q is preferably 1 or 2, very preferably 1, and in formulae I3-I8 the benzene rings of the adduct are optionally substituted by one or more further groups R.

Very preferred are compounds of formula 111-18 wherein $C_n$ is C60 or C70.

Very preferred are compounds of formula 111.

Further preferred are compounds of formula 111 wherein r is 0, q is 1 or 2, one substituent R is benzene, thiophene or naphthalene which are optionally substituted by one or more groups $R^{11}$, and the other substituent R is an ester group, preferably selected from formulae C-27 to C-32, very preferably from formulae C27 and C-28.

Further preferred are compounds of formula II1 wherein r is 0, q is 1 or 2, one substituent R is benzene, thiophene or naphthalene, and the other substituent R is an ester group of formula C-27, wherein b is 1, 2, 3, 4, 5, or 6, very preferably 3, and a is an integer from 1 to 12, preferably 1, 2, 3, 4, 5 or 6.

Examples of preferred compounds of formulae 111-18 are listed below

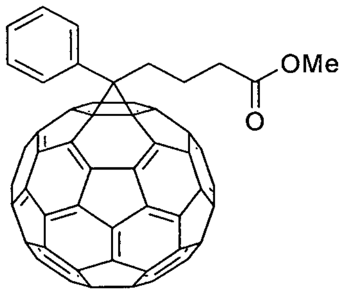

II1a

(PCBM-C60)

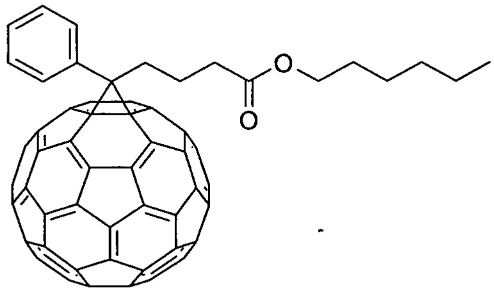

II1b

(PCBC$_6$-C60)

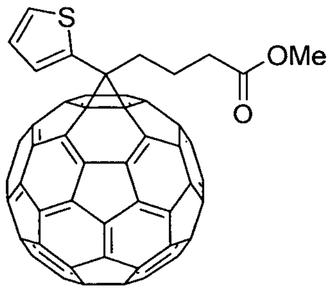

II1c

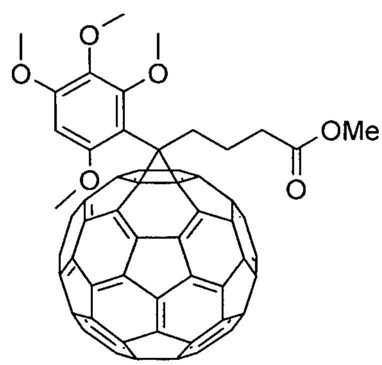

II1d

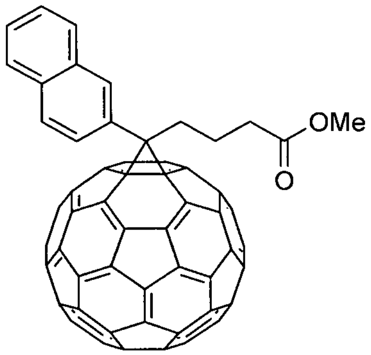

II1e

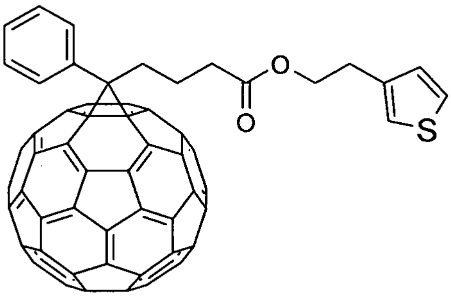

II1f

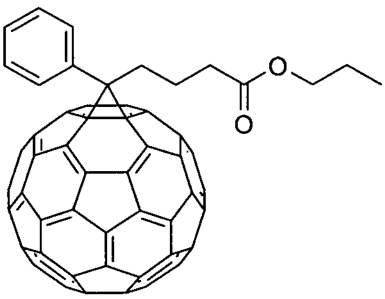

II1g

(PCBC$_3$-C60)

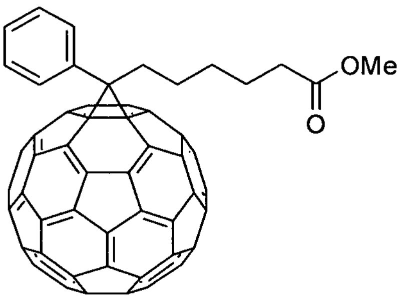

II1h

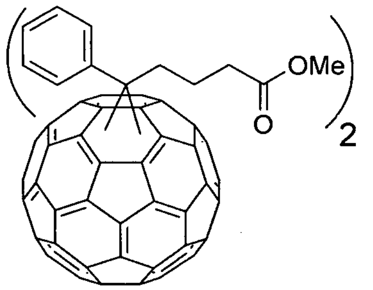

II1i

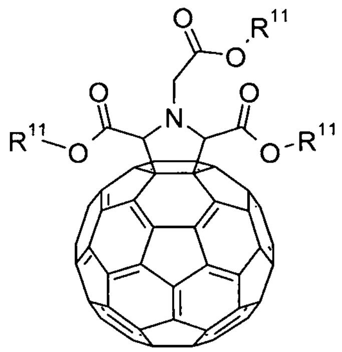

II2a

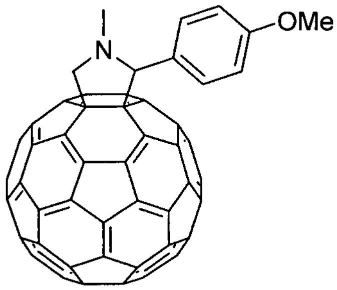

II2b

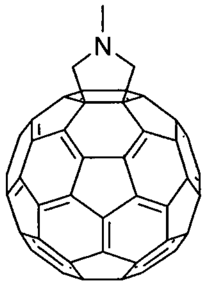

II2c

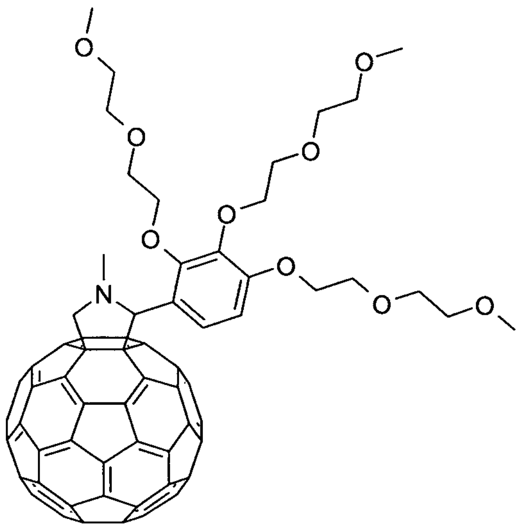

II2d

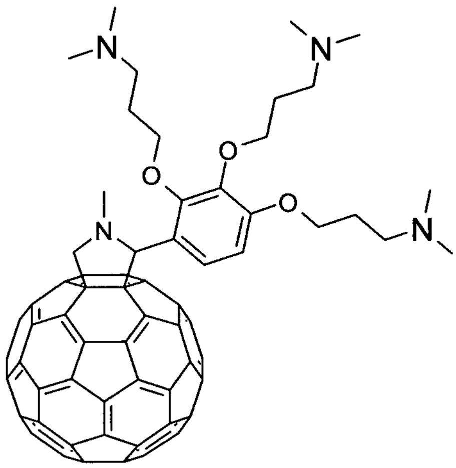

II2e

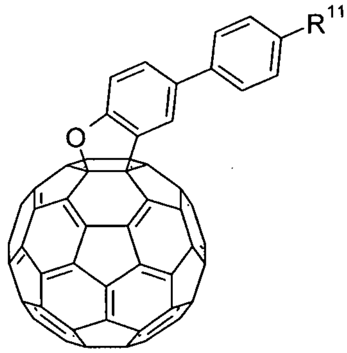

II3a

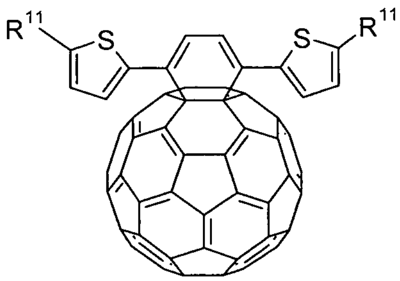

II4a

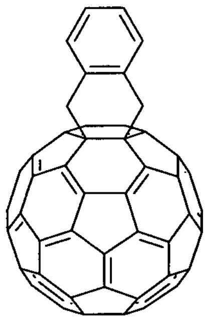

II6a

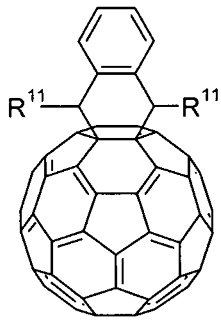

II6b

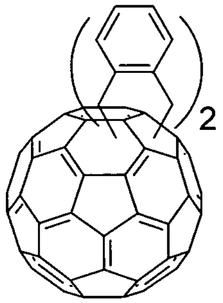

II6c

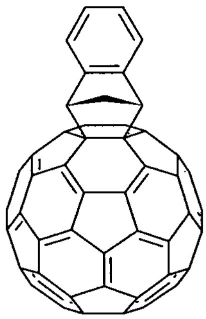

II7a

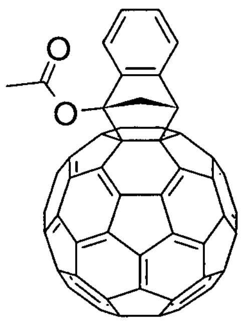

II7b

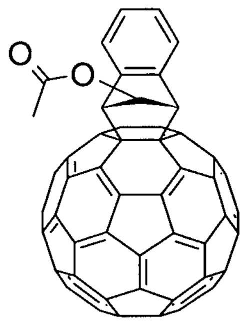

II7c

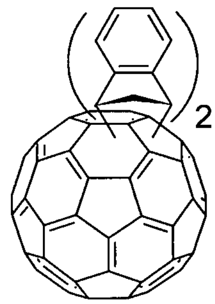

II7d

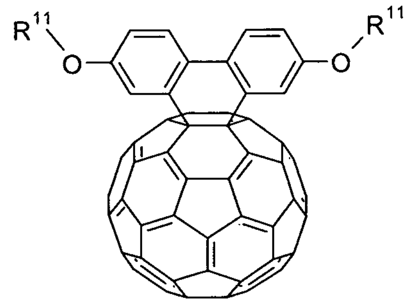

II8a

wherein $R^{11}$ has one of the meanings given above and below, and preferably denotes alkyl with 1 to 12 C atoms, Me is a methyl group, and the fullerene is C60.

Further preferred compounds are those of formula II1a-II8a shown above, but wherein the C60 fullerene is replaced by a C70 fullerene.

Very preferred compounds of formula II are PCBM-C60 and PCBM-C70.

In addition to the polyfullerene, the semiconducting mixture according to the present invention comprises a p-type semiconductor.

The p-type semiconductor can be a small molecule or a polymer.

In a preferred embodiment of the present invention the p-type semiconductor is a small molecule, for example chloro-boron subphthalocyanine, chloro-boronsubnaphthalocyanine, 6,13-Bis(triisopropylsilylethynyl)pentacene, α-sexithiophene, 3,6-bis(5-(benzofuran-2-yl)thiophen-2-yl)-2,5-bis(2-ethylhexyl)pyrrolo[3,4-c]-pyrrole-1,4-dione, 7,7'-[4,4-Bis(2-ethylhexyl)-4H-silolo[3,2-b:4,5-b']dithiophene-2,6-diyl]bis[6-fluoro-4-(5'-hexyl-[2,2'-bithiophen]-5-yl)benzo[c][1,2,5]thiadiazole] or 2,2'-Bis(2,2-dicyanovinyl)-quinquethiophene.

In another preferred embodiment of the present invention the p-type semiconductor is a conjugated organic polymer.

A suitable conjugated organic polymer (hereinafter simply referred to as "polymer") for use in a fullerene composition according to the present invention can be selected from polymers as described in prior art, for example in WO/2010/008672, WO/2010/049323, WO 2011/131280, WO/2011/052709, WO/2011/052710, US/2011/0017956, WO/2012/030942 or US/8334456B2.

A preferred polymer is selected from the group consisting of poly(3-substituted thiophene) and poly(3-substituted selenophene), preferably from poly(3-alkyl thiophene) and poly(3-alkyl selenophene), wherein "alkyl" is an alkyl group with 1 to 12 C atoms, very preferably poly(3-hexyl thiophene) or poly(3-hexyl selenophene).

A further preferred polymer comprises one or more repeating units selected from formulae PIIa and PIIb:

$$-[(Ar^1)_a-(D)_b-(Ar^2)_c-(Ar^3)_d]- \qquad \text{PIIa}$$

$$-[(Ar^1)_a-(Ac)_b-(Ar^2)_c-(Ar^3)_d]- \qquad \text{PIIb}$$

wherein

Ac is arylene or heteroarylene with 5 to 30 ring atoms that is optionally substituted by one or more groups $R^S$, and preferably has electron acceptor property,

D is arylene or heteroarylene with 5 to 30 ring atoms that is different from A, is optionally substituted by one or more groups $R^S$, and preferably has electron donor property,

$Ar^1$, $Ar^2$, $Ar^3$ are, on each occurrence identically or differently, and independently of each other, arylene or heteroarylene that is different from A and D, preferably has 5 to 30 ring atoms, and is optionally substituted, preferably by one or more groups $R^P$,

$R^P$ is on each occurrence identically or differently F, Br, Cl, -CN, -NC, -NCO, -NCS, -OCN, -SCN, $-C(O)NR^0R^{00}$, $-C(O)X^0$, $-C(O)R^0$, $-C(O)OR^0$, $-NH_2$, $-NR^0R^{00}$, -SH, $-SR^0$, $-SO_3H$, $-SO_2R^0$, -OH, $-NO_2$, $-CF_3$, $-SF_5$, optionally substituted silyl, carbyl or hydrocarbyl with 1 to 40 C atoms that is optionally substituted and optionally comprises one or more hetero atoms,

$R^0$ and $R^{00}$ are independently of each other H or optionally substituted $C_{1-40}$ carbyl or hydrocarbyl, and preferably denote H or alkyl with 1 to 12 C-atoms,

$X^0$ is halogen, preferably F, Cl or Br,

a, b, c are on each occurrence identically or differently 0, 1 or 2,

d is on each occurrence identically or differently 0 or an integer from 1 to 10.

Preferably the polymer comprises at least one repeating unit of formula PIIa wherein b is at least 1. Further preferably the polymer comprises at least one repeating unit of formula PIIa wherein b is at least 1, and at least one repeating unit of formula PIIb wherein b is at least 1.

A further preferred polymer comprises, in addition to the units of formula PIIa and/or PIIb, one or more repeating units selected from monocyclic or polycyclic arylene or heteroarylene groups that are optionally substituted.

These additional repeating units are preferably selected of formula PIII

$$-[(Ar^1)_a-(Ar^2)_c-(Ar^3)_d]- \qquad \text{PIII}$$

wherein $Ar^1$, $Ar^2$, $Ar^3$, a, c and d are as defined in formula PIIa.

$R^P$ preferably denotes, on each occurrence identically or differently, H, straight-chain, branched or cyclic alkyl with 1 to 30 C atoms, in which one or more $CH_2$ groups are optionally replaced by -O-, -S-, -C(O)-, -C(S)-, -C(O)-O-, -O-C(O)-, $-NR^0-$, $-SiR^0R^{00}-$, $-CF_2-$, $-CHR^0=CR^{00}-$, $-CY^1=CY^2-$ or -C≡C- in such a manner that O and/or S atoms are not linked directly to one another, and in which one or more H atoms are optionally replaced by F, Cl, Br, I or CN, or denotes aryl, heteroaryl, aryloxy or heteroaryloxy with 4 to 20 ring atoms which is optionally substituted, preferably by halogen or by one or more of the aforementioned alkyl or cyclic alkyl groups, wherein $R^0$ and $R^{00}$ and $Y^1$ and $Y^2$ have one of the meanings given above and below, $R^0$ and $R^{00}$ preferably denote H or alkyl with 1 to 12 C-atoms, and $Y^1$ and $Y^2$ preferably denote F, Cl or Br.

Further preferably the polymer is selected of formula PIV:

$$*\!-\!\!\left[(A)_x-(B)_y-(C)_z\right]_{n1}\!\!-\!* \qquad \text{PIV}$$

wherein

A, B, C independently of each other denote a distinct unit of formula PIIa, PIIb or PIII,

x is > 0 and ≤ 1,

y is ≥ 0 and < 1,

z is ≥ 0 and < 1,

x+y+z is 1, and

n1 is an integer >1.

Preferably at least one of B or C denotes a unit of formula PIIa. Very preferably one of B and C denotes a unit of formula PIIa and one of B and C denotes a unit of formula PIIb.

A preferred polymer of formula PIV is selected from the following formulae

$$*\text{-}[(Ar^1\text{-}D\text{-}Ar^2)_x\text{-}(Ar^3)_y]_{n1}\text{-}* \quad \text{PIVa}$$

$$*\text{-}[(Ar^1\text{-}D\text{-}Ar^2)_x\text{-}(Ar^3\text{-}Ar^3)_y]_{n1}\text{-}* \quad \text{PIVb}$$

$$*\text{-}[(Ar^1\text{-}D\text{-}Ar^2)_x\text{-}(Ar^3\text{-}Ar^3\text{-}Ar^3)_{y]n1}\text{-}* \quad \text{PIVc}$$

$$*\text{-}[(Ar^1)_a\text{-}(D)_b\text{-}(Ar^2)_c\text{-}(Ar^3)_d]_{n1}\text{-}* \quad \text{PIVd}$$

$$*\text{-}([(Ar^1)_a\text{-}(D)_b\text{-}(Ar^2)_c\text{-}(Ar^3)_d]_x\text{-}[(Ar^1)_a\text{-}(Ac)_b\text{-}(Ar^2)_c\text{-}(Ar^3)_d]_y)_{n1}\text{-}* \quad \text{PIVe}$$

$$*\text{-}[(D\text{-}Ar^1\text{-}D)_x\text{-}(Ar^2\text{-}Ar^3)_y]_{n1}\text{-}* \quad \text{PIVf}$$

$$*\text{-}[(D\text{-}Ar^1\text{-}D)_x\text{-}(Ar^2\text{-}Ar^3\text{-}Ar^2)_y]_{n1}\text{-}* \quad \text{PIVg}$$

$$*\text{-}[(D)_b\text{-}(Ar^1)_a\text{-}(D)_b\text{-}(Ar^2)_c]_{n1}\text{-}* \quad \text{PIVh}$$

$$*\text{-}([(D)_b\text{-}(Ar^1)_a\text{-}(D)_b\text{-}(Ar^2)_c]_x\text{-}[(Ac)_b\text{-}(Ar^1)_a\text{-}(Ac)_b\text{-}(Ar^2)_d]_y)_{n1}\text{-}* \quad \text{PIVi}$$

$$*\text{-}[(D\text{-}Ar^1)_x\text{-}(D\text{-}Ar^2)_y\text{-}(D\text{-}Ar^3)_z]_{n1}\text{-}* \quad \text{PIVk}$$

wherein D, $Ar^1$, $Ar^2$, $Ar^3$, a, b, c and d have in each occurrence identically or differently one of the meanings given in formula PIIa, Ac has on each occurrence identically or differently one of the meanings given in formula PIIb, and x, y, z and n1 are as defined in formula PIV, wherein these polymers can be alternating or random copolymers, and wherein in formula PIVd and PIVe in at least one of the repeating units $[(Ar^1)_a\text{-}(D)_b\text{-}(Ar^2)_c\text{-}(Ar^3)_d]$ and in at least one of the repeating units $[(Ar^1)_a\text{-}(Ac)_b\text{-}(Ar^2)_c\text{-}(Ar^3)_d]$ b is at least 1 and wherein in formula PIVh and PIVi in at least one of the repeating units $[(D)_b\text{-}(Ar^1)_a\text{-}(D)_b\text{-}(Ar^2)_d]$ and in at least one of the repeating units $[(D)_b\text{-}(Ar^1)_a\text{-}(D)_b\text{-}(Ar^2)_d]$ b is at least 1.

In the polymers of formula PIV and its subformulae PIVa to PIVk, b is preferably 1 in all repeating units.

In the polymers of formula PIV and its subformulae PIVa to PIVk, x is preferably from 0.1 to 0.9, very preferably from 0.3 to 0.7.

In a preferred embodiment of the present invention one of y and z is 0 and the other is >0. In another preferred embodiment of the present invention, both y and z are 0. In yet another preferred embodiment of the present invention, both y and z are >0. If in the polymers of formula PIV and its subformulae PIVa to PIVk y or z is >0, it is preferably from 0.1 to 0.9, very preferably from 0.3 to 0.7.

In the polymer, the total number of repeating units n1 is preferably from 2 to 10,000. The total number of repeating units n1 is preferably ≥ 5, very preferably ≥ 10, most preferably ≥ 50, and preferably ≤ 500, very preferably ≤ 1,000, most preferably ≤ 2,000, including any combination of the aforementioned lower and upper limits of n1.

The polymer can be a homopolymer or copolymer, like a statistical or random copolymer, alternating copolymer or block copolymer, or a combination of the aforementioned.

Especially preferred is a polymer selected from the following groups:

- Group A consisting of homopolymers of the unit D or ($Ar^1$-D) or ($Ar^1$-D-$Ar^2$) or ($Ar^1$-D-$Ar^3$) or (D-$Ar^2$-$Ar^3$) or ($Ar^1$-D-$Ar^2$-$Ar^3$) or (D-$Ar^1$-D), i.e. where all repeating units are identical,

- Group B consisting of random or alternating copolymers formed by identical units ($Ar^1$-D-$Ar^2$) or (D-$Ar^1$-D) and

identical units ($Ar^3$),

- Group C consisting of random or alternating copolymers formed by identical units ($Ar^1$-D-$Ar^2$) or (D-$Ar^1$-D) and identical units ($A^1$),

- Group D consisting of random or alternating copolymers formed by identical units ($Ar^1$-D-$Ar^2$) or (D-$Ar^1$-D) and identical units ($Ar^1$-Ac-$Ar^2$) or (Ac-$Ar^1$-Ac),

wherein in all these groups D, Ac, $Ar^1$, $Ar^2$ and $Ar^3$ are as defined above and below, in groups A, B and C $Ar^1$, $Ar^2$ and $Ar^3$ are different from a single bond, and in group D one of $Ar^1$ and $Ar^2$ may also denote a single bond .

A preferred polymer of formula PIV and PIVa to PIVk is selected of formula PV

$R^{21}$-chain-$R^{22}$ PV

wherein "chain" denotes a polymer chain of formulae PIV or PIVa to PIVk, and $R^{21}$ and $R^{22}$ have independently of each other one of the meanings of $R^S$ as defined above, or denote, independently of each other, H, F, Br, Cl, I, $-CH_2Cl$, -CHO, -CR'=CR"$_2$, -SiR'R"R"', -SiR'X'X", -SiR'R"X', -SnR'R"R"', -BR'R", -B(OR')(OR"), $-B(OH)_2$, $-O-SO_2-R'$, -C≡CH, -C≡C-SiR'$_3$, -ZnX' or an endcap group, X' and X" denote halogen, R', R" and R'" have independently of each other one of the meanings of $R^0$ given in formula I, and two of R', R" and R"' may also form a cyclosilyl, cyclostannyl, cycloborane or cycloboronate group with 2 to 20 C atoms together with the respective hetero atom to which they are attached.

Preferred endcap groups $R^{21}$ and $R^{22}$ are H, $C_{1-20}$ alkyl, or optionally substituted $C_{6-12}$ aryl or $C_{2-10}$ heteroaryl, very preferably H or phenyl.

In the polymer represented by formula PIV, PIVa to PIVk or PV, x, y and z denote the mole fraction of units A, B and C, respectively, and n denotes the degree of polymerisation or total number of units A, B and C. These formulae includes block copolymers, random or statistical copolymers and alternating copolymers of A, B and C, as well as homopolymers of A for the case when x>0 and y=z=0.

In the repeating units and polymers of formulae PIIa, PIIb, PIII, PIV, PIVa-PIVk and PV, preferably D, $Ar^1$, $Ar^2$ and $Ar^3$ are selected from the group consisting of the following formulae

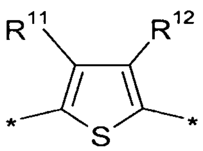
(D1)

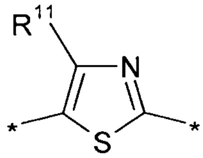
(D2)

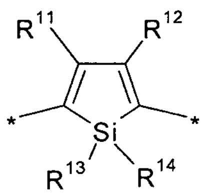
(D3)

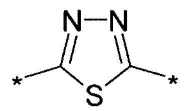
(D4)

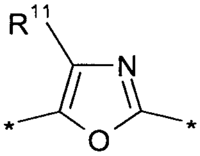
(D5)

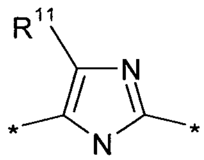
(D6)

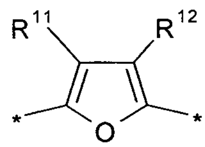
(D7)

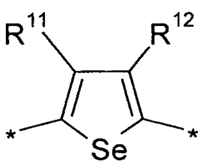
(D8)

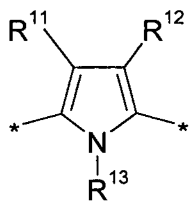
(D9)

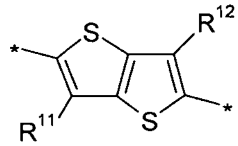
(D10)

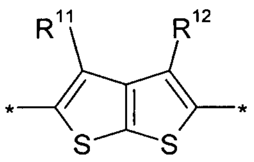

(D11)

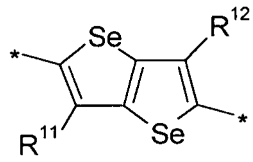

(D12)

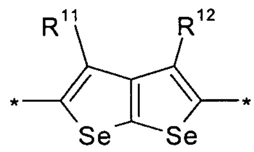

(D13)

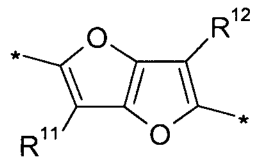

(D14)

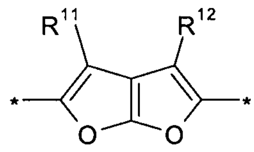

(D15)

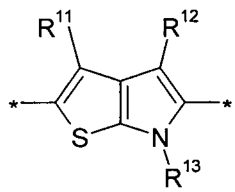

(D16)

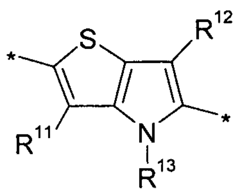

(D17)

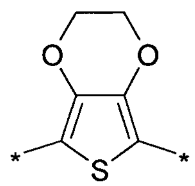

(D18)

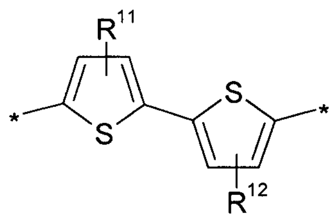

(D19)

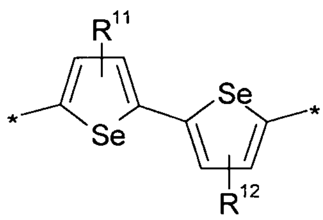

(D20)

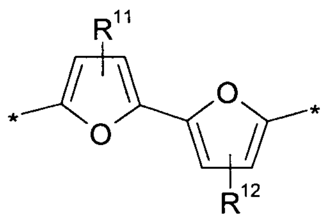

(D21)

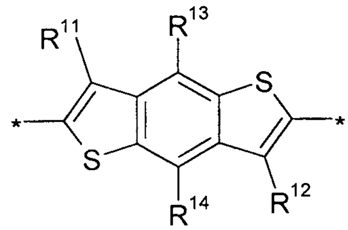

(D22)

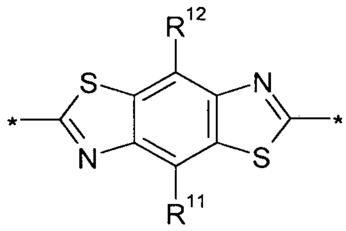

(D23)

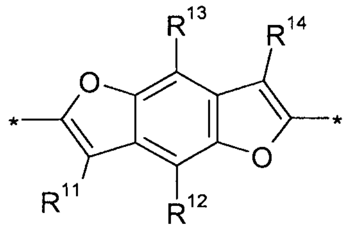

(D24)

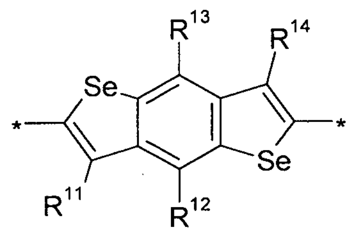

(D25)

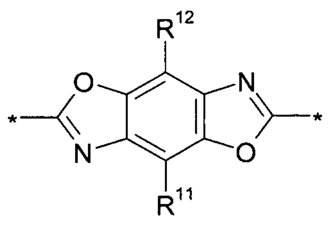
(D26)

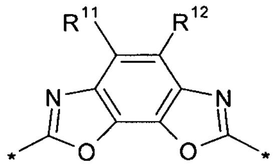
(D27)

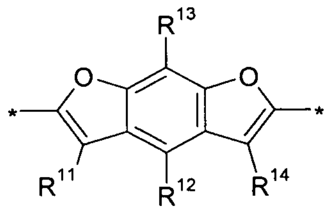
(D28)

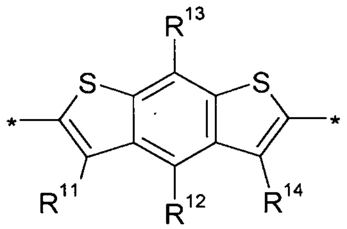
(D29)

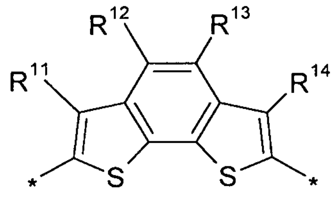
(D30)

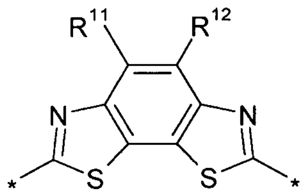
(D31)

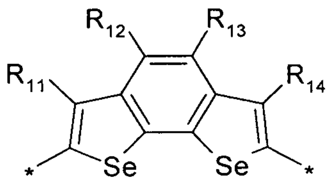
(D32)

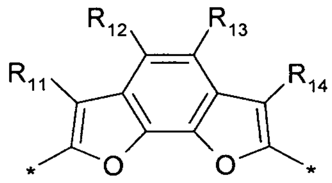
(D33)

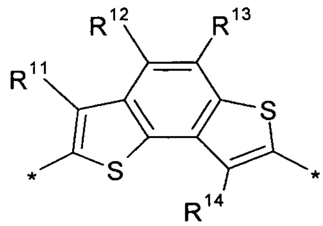
(D34)

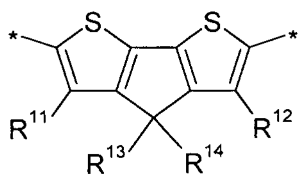
(D35)

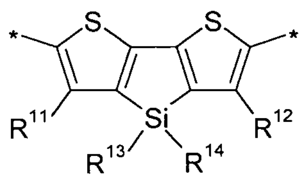
(D36)

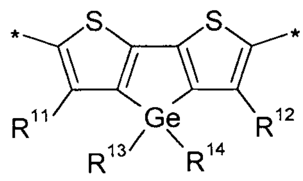
(D37)

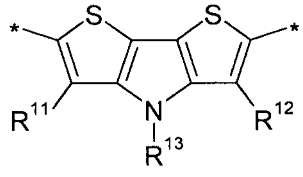
(D38)

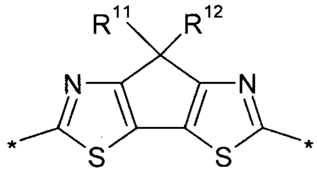
(D39)

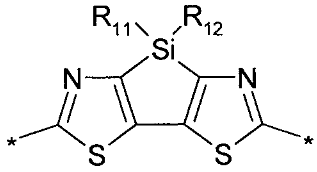
(D40)

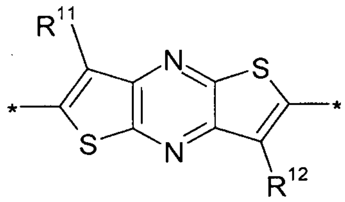

(D41)

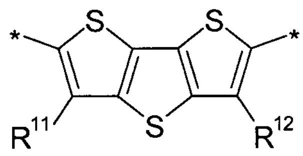

(D42)

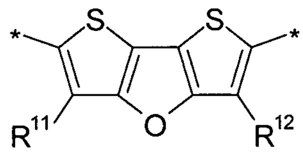

(D43)

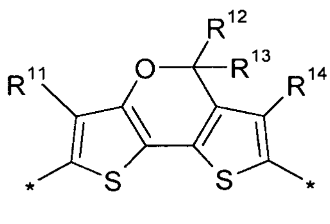

(D44)

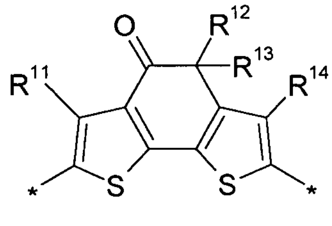

(D45)

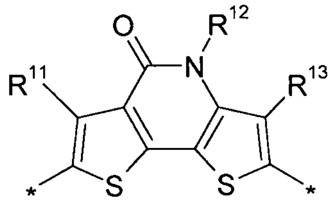

(D46)

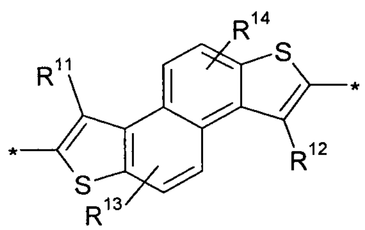

(D47)

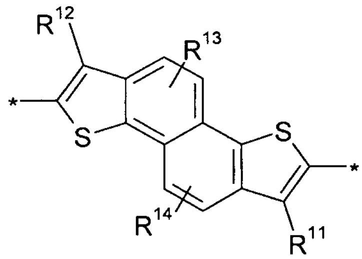

(D48)

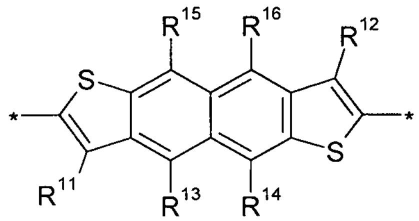

(D49)

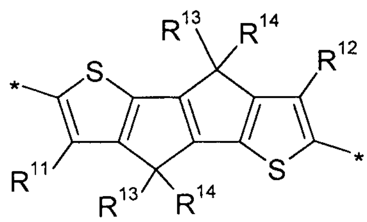

(D50)

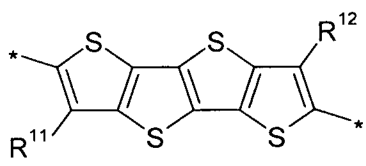

(D51)

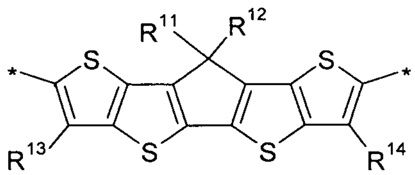

(D52)

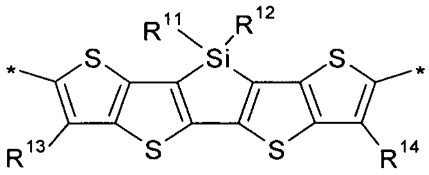

(D53)

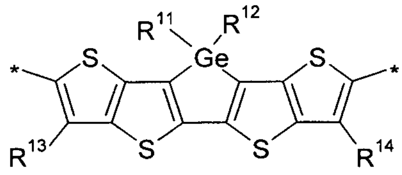

(D54)

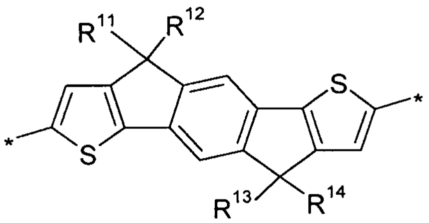

(D55)

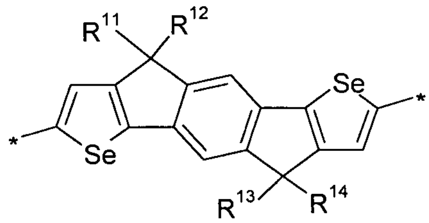

(D56)

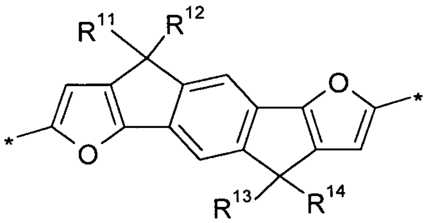

(D57)

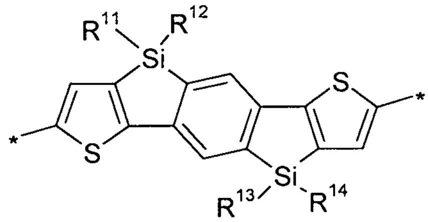

(D58)

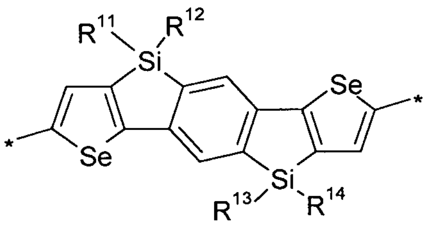

(D59)

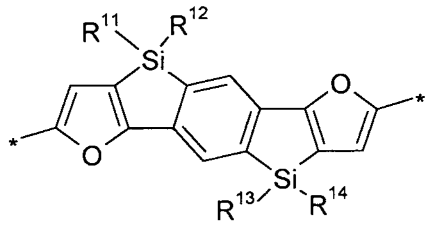

(D60)

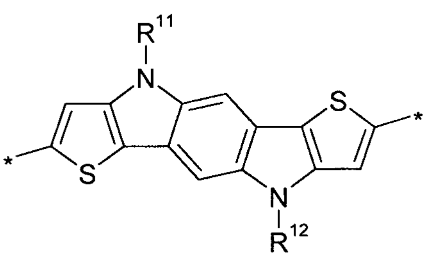

(D61)

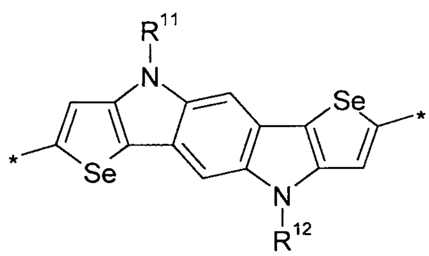

(D62)

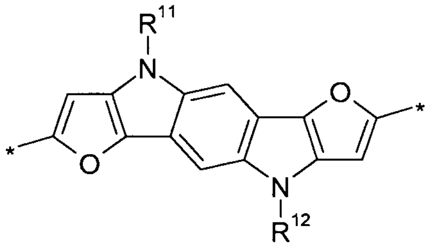

(D63)

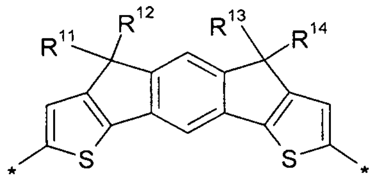

(D64)

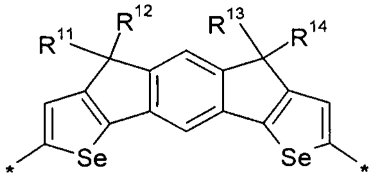

(D65)

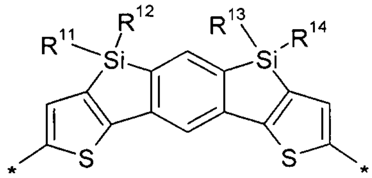

(D66)

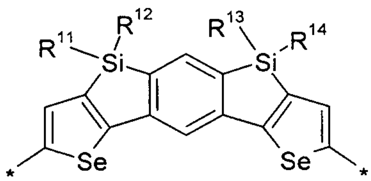

(D67)

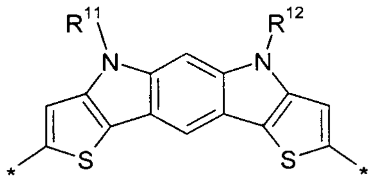

(D68)

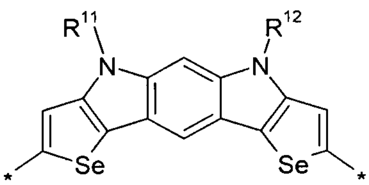

(D69)

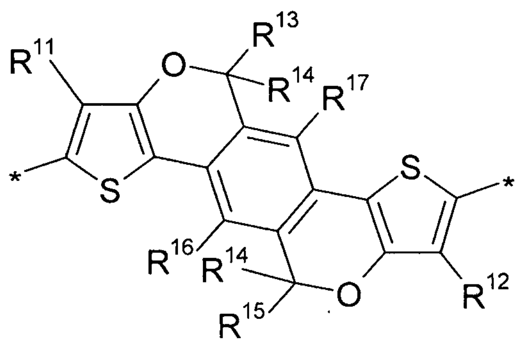

(D70)

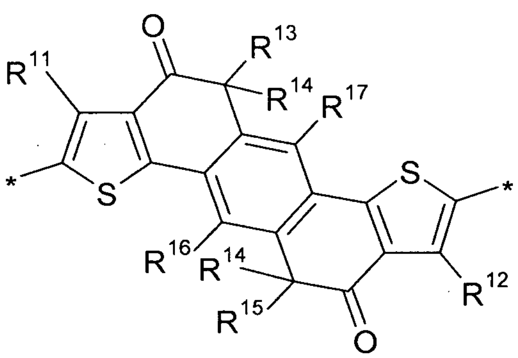

(D71)

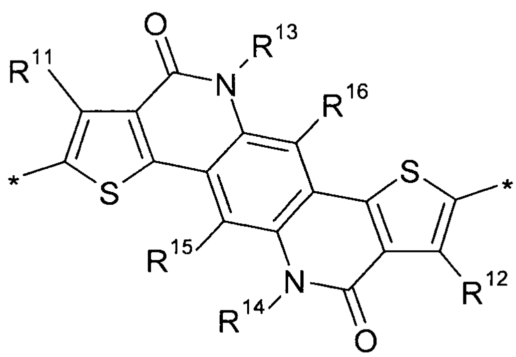

(D72)

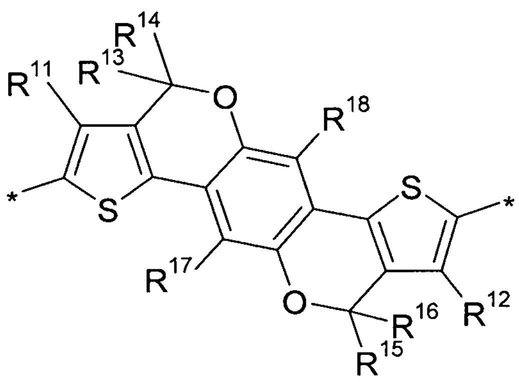

(D73)

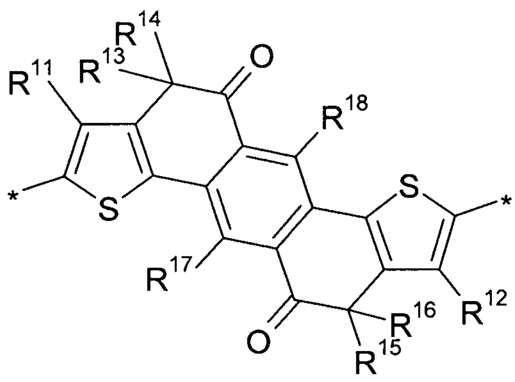

(D74)

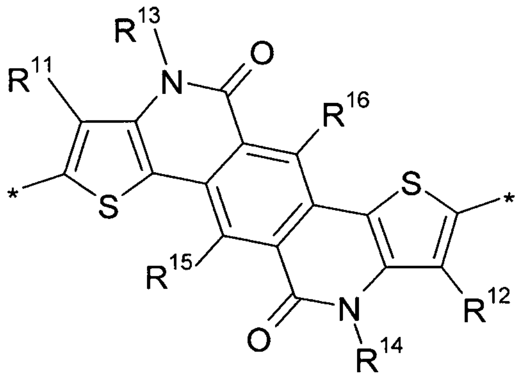

(D75)

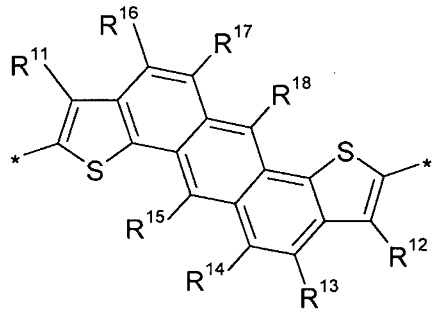

(D76)

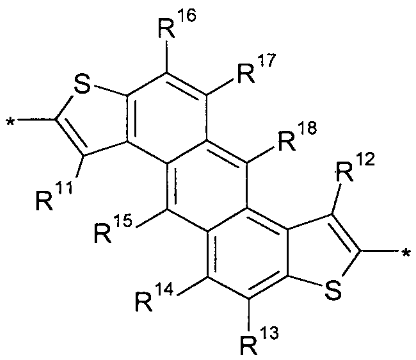

(D77)

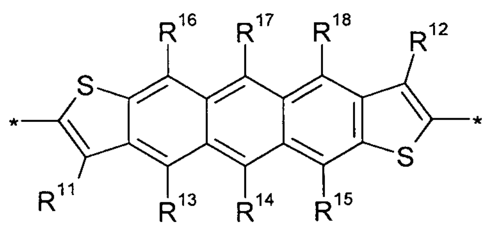

(D78)

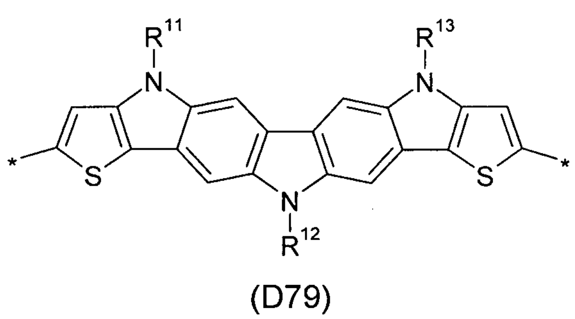

(D79)

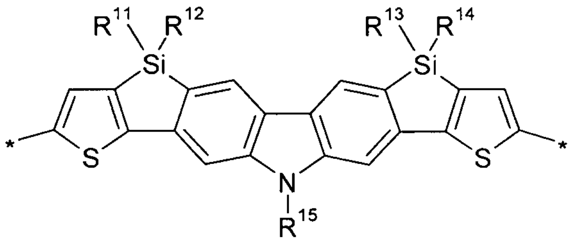

(D80)

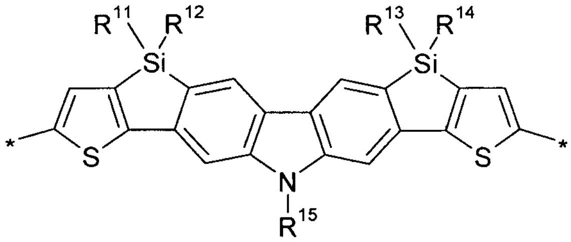

(D81)

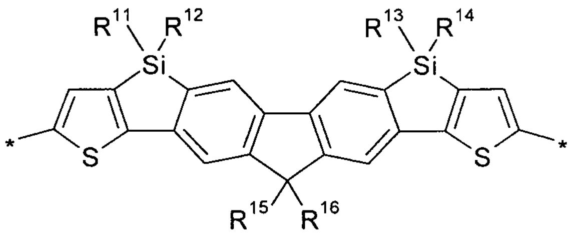

(D82)

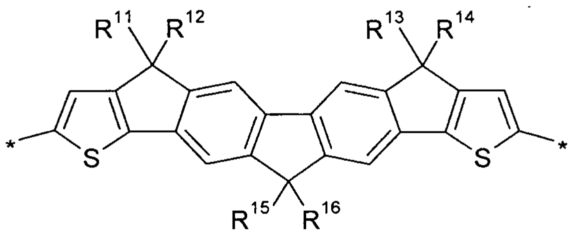

(D83)

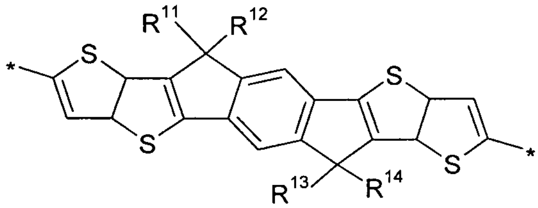

(D84)

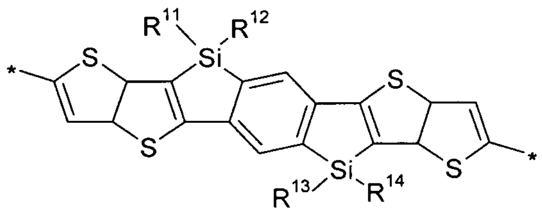

(D85)

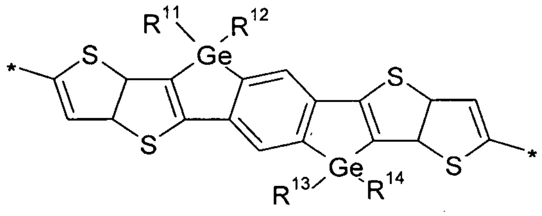

(D86)

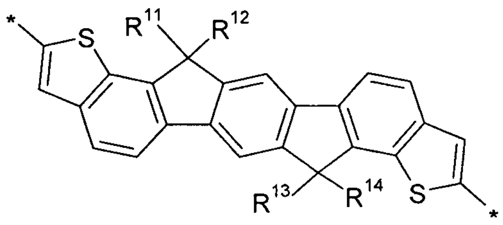

(D87)

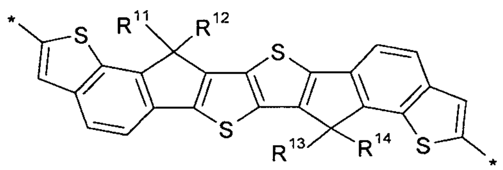

(D88)

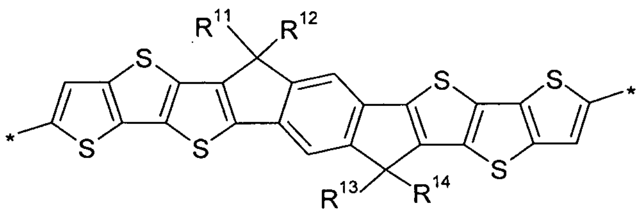

(D89)

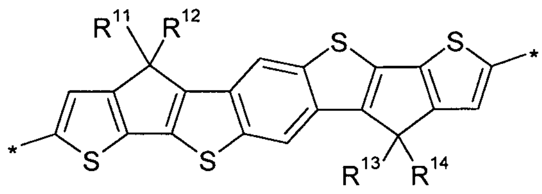

(D90)

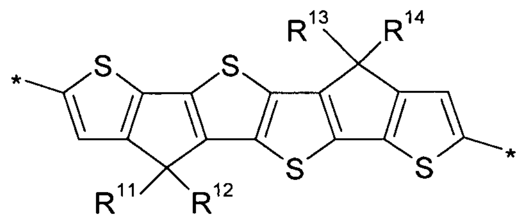

(D91)

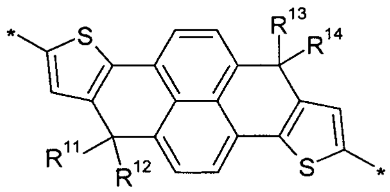

(D92)

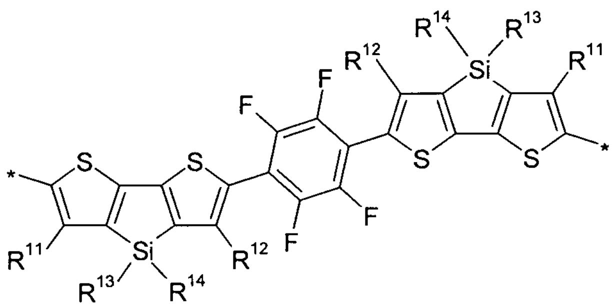

(D93)

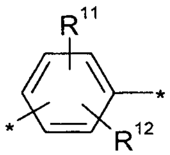

(D94)

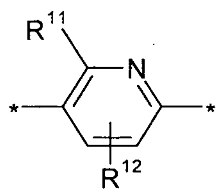

(D95)

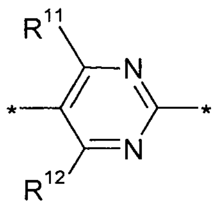

(D96)

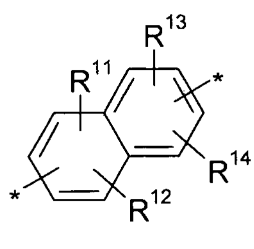

(D97)

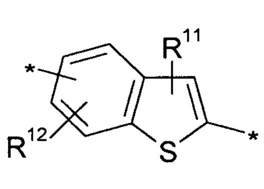

(D98)

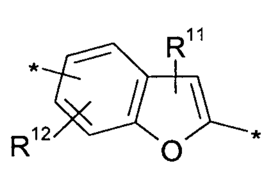

(D99)

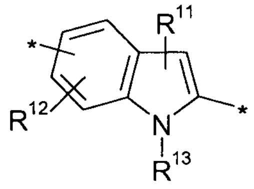

(D100)

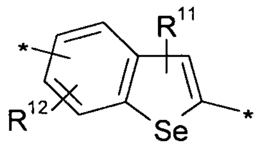

(D101)

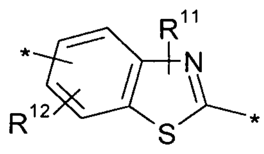

(D102)

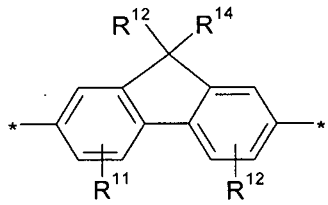

(D103)

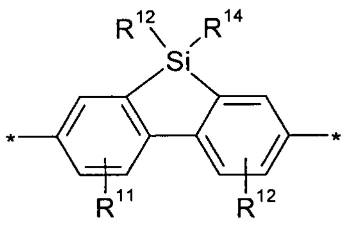

(D104)

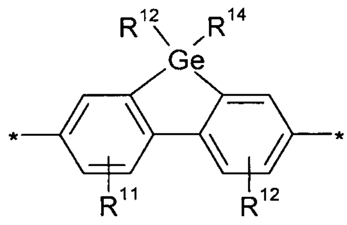

(D105)

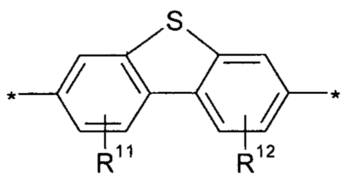

(D106)

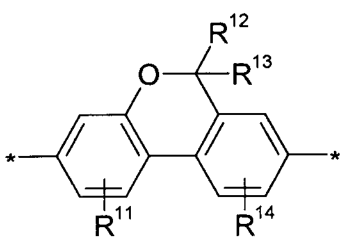

(D107)

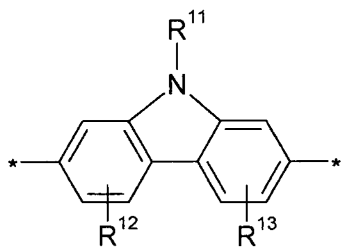

(D108)

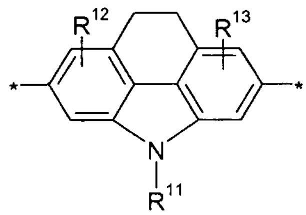

(D109)

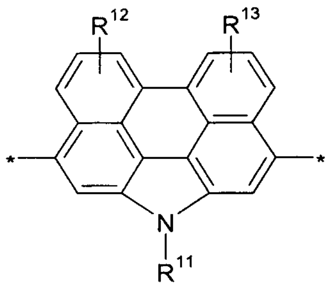

(D110)

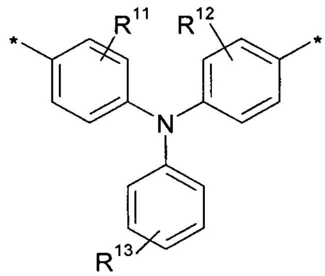

(D111)

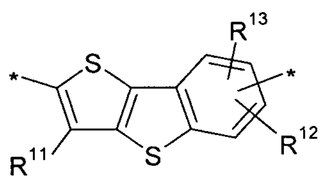

(D112)

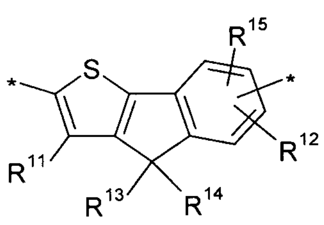
(D113)

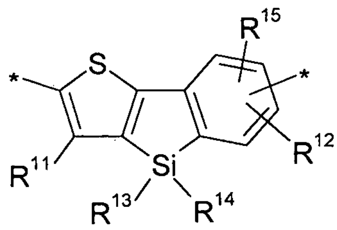
(D114)

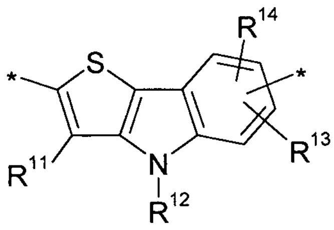
(D115)

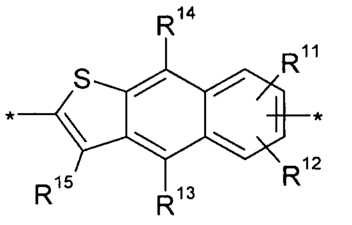
(D116)

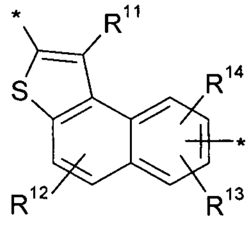
(D117)

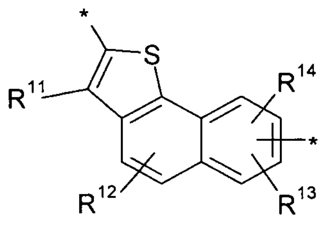
(D118)

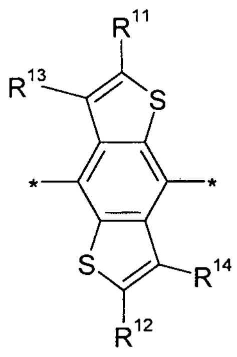
(D119)

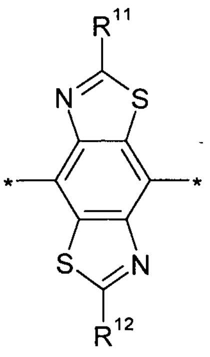
(D120)

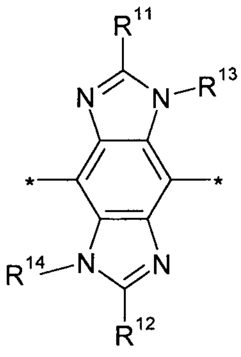
(D121)

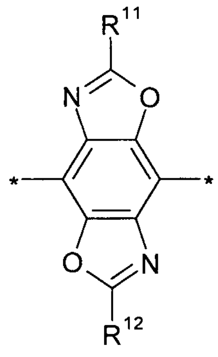
(D122)

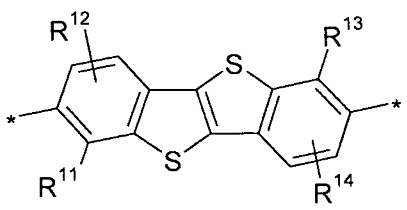
(D123)

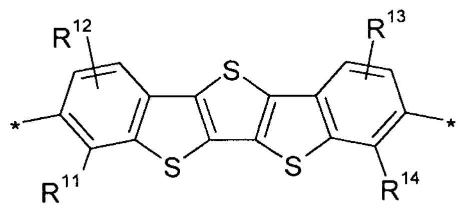
(D124)

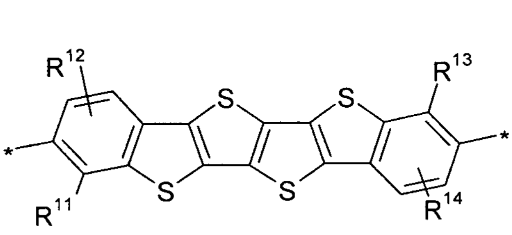
(D125)

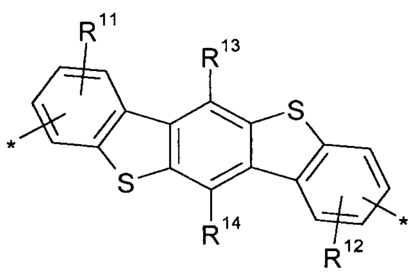
(D126)

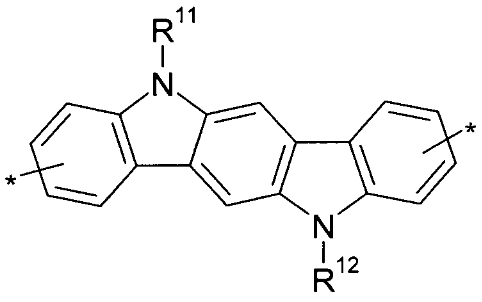

(D127)

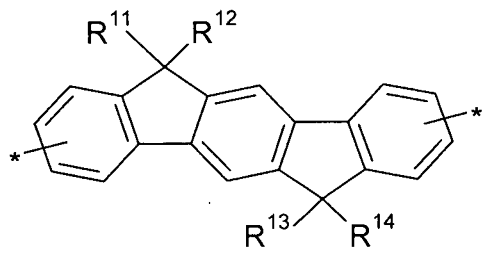

(D128)

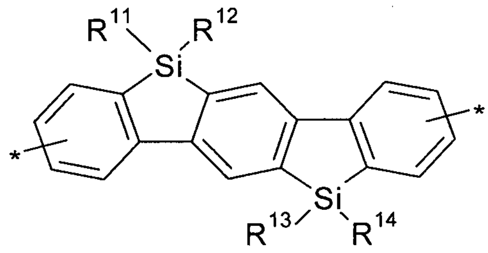

(D129)

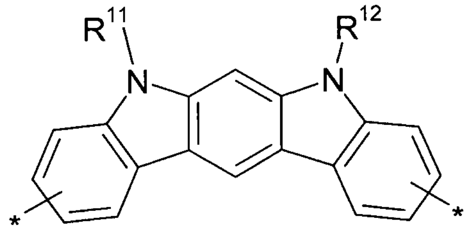

(D130)

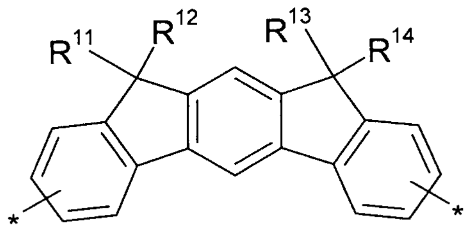

(D131)

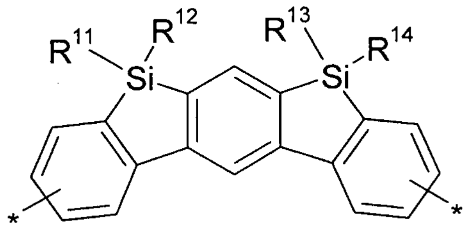

(D132)

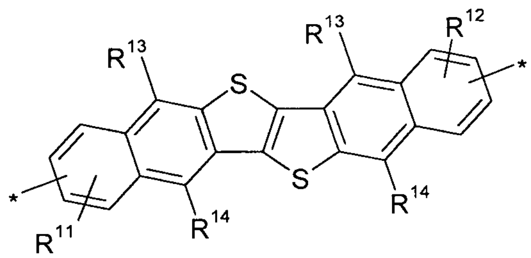

(D133)

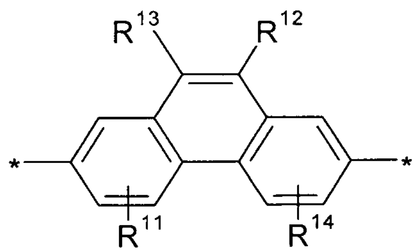

(D134)

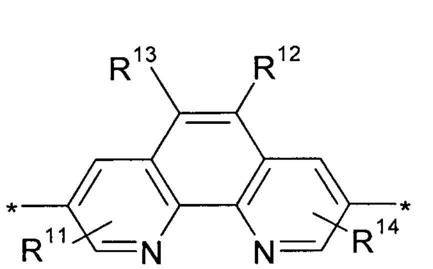

(D135)

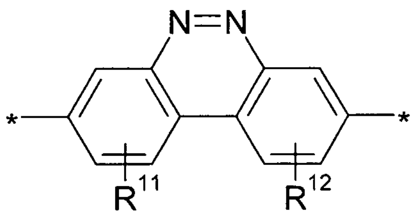

(D136)

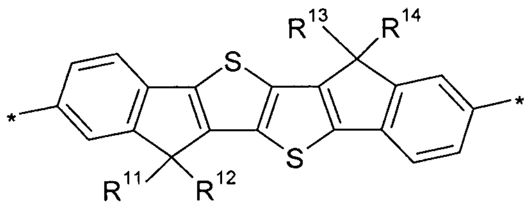

(D137)

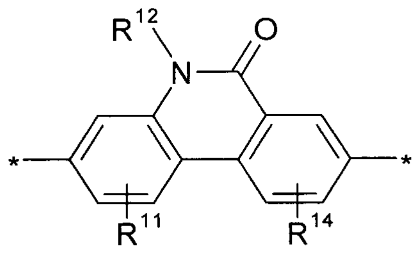

(D138)

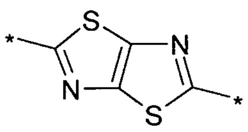

(D139)

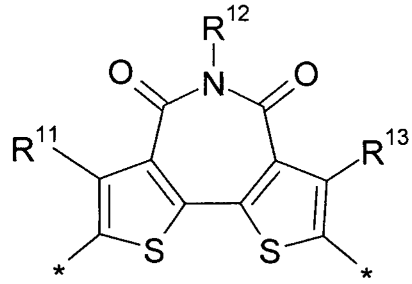

(D140)

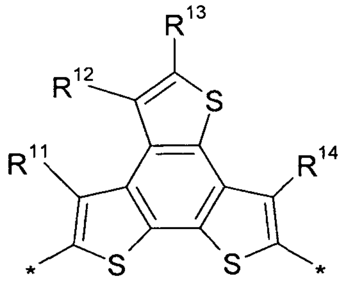

(D141)

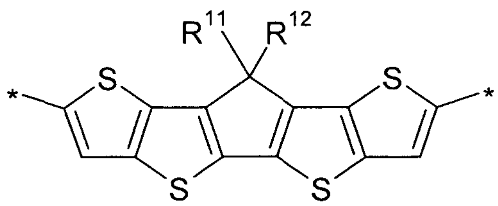

(D142)

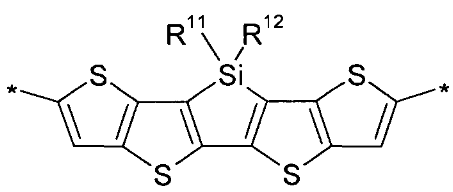

(D143)

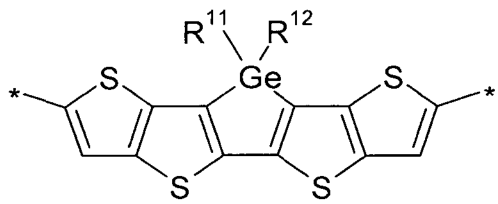

(D144)

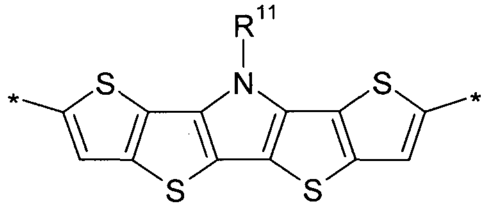

(D145)

wherein $R^{11}$, $R^{12}$, $R^{13}$, $R^{14}$, $R^{15}$, $R^{16}$, $R^{17}$ and $R^{18}$ independently of each other denote H or have one of the meanings

of $R^P$ as defined above and below. Preferred donor units are selected from formulae D1, D10, D19, D22, D25, D35, D36, D37, D38, D44, D84, D93, D94, D103, D108, D111, D137, D139, D140 or D141 wherein preferably at least one of $R^{11}$, $R^{12}$, $R^{13}$ and $R^{14}$ is different from H.

In the repeating units and polymers of formulae PIIa, PIIb, PIII, PIV, PIVa-PIVk and PV, preferably Ac, $Ar^1$, $Ar^2$ and $Ar^3$ are selected from the group consisting of the following formulae

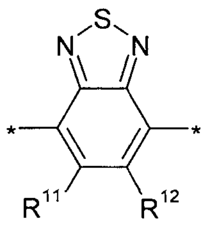
(A1)

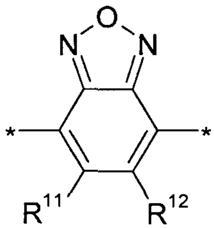
(A2)

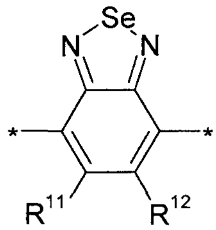
(A3)

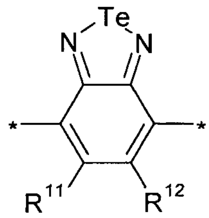
(A4)

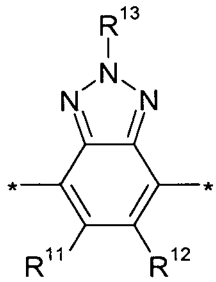
(A5)

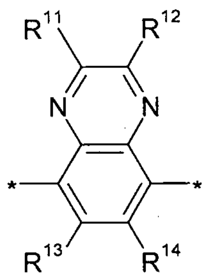
(A6)

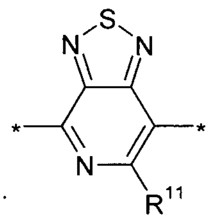
(A7)

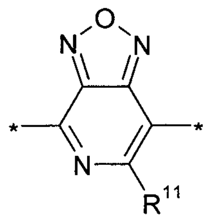
(A8)

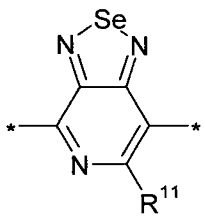
(A9)

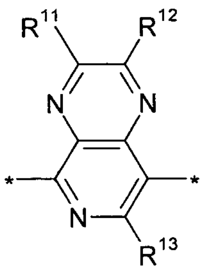
(A10)

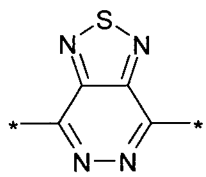
(A11)

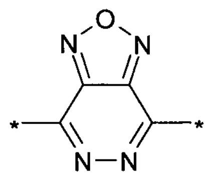
(A12)

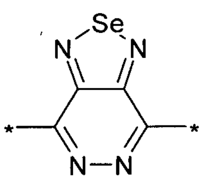
(A13)

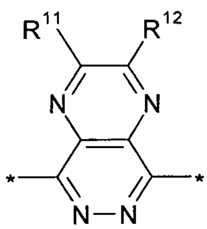
(A14)

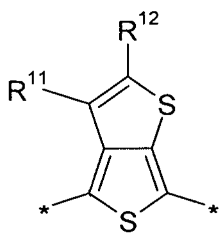
(A15)

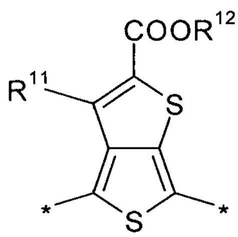
(A16)

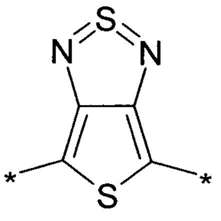

(A17)

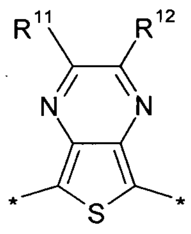

(A18)

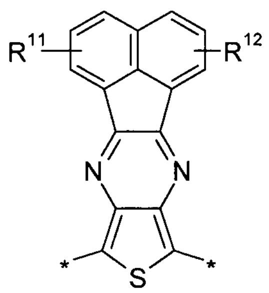

(A19)

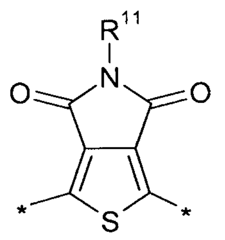

(A20)

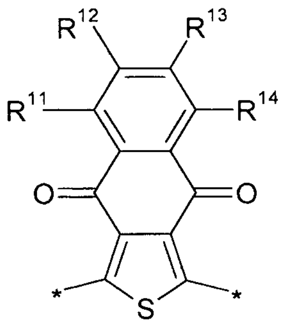

(A21)

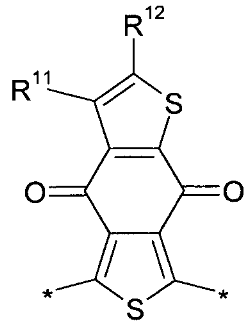

(A22)

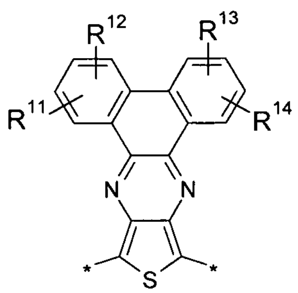

(A23)

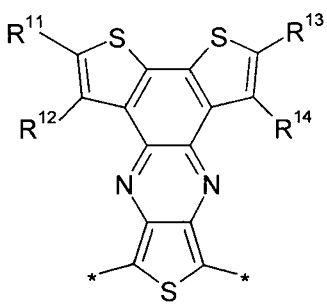

(A24)

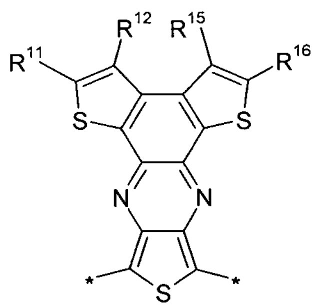

(A25)

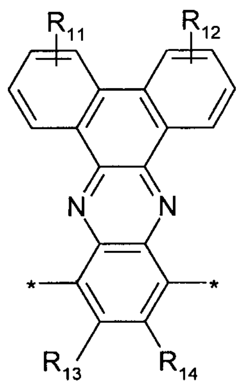

(A26)

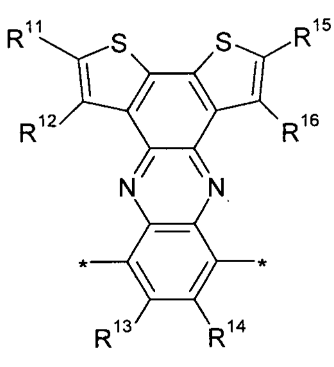

(A27)

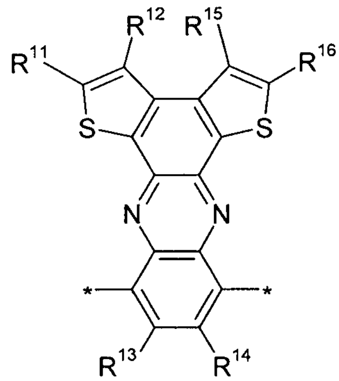

(A28)

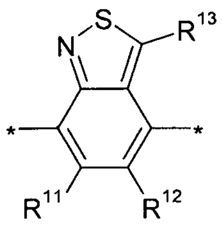
(A29)

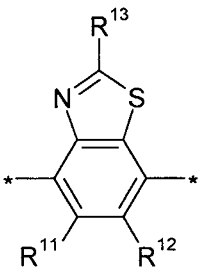
(A30)

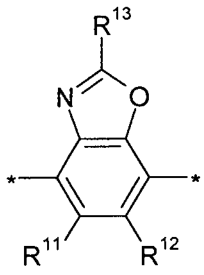
(A31)

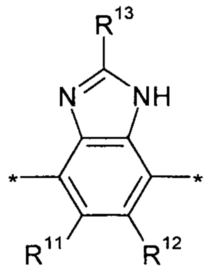
(A32)

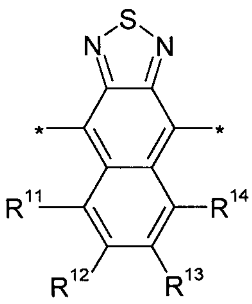
(A33)

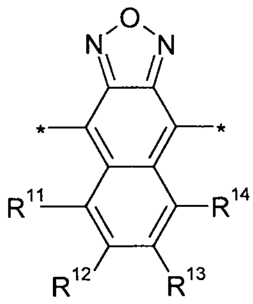
(A34)

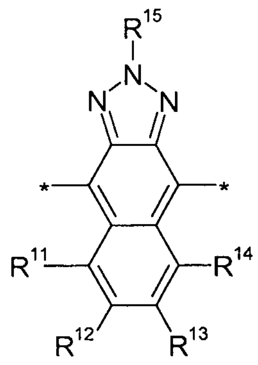
(A35)

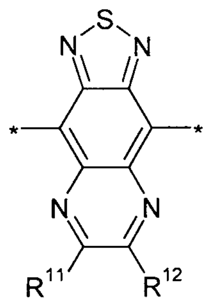
(A36)

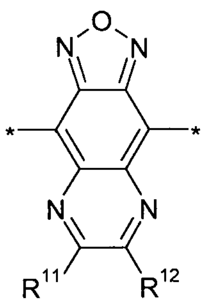
(A37)

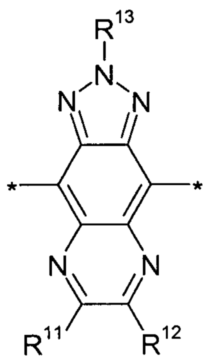
(A38)

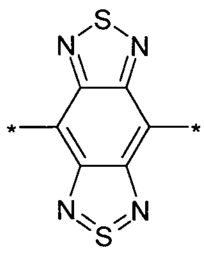
(A39)

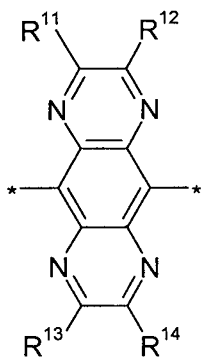
(A40)

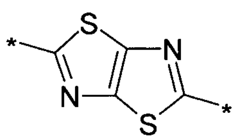
(A41)

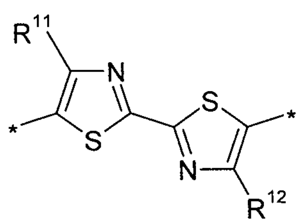
(A42)

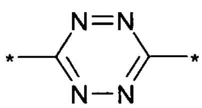
(A43)

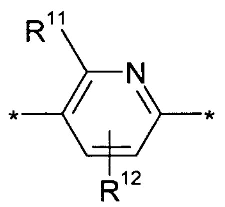

(A44)

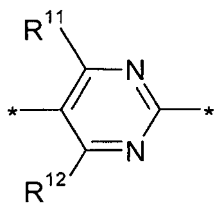

(A45)

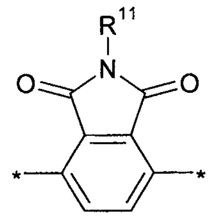

(A46)

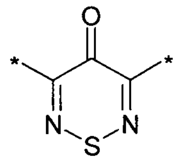

(A47)

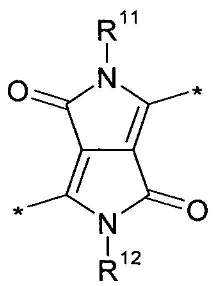

(A48)

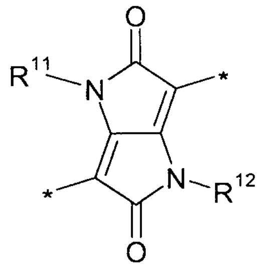

(A49)

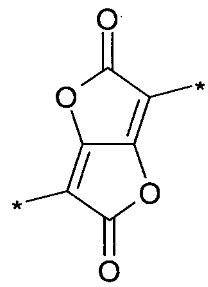

(A50)

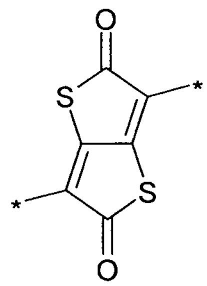

(A51)

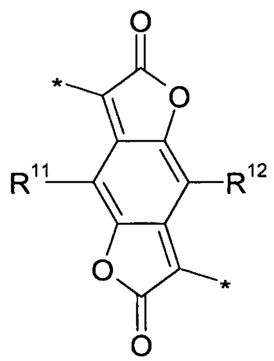

(A52)

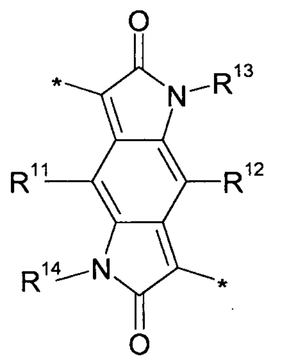

(A53)

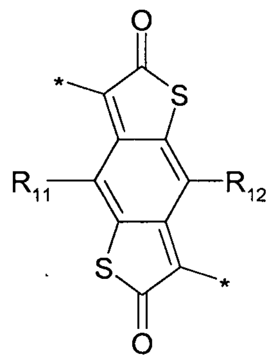

(A54)

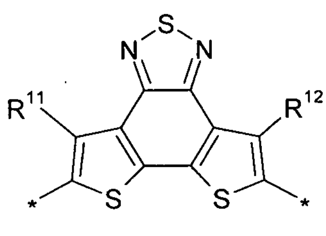

(A55)

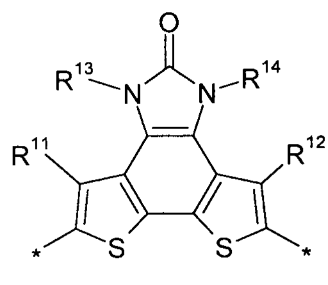

(A56)

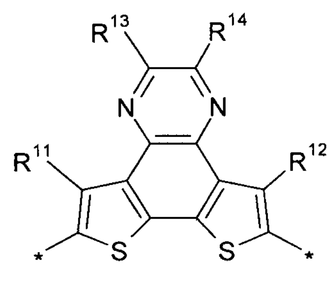

(A57)

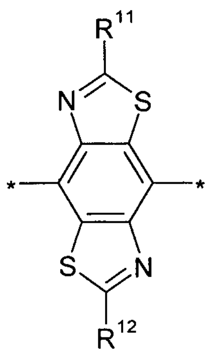

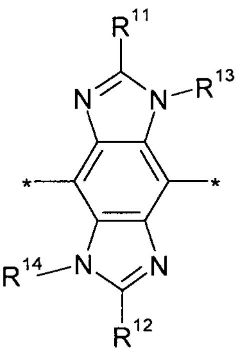

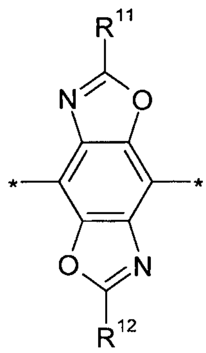

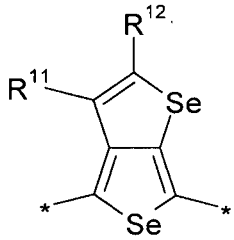

(A58) (A59) (A60) (A61)

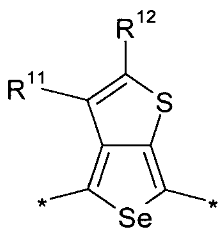

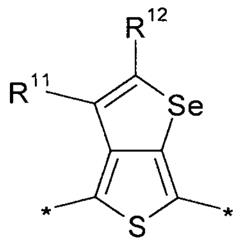

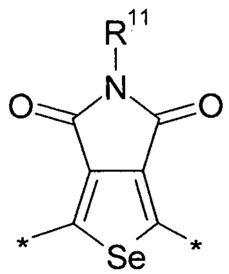

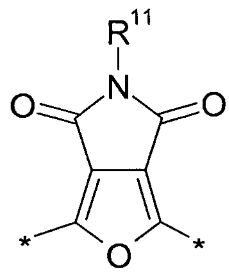

(A62) (A63) (A64) (A65)

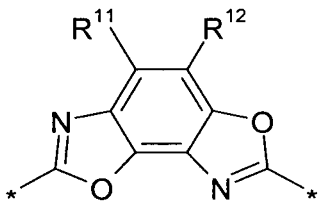

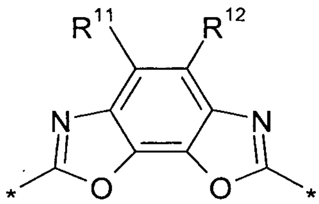

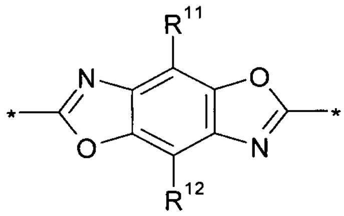

(A66) (A67) (A68)

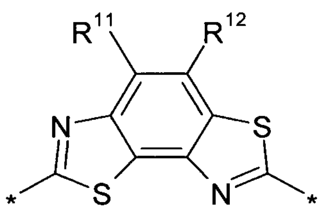

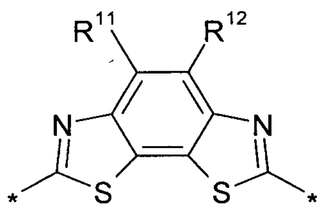

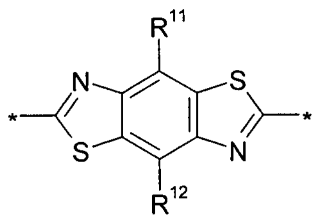

(A69) (A70) (A71)

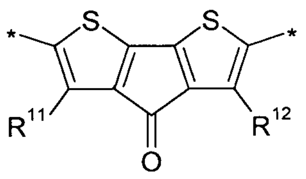

(A72)

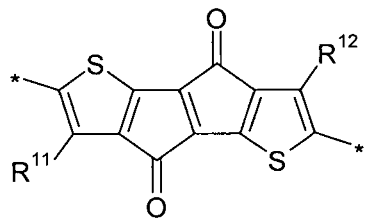

(A73)

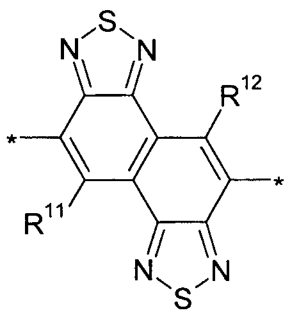

(A74)

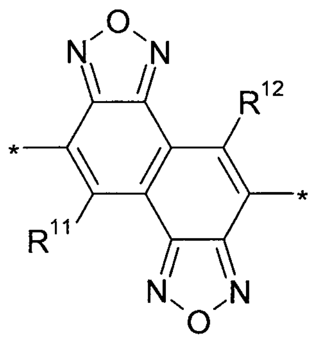

(A75)

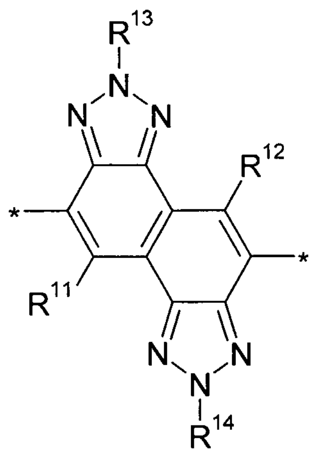

(A76)

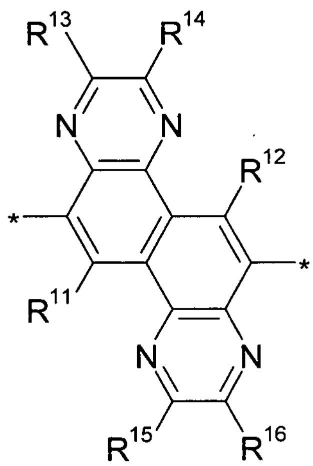

(A77)

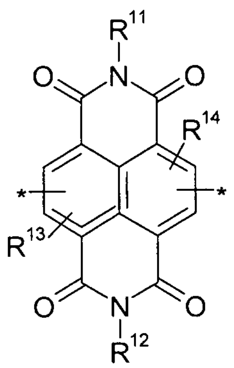

(A78)

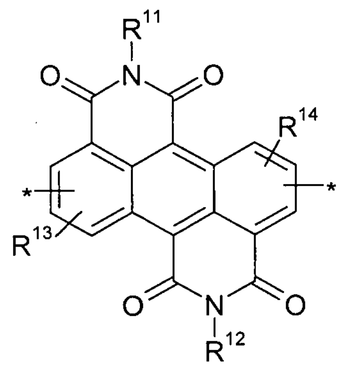

(A79)

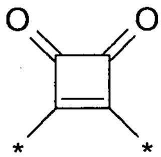

(A80)

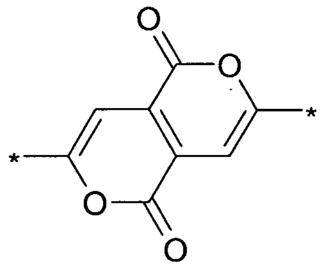

(A81)

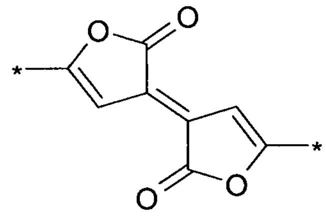

(A82)

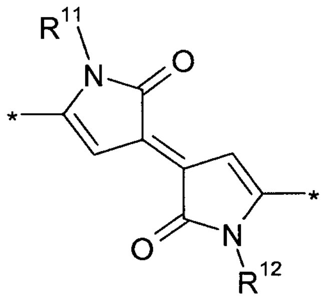

(A83)

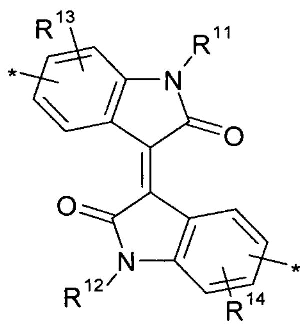

(A84)

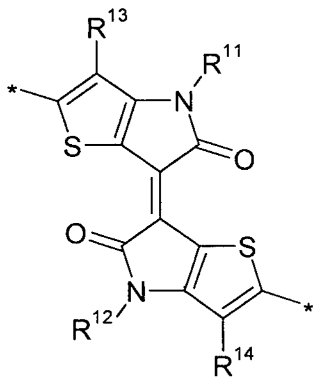

(A85)

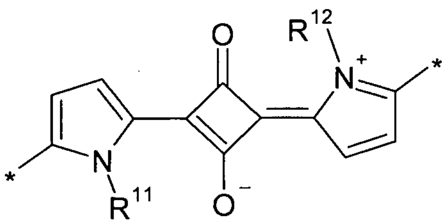

(A86)

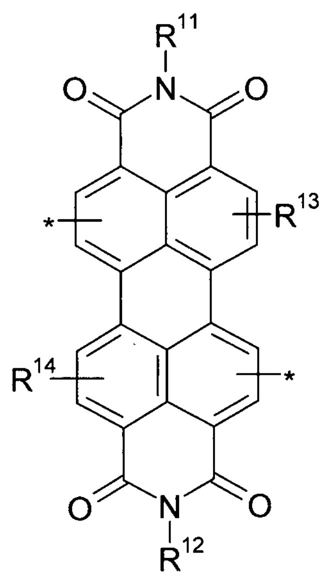

(A87)

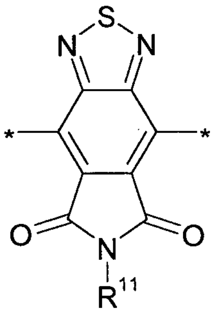
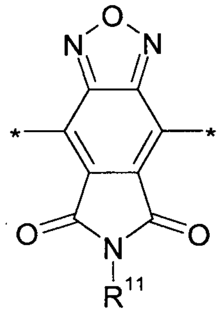
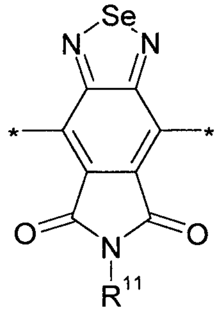
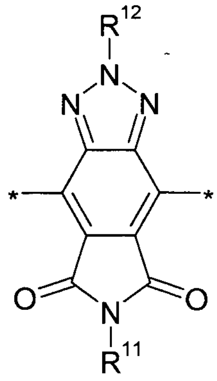

(A88) (A89) (A90) (A91)

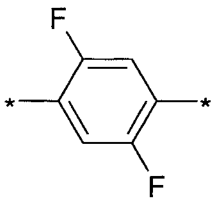
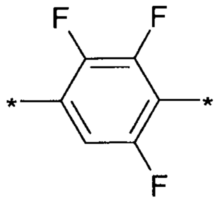
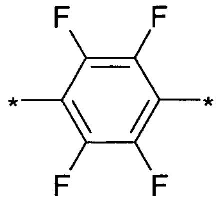
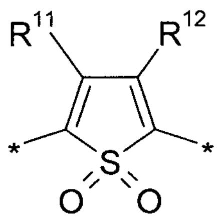

(A92) (A93) (A94) (A95)

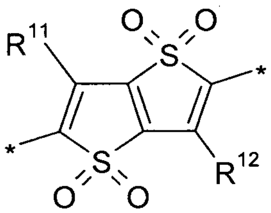
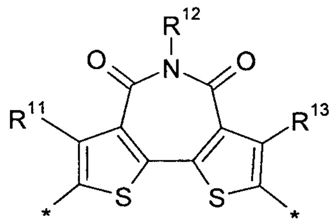

(A96) (A97)

wherein $R^{11}$, $R^{12}$, $R^{13}$, $R^{14}$, $R^{15}$ and $R^{16}$ independently of each other denote H or have one of the meanings of $R^P$ as defined above and below. Preferred acceptor units are selected from formulae A1, A2, A3, A20, A41, A48, A74, A85 or A94 wherein preferably at least one of $R^{11}$, $R^{12}$, $R^{13}$ and $R^{14}$ is different from H.

Preferably the polymer comprises one or more units $Ar^1$, $Ar^2$ or $Ar^3$, hereinafter also referred to as "spacer units" Sp, which are selected from the group consisting of the following formulae

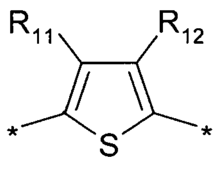

Sp1

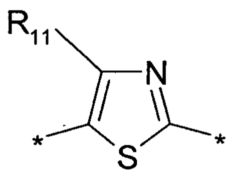

Sp2

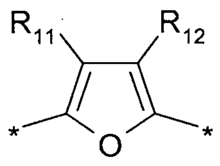

Sp3

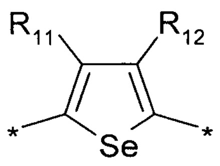

Sp4

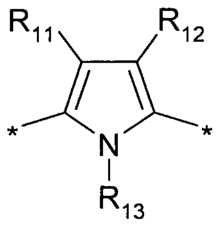

Sp5

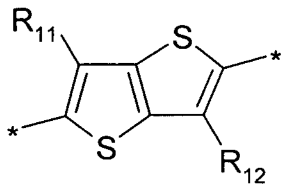

Sp6

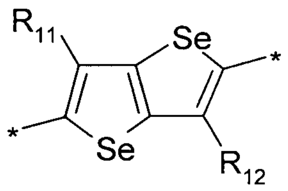

Sp7

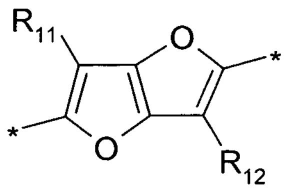

Sp8

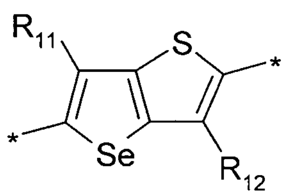

Sp9

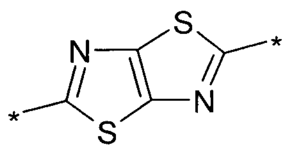

Sp10

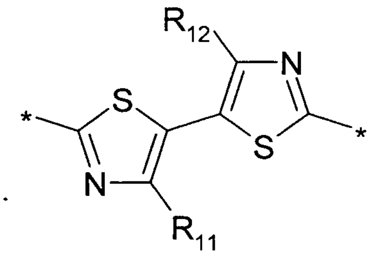

Sp11

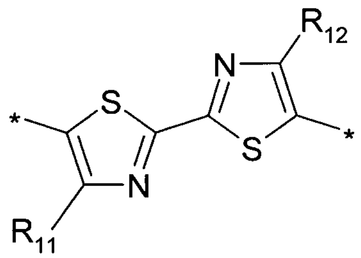

Sp12

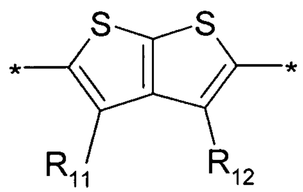

Sp13

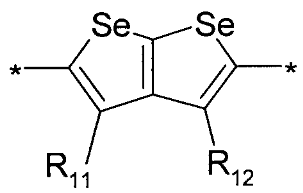

Sp14

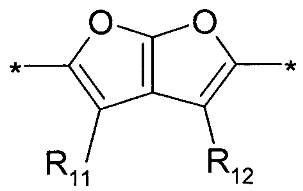

Sp15

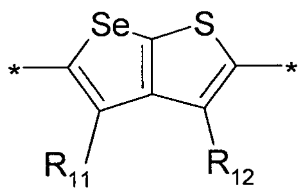

Sp16

wherein $R^{11}$ and $R^{12}$ are as defined above.

Preferred spacer units are selected from formula Sp1, Sp4 and Sp6, wherein preferably one of $R^{11}$ and $R^{12}$ is H or both $R^{11}$ and $R^{12}$ are H.

Preferably the conjugated polymer comprises one or more units of formula 1 and one or more units of formula 2

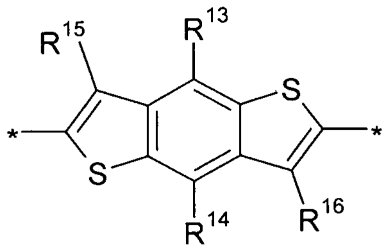

1

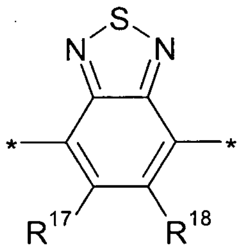

2

wherein the individual radicals, independently of each other, and on each occurrence identically or differently, have the following meanings

$R^{13-18}$ H, straight-chain or branched alkyl with 1 to 30 C atoms, in which one or more $CH_2$ groups are optionally replaced by-O-, -S-, -C(O)-, -C(S)-, -C(O)-O-, -O-C(O)-, $-NR^0-$,$-SiR^0R^{00}-$, $-CF_2-$, $-CHR^0=CR^{00}-$, $-CY^1=CY^2-$ or -C≡C- in such a manner that O and/or S atoms are not linked directly to one another, and in which one or more H atoms are optionally replaced by F, Cl or CN,

$R^0$ and $R^{00}$ H or alkyl with 1 to 12 C-atoms,

$Y^1$ and $Y^2$ H, F, Cl or CN,

Preferred polymers comprise, very preferably consist of, one or more units of the formula 1a and one or more units of the formula 2a

-(D-Sp)- 1a

-(A-Sp)- 2a

wherein D denotes a unit of formula 1, A denotes a unit of formula 2 and Sp denotes a unit selected from formulae Sp1 to Sp16, very preferably from formulae Sp1 and Sp6.

Preferred polymers consist of one or more units of formula 1, one or more units of formula 2 and optionally one or more spacer units selected from formulae Sp1 to Sp16.

Very preferred are polymers of formula P

$-[(D-Sp)_x-(A-Sp)_y]_n-$ P

wherein A, D and Sp are as defined in formula 1a and 2a, x denotes the molar fraction of the units (D-Sp), y denotes the molar fraction of the units (ASp), x and y are each, independently of one another > 0 and <1, with x+y=1, and n is an integer >1.

Preferred polymers of formula P are selected from the following subformulae

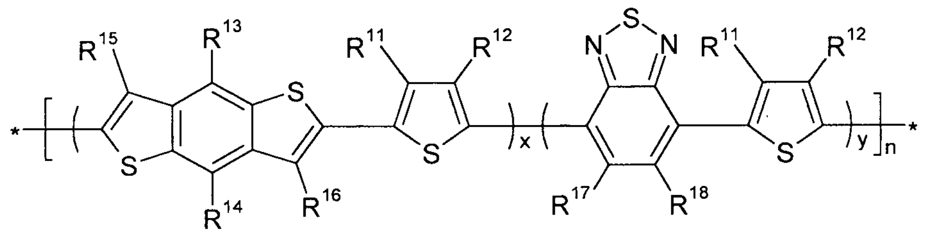

P1

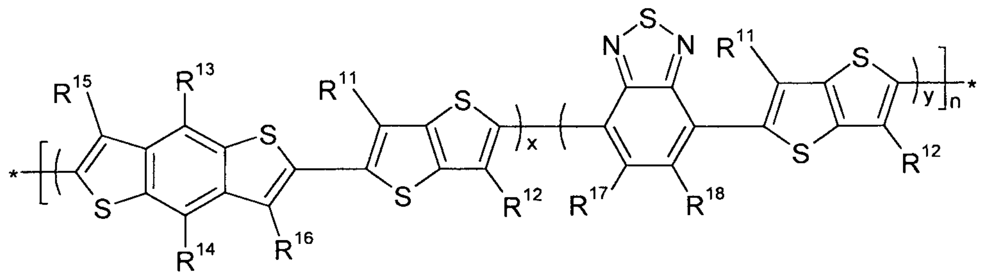

P2

wherein $R^{11-16}$, have one of the meanings of $R^{13}$ as given in formula 1 above, x is > 0 and <1, y is > 0 and < 1, x+y is 1, and n is an integer >1.

Preferably $R^{11}$ and $R^{12}$ in formulae Sp1 to Sp16, P1 and P2 are H.

Preferably $R^{13}$ and $R^{14}$ in formula 1, P1 and P2 are different from H.

Preferably $R^{15}$ and $R^{16}$ in formula 1, P1 and P2 are H.

Preferably $R^{17}$ and $R^{18}$ in formula 2, P1 and P2 are different from H.

Preferably $R^{11}$, $R^{12}$, $R^{13}$, $R^{14}$, $R^{15}$, $R^{16}$, $R^{17}$ and $R^{18}$ in formulae 1, 2, Sp1-Sp16, P1 and P2, when being different from H, are selected from the following groups:

- the group consisting of straight-chain or branched alkyl with 1 to 30, preferably 1 to 20, C atoms that is optionally fluorinated,

- the group consisting of straight-chain or branched alkyl, alkoxy or sulfanylalkyl with 1 to 30, preferably 1 to 20, C atoms, and straight-chain or branched alkylcarbonyl, alkylcarbonyloxy or alkyloxycarbonyl with 2 to 30, preferably 2 to 20, C atoms, each of the aforementioned groups being unsubstituted or substituted by one or more F atoms.

Very preferably $R^{13}$ and $R^{14}$ in formula 1, P1 and P2 denote -CO-O-$R^x$, with $R^x$ being straight-chain or branched alkyl with 1 to 20 C atoms that is optionally fluorinated.

Very preferably $R^{17}$ and $R^{18}$ in formula 2, P1 and P2 denote $R^x$ or -O$R^x$, with $R^x$ being straight-chain or branched alkyl with 1 to 20 C atoms that is optionally fluorinated.

In the polymers of formulae P, P1 and P2, x and y are preferably from 0.1 to 0.9, very preferably from 0.3 to 0.7, most preferably from 0.4 to 0.6.

The conjugated polymer can be prepared for example from monomers selected from the following formulae

$R^{23}$-$(Ar^1)_a$-D-$(Ar^2)_c$-$R^{24}$ PVIa

$R^{23}$-D-$(Ar^1)_a$-D-$R^{24}$ PVIb

$R^{23}$-$(Ar^1)_a$-Ac-$(Ar^2)_c$-$R^{24}$ PVIc

$R^{23}$-Ac-$(Ar^1)_a$-Ac-$R^{24}$ PVId

$R^{23}$-$(Ar^1)_a$-$(Ar^2)_c$-$R^{24}$ PVIe

wherein Ac, D, $Ar^1$, $Ar^2$, a and b have the meanings of formula PIIa and PIIb, or one of the preferred meanings as described above and below, and $R^{23}$ and $R^{24}$ are, preferably independently of each other, selected from the group consisting of H, Cl, Br, I, O-tosylate, O-triflate, O-mesylate, O-nona-flate, -$SiMe_2F$, -$SiMeF_2$, -O-$SO_2Z^1$, -$B(OZ^2)_2$ , -$CZ^3$=$C(Z^3)_2$, -C≡CH, -C≡CSi$(Z^1)_3$, -Zn$X^0$ and -Sn$(Z^4)_3$, wherein $X^0$ is halogen, preferably Cl, Br or I, $Z^{1-4}$ are selected from the group consisting of alkyl and aryl, each being optionally substituted, and two groups $Z^2$ may also together form

a cycloboronate group with 2 to 20 C atoms together with the B and O atoms.

Suitable monomers are for example selected from the following subformulae

$R^{23}$-$Ar^1$-D-$Ar^2$-$R^{24}$ PVIa1

$R^{23}$-D-$R^{24}$ PVIa2

$R^{23}$-$Ar^1$-O-$R^{24}$ PVIa3

$R^{23}$-D-$Ar^2$-$R^{24}$ PVIa4

$R^{23}$-D-$Ar^1$-D-$R^{24}$ PVIb1

$R^{23}$-$Ar^1$-Ac-$Ar^2$-$R^{24}$ PVIc1

$R^{23}$-Ac-$R^{24}$ PVIc2

$R^{23}$-$Ar^1$-Ac-$R^{24}$ PVIc3

$R^{23}$-Ac-$Ar^2$-$R^{24}$ PVIc4

$R^{23}$-Ac-$Ar^1$-Ac-$R^{24}$ PVId1

$R^{23}$-$Ar^1$-$R^{24}$ PVIe1

$R^{23}$-$Ar^1$-$Ar^2$-$R^{24}$ PVIe2

wherein Ac, D, $Ar^1$, $Ar^2$, a, c, $R^{23}$ and $R^{24}$ are as defined in formulae PVIa-PVIe.

Preferably the conjugated polymer are prepared by copolymerising one or more monomers selected from the following formulae in an aryl-aryl coupling reaction

$R^{33}$-D-$R^{34}$ MI

$R^{33}$-A-$R^{34}$ MII

$R^{33}$-Sp-$R^{34}$ MIII

wherein at least one monomer is selected of formula MI and at least one monomer is selected of formula MII,

D denotes a unit of formula 1,

A denotes a unit of formula 2,

Sp denotes a spacer unit selected from formulae Sp1 to Sp16,

$R^{33}$ and $R^{34}$ are as defined above.

The polymer can be synthesized according to or in analogy to methods that are known to the skilled person and are described in the literature. Other methods of preparation can be taken from the examples. For example, the polymers can be suitably prepared by aryl-aryl coupling reactions, such as Yamamoto coupling, Suzuki coupling, Stille coupling, Sonogashira coupling, C-H activation coupling, Heck coupling or Buchwald coupling. Suzuki coupling, Stille coupling and Yamamoto coupling are especially preferred. The monomers which are polymerised to form the repeat units of the polymers can be prepared according to methods which are known to the person skilled in the art.

For example the polymer can be prepared by coupling one or more monomers selected from formulae PVIa-PVIe and their subformulae in an aryl-aryl coupling reaction, wherein $R^{23}$ and $R^{24}$ are selected from Cl, Br, I, $-B(OZ^2)_2$ and $-Sn(Z^4)_3$.

Preferred aryl-aryl coupling and polymerisation methods used in the processes described above and below

are Yamamoto coupling, Kumada coupling, Negishi coupling, Suzuki coupling, Stille coupling, Sonogashira coupling, Heck coupling, C-H activation coupling, Ullmann coupling or Buchwald coupling. Especially preferred are Suzuki coupling, Negishi coupling, Stille coupling and Yamamoto coupling. Suzuki coupling is described for example in WO 00/53656 A1. Negishi coupling is described for example in J. Chem. Soc., Chem. Commun., 1977, 683-684. Yamamoto coupling is described in for example in T. Yamamoto et al., Prog. Polym. Sci., 1993, 17, 1153-1205, or WO 2004/022626 A1, and Stille coupling is described for example in Z. Bao et al., J. Am. Chem. Soc., 1995, 117, 12426-12435. For example, when using Yamamoto coupling, monomers having two reactive halide groups are preferably used. When using Suzuki coupling, monomers of formulae PVIa-PVId and their subformulae having two reactive boronic acid or boronic acid ester groups or two reactive halide groups are preferably used. When using Stille coupling, monomers having two reactive stannane groups or two reactive halide groups are preferably used. When using Negishi coupling, monomers having two reactive organozinc groups or two reactive halide groups are preferably used.

Preferred catalysts, especially for Suzuki, Negishi or Stille coupling, are selected from Pd(0) complexes or Pd(II) salts. Preferred Pd(0) complexes are those bearing at least one phosphine ligand such as $Pd(Ph_3P)_4$. Another preferred phosphine ligand is tris(*ortho*-tolyl)phosphine, i.e. $Pd(o\text{-}Tol_3P)_4$. Preferred Pd(II) salts include palladium acetate, i.e. $Pd(OAc)_2$. Alternatively the Pd(0) complex can be prepared by mixing a Pd(0) dibenzylideneacetone complex, for example tris(dibenzyl-ideneacetone)dipalladium(0), bis(dibenzylideneacetone)-palladium(0), or Pd(II) salts *e.g.* palladium acetate, with a phosphine ligand, for example triphenylphosphine, tris(*ortho*-tolyl)phosphine or tri(tert-butyl)phosphine. Suzuki polymerisation is performed in the presence of a base, for example sodium carbonate, potassium carbonate, lithium hydroxide, potassium phosphate or an organic base such as tetraethylammonium carbonate or tetraethylammonium hydroxide. Yamamoto polymerisation employs a Ni(0) complex, for example bis(1,5-cyclooctadienyl) nickel(0).

Suzuki and Stille polymerisation may be used to prepare homopolymers as well as statistical, alternating and block random copolymers. Statistical or block copolymers can be prepared for example from the above monomers of formula PVI or its subformulae, wherein one of the reactive groups is halogen and the other reactive group is a boronic acid, boronic acid derivative group or and alkylstannane. The synthesis of statistical, alternating and block copolymers is described in detail for example in WO 03/048225 A2 or WO 2005/014688 A2.

In a semiconducting mixture according to the present invention comprising a conjugated polymer as p-type semiconductor ("p-type polymer"), a polyfullerene as described above and below and a fullerene that is different from the polyfullerene ("fullerene"), the molar ratio of p-type polymer/fullerene/polyfullerene is preferably 1:[0.8 to 2.0]:[0.04 to 0.25], i.e. the mixture preferably comprises 1 equivalent of p-type polymer, 0.8 to 2.0 equivalents of fullerene and 0.04 to 0.25 equivalents of polyfullerene.

Another aspect of the present invention relates to a formulation comprising a polyfullerene or a semiconducting mixture as described above and below and one or more solvents, preferably selected from organic solvents.

Such a formulation is preferably used as a carrier for the preparation of the photoactive layer of an OE device, like an OPV or OPD device.

The concentration of the polyfullerene in the formulation is preferably from 2 to 100 $mg\cdot cm^{-3}$, more preferably from 5 to 50 $mg\cdot cm^{-3}$, most preferably from 5 to 20 $mg\cdot cm^{-3}$.

The concentration of the p-type semiconductor in the formulation is preferably from 0.1 to 10 $mg\cdot cm^{-3}$, more preferably from 0.2 to 5 $mg\cdot cm^{-3}$, most preferably from 0.5 to 5 $mg\cdot cm^{-3}$.

The concentration of the fullerene that is different from the polyfullerene in the formulation is preferably from 2 to 100 $mg\cdot cm^{-3}$, more preferably from 5 to 50 $mg\cdot cm^{-3}$, most preferably from 5 to 20 $mg\cdot cm^{-3}$.

Optionally the formulation further comprises one or more binders to adjust the rheological properties, as described for example in WO 2005/055248 A1. Preferably a polymeric binder is comprised in the mixture at a concentration from 5 to 95% by weight. Examples of suitable and preferred binders include polystyrene (PS), polypropylene (PP) and polymethylmethacrylate (PMMA).

The formulation according to the present invention preferably forms a solution.

The invention additionally provides an OE device comprising a semiconducting mixture or BHJ according to the present invention in its photoactive layer. For use in OPV or OPD devices a semiconducting mixture is used that contains a p-type (electron donor) semiconductor and an n-type (electron acceptor) semiconductor. The n-type semiconductor is a polyfullerene, or a mixture of two or more fullerenes, at least one of which is a polyfullerene. The p-type semiconductor is for example a conjugated polymer as described above.

The OE, OPV or OPD device preferably further comprises a first transparent or semi-transparent electrode on a transparent or semi-transparent substrate on one side of the active layer, and a second metallic or semi-transparent electrode on the other side of the active layer.

Preferably, the active layer according to the present invention is further blended with additional organic and inorganic compounds to enhance the device properties. For example, metal particles such as Au or Ag nanoparticles or Au or Ag nanoprism for enhancements in light harvesting due to near-field effects (i.e. plasmonic effect) as described, for example in Adv. Mater. 2013, 25 (17), 2385-2396 and Adv. Ener. Mater. 10.1002/aenm.201400206, a molecular dopant such as 2,3,5,6-tetrafluoro-7,7,8,8-tetracyanoquinodimethane for enhancement in photoconductivity as described, for example in Adv. Mater. 2013, 25(48), 7038-7044, or a stabilising agent consisting of a UV absorption agent and/or anti-radical agent and/or antioxidant agent such as 2-hydroxybenzophenone, 2-hydroxyphenylbenzotriazole, oxalic acid anilides, hydroxyphenyl triazines, merocyanines, hindered phenol, N-aryl-thiomorpholine, N-aryl-thiomorpholine-1-oxide, N-aryl-thiomorpholine-1,1-dioxide, N-aryl-thiazolidine, N-aryl-thiazolidine-1-oxide, N-aryl-thiazolidine-1,1-dioxide and 1,4-diazabicyclo[2.2.2]octane as described, for example, in WO2012095796 A1 and in WO2013021971 A1.

The OE, OPV or OPD device preferably may further comprise a UV to visible photo-conversion layer such as described, for example, in J. Mater. Chem. 2011, 21, 12331 or a NIR to visible or IR to NIR photo-conversion layer such as described, for example, in J. Appl. Phys. 2013, 113, 124509.

Further preferably the OE, OPV or OPD device comprises, between the active layer and the first or second electrode, one or more additional buffer layers acting as hole transporting layer and/or electron blocking layer, which comprise a material such as metal oxides, like for example, ZTO, $MoO_x$, $NiO_x$, a doped conjugated polymer, like for example PEDOT:PSS and polypyrrole-polystyrene sulfonate (PPy:PSS), a conjugated polymer, like for example polytriarylamine (PTAA), an organic compound, like for example substituted triaryl amine derivatives such as N,N'-diphenyl-N,N'-bis(1-naphthyl)(1,1'-biphenyl)-4,4'diamine (NPB), N,N'-diphenyl-N,N'-(3-methylphenyl)-1,1'-biphenyl-4,4'-diamine (TPD), graphene based materials, like for example, graphene oxide and graphene quantum dots or alternatively as hole blocking layer and/or electron transporting layer, which comprise a material such as metal oxide, like for example, $ZnO_x$, $TiO_x$, AZO (aluminium doped zinc oxide), a salt, like for example LiF, NaF, CsF, a conjugated polymer electrolyte, like for example poly[3-(6-trimethylammoniumhexyl)thiophene], poly(9,9-bis(2-ethylhexyl)-fluorene]-*b*-poly[3-(6-trimethylammoniumhexyl)thiophene, or poly[(9,9-bis(3'-(N,N-dimethylamino)propyl)-2,7-fluorene)-alt-2,7-(9,9-dioctylfluorene)], a polymer, like for example poly(ethyleneimine) or crosslinked N-containing compound derivatives or an organic compound, like for example tris(8-quinolinolato)-aluminium(III) ($Alq_3$), phenanthroline derivative or $C_{60}$ or $C_{70}$ based fullerenes, like for example, as described in Adv. Energy Mater. 2012, 2, 82-86.

To produce thin layers in OE devices, like BHJ OPV devices, the mixture or formulation according to the present invention may be deposited by any suitable method. Liquid coating of devices is more desirable than vacuum deposition techniques. Solution deposition methods are especially preferred. The formulations of the present invention enable the use of a number of liquid coating techniques. Preferred deposition techniques include, without limitation, dip coating, spin coating, ink jet printing, nozzle printing, letter-press printing, screen printing, gravure printing, doctor blade coating, roller printing, reverse-roller printing, offset lithography printing, dry offset lithography printing, flexographic printing, web printing, spray coating, curtain coating, brush coating, slot dye coating or pad printing. For the fabrication of OPV devices and modules area printing method compatible with flexible substrates are preferred, for example slot dye coating, spray coating and the like.

When preparing a suitable solution or formulation containing a composition with a fullerene derivative (as n-type component) and a polymer (as p-type component) according to the present invention, a suitable solvent should be selected so as to ensure full dissolution of both the p-type and the n-type component, and to take into account the boundary conditions (for example rheological properties) introduced by the chosen printing method.

Organic solvents are generally used for this purpose. Typical solvents can be aromatic solvents, halogenated solvents or chlorinated solvents, including chlorinated aromatic solvents. Preferred solvents are aliphatic hydrocarbons, chlorinated hydrocarbons, aromatic hydrocarbons, ketones, ethers and mixtures thereof. Examples include, but are not limited to dichloromethane, trichloromethane, tetrachloromethane, chlorobenzene, o-dichlorobenzene, 1,2,4-trichlorobenzene, 1,2-dichloroethane, 1,1,1-trichloroethane, 1,1,2,2-tetrachloroethane, 1,8-diiodooctane, 1-chloronaphthalene, 1,8-octane-dithiol, anisole, 2-methylanisole, phenetol, 4-methyl-anisole, 3-methylanisole, 2,6-dimethylanisole, 2,5-dimethylanisole, 2,4-dimethylanisole, 3,5-dimethyl-anisole, 4-fluoroanisole, 3-fluoro-anisole, 3-trifluoro-methylanisole, 4-fluoro-3-methylanisole, 2-fluoroanisole, toluene, o-xylene, m-xylene, p-xylene, mixture of xylene o-, m-, and p-isomers, 1,2,4-trimethylbenzene, 1,2,3,4-tetra-methyl benzene, pentylbenzene, mesitylene, cumene, cymene, cyclohexylbenzene, diethylbenzene, cyclohexane, 1-methylnaphthalene, 2-methylnaphthalene, 1,2-dimethylnaphthalene, tetraline, decaline, indane, 1-methyl-4-(1-methylethenyl)-cyclohexene (d-Limonene), 6,6-dimethyl-2-methylenebicyclo[3.1.1]heptanes (β -pinene), 2,6-lutidine, 2-fluoro-m-xylene, 3-fluoro-o-xylene, 2-chloro-benzotrifluoride, 2-chloro-6-fluorotoluene, 2,3-dimethylpyrazine, 2-fluorobenzonitrile, 4-fluoroveratrol, 3-fluorobenzo-nitrile, 1-fluoro-3,5-dimethoxy-benzene, 3-fluorobenzo-trifluoride, benzotrifluoride, trifluoromethoxy-benzene, 4-fluorobenzotrifluoride, 3-fluoropyridine, toluene, 2-fluoro-toluene, 2-fluorobenzotrifluoride, 3-fluorotoluene, 4-isopropylbiphenyl, phenyl ether, pyridine, 4-fluorotoluene, 2,5-difluorotoluene, 1-chloro-2,4-difluorobenzene, 2-fluoropyridine, 3-chlorofluoro-benzene, 1-chloro-2,5-difluorobenzene, 4-chlorofluorobenzene, 2-chlorofluorobenzene, methyl benzoate, ethyl benzoate, nitrobenzene, benzaldehyde, benzonitrile, tetrahydrofuran, 1,4-dioxane, 1,3-dioxane, morpholine, acetone, methylethylketone, ethyl acetate, n-butyl acetate, N,N-dimethylaniline, N,N-dimethylformamide, N-methylpyrrolidinone, dimethylacetamide, dimethylsulfoxide and/or mixtures thereof.

Especially preferred are solvents selected from aliphatic or aromatic hydrocarbons, or mixtures thereof, which are non-chlorinated.

Further preferred are solvents selected from non-chlorinated aliphatic or aromatic hydrocarbons, or mixtures

thereof, which contain less than 5% of halogenated but non-chlorinated (e.g. fluorinated, brominated or iodinated) aliphatic or aromatic hydrocarbons, like e.g. 1,8-diiodooctane.

Preferred solvents of this type are selected from 1,2,4-trimethylbenzene, 1,2,3,4-tetra-methyl benzene, pentylbenzene, acetophenone, mesitylene, cumene, cymene, cyclohexylbenzene, diethylbenzene, tetralin, decalin, 2,6-lutidine, N,N-dimethylformamide, 2,3-dimethylpyrazine, 2-methylanisole, phenetol, 4-methyl-anisole, 3-methylanisole, 2,5-dimethyl-anisole, 2,4-dimethylanisole, 3,5-dimethyl-anisole, N,N-dimethylaniline, ethyl benzoate, 1-methylnaphthalene, 2-methylnaphthalene, N-methylpyrrolidinone, dioxane, 4-isopropylbiphenyl, phenyl ether, pyridine, 1,8-octanedithiol, nitrobenzene, 1-chloronaphthalene, p-xylene, m-xylene, o-xylene or mixture of o-, m-, and p-isomers.

The OPV device can be of any OPV device type known from the literature (see e.g. Waldauf et al., Appl. Phys. Lett., 2006, 89, 233517).

A first preferred OPV device according to the invention comprises the following layers (in the sequence from bottom to top):

- optionally a substrate,
- a high work function electrode, preferably comprising a metal oxide, like for example ITO, serving as anode or a conducting grid
- an optional conducting polymer layer or hole transport layer, preferably comprising an organic polymer or polymer blend, for example PEDOT:PSS (poly(3,4-ethylenedioxythiophene): poly(styrene-sulfonate), substituted triaryl amine derivatives, for example,TBD (N,N'-dyphenyl-N-N'-bis(3-methylphenyl)-1,1'biphenyl-4,4'-diamine) or NBD (N,N'-dyphenyl-N-N'-bis(1-napthylphenyl)-1,1'biphenyl-4,4'-diamine),
- a layer, also referred to as "photoactive layer", comprising a semiconducting mixture as described above and below, which can exist for example as a p-type/n-type bilayer or as distinct p-type and n-type layers, or as blend or p-type and n-type semiconductor, forming a BHJ,
- optionally a layer having electron transport properties, for example comprising LiF, $TiO_x$, $ZnO_x$, PFN, a poly(ethyleneimine) or crosslinked nitrogen containing compound derivatives or a phenanthroline derivatives
- a low work function electrode, preferably comprising a metal like for example aluminum, serving as cathode, wherein at least one of the electrodes, preferably the anode, is at least partially transparent to visible light.

A second preferred OPV device according to the invention is an inverted OPV device and comprises the following layers (in the sequence from bottom to top):

- optionally a substrate,
- a high work function metal or metal oxide electrode, comprising for example ITO, serving as cathode, or a conducting grid
- a layer having hole blocking properties, preferably comprising a metal oxide like $TiO_x$ or $ZnO_x$, or comprising an organic compound such as polymer like poly(ethyleneimine) or crosslinked nitrogen containing compound derivatives or phenanthroline derivatives,
- a photoactive layer comprising a semiconducting mixture as described above and below, situated between the electrodes, which can exist for example as a p-type/n-type bilayer or as distinct p-type and n-type layers, or as blend or p-type and n-type semiconductor, forming a BHJ,
- an optional conducting polymer layer or hole transport layer, preferably comprising an metal oxide, organic polymer or polymer blend, for example of PEDOT:PSS, $MoO_x$, $VO_x$, $NiO_x$, $WO_x$ or substituted triaryl amine derivatives, for example, TBD or NBD,
- an electrode comprising a high work function metal like for example silver, serving as anode, wherein at least one of the electrodes, preferably the cathode, is at least partially transparent to visible light.

In the OPV devices of the present invention the p-type and n-type semiconductor materials are preferably selected from the materials, like the polymer/polyfullerene/fullerene systems, as described above

When the photoactive layer is deposited on the substrate, it forms a BHJ that phase separates at nanoscale level. For discussion on nanoscale phase separation see Dennler et al, Proceedings of the IEEE, 2005, 93 (8), 1429 or Hoppe et al, Adv. Func. Mater, 2004, 14(10), 1005. An optional annealing step may be then necessary to optimize blend morpohology and consequently OPV device performance.

Another method to optimize device performance is to prepare formulations for the fabrication of OPV(BHJ) devices that may include additives with variable boiling points to promote phase separation in the right way. 1,8-Octanedithiol, 1,8-diiodooctane, nitrobenzene, 1-chloronaphthalene, N,N-dimethylformamide, dimethylacetamide, dimethylsulfoxide, phenyl ether and other additives have been used to obtain high-efficiency solar cells. Examples are disclosed in J. Peet, et al, Nat. Mater., 2007, 6, 497 or Fréchet et a/. J. Am. Chem. Soc., 2010, 132, 7595-7597.

Another preferred embodiment of the present invention relates to the use of a polyfullerene or a mixture according

to the present invention as dye, hole transport layer, hole blocking layer, electron transport layer and/or electron blocking layer in a DSSC or a perovskite-based solar cells, and to a DSSC or perovskite-based solar cells comprising a compound composition or polymer blend according to the present invention.

DSSCs and perovskite-based solar cells can be manufactured as described in the literature, for example in Chem. Rev. 2010, 110, 6595-6663, Angew. Chem. Int. Ed. 2014, 53, 2-15 or in WO2013171520A1.

Unless the context clearly indicates otherwise, as used herein plural forms of the terms herein are to be construed as including the singular form and vice versa.

Throughout the description and claims of this specification, the words "comprise" and "contain" and variations of the words, for example "comprising" and "comprises", mean "including but not limited to", and are not intended to (and do not) exclude other components.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

Above and below, unless stated otherwise percentages are percent by weight and temperatures are given in °C. The values of the dielectric constant ε ("permittivity") refer to values taken at 20°C and 1,000 Hz.

The invention will now be described in more detail by reference to the following examples, which are illustrative only and do not limit the scope of the invention.

Examples

A) Comonomer synthesis

Example 1 - 1,4-bis(octyloxy)benzene

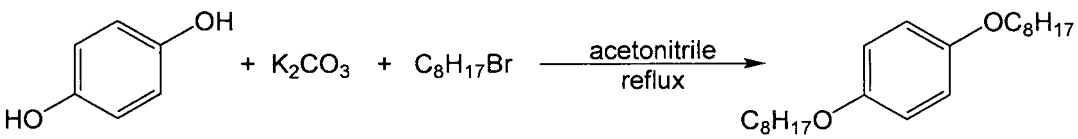


A dry 1000 cm$^3$ three neck round bottom flask is charged with 1,4-hydroquinone (10.0 g; 90.7 mmol; 1.000 eq.), 1-bromooctane (47 cm$^3$; 272 mmol; 3.000 eq.), and potassium carbonate (37.70 g; 273 mmol; 3.011 eq.). The vessel is evacuated and nitrogen purged three times and nitrogen purged acetonitrile (180 cm$^3$) is added before the reaction mixture is degassed further for 15 minutes. The reaction mixture is heated to reflux and stirred at this temperature for two days. After completion of the reaction, the reaction mixture is allowed to cool to 25 °C and precipitated into stirred water (1000 cm$^3$). The precipitates are collected by filtration, dried under air, and dissolved in the minimum of hot n-hexane. The solution is dropped into cold (0 °C) methanol (100 cm$^3$) and the process of reprecipitation repeated in the same manner. The precipitates are recovered by filtration and dried under vacuum (25 g, 70%).

$^1$H NMR (400.6 MHz, $CDCl_3$) δ = 0.89 (t, 6H $-OCH_2(CH_2)_6CH_3$), 1.29-1.75 (m, 24H, $-OCH_2(CH_2)_6CH_3$), 3.90 (t, 4H, $-OCH_2(CH_2)_6CH_3$), 6.82 (s, 4H, aromatics) ppm.

$^{13}$C NMR (100.16 MHz, $CDCl_3$): δ =14.56 (s, $O-CH_2(CH_2)_6CH_3$), 23.13 (s, $O-CH_2(CH_2)_5CH_2CH_3$), 26.54 (s, $O-CH_2CH_2CH_2(CH_2)_4CH_3$), 29.72-29.86 (s, $O-CH_2CH_2CH_2(CH_2)_2CH_2CH_2CH_3$), 32.29 (s, $O-CH_2(CH_2)_4CH_2CH_2CH_3$), 69.13 (s, $O-CH_2(CH_2)_6CH_3$), 115.86 (s, aromatic), 153.67 (s, aromatic-$OC_8H_{17}$) ppm.

Example 2 - 2.5-bis(bromomethyl)-1,4-bis(octyloxy)benzene

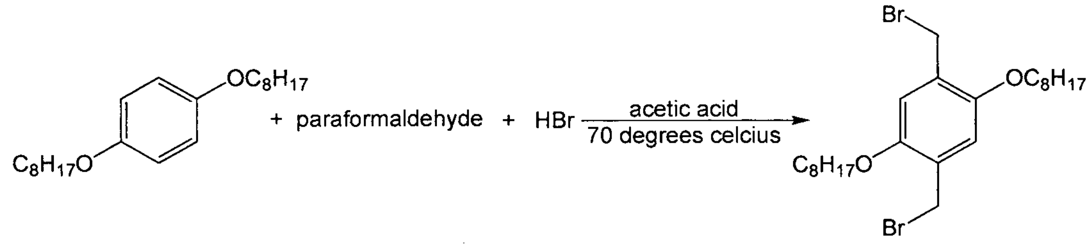


A dry 250 $cm^3$ three neck round bottom flask is charged with 1,4-bis(octyloxy)benzene (7.48 g; 22.3 mmol; 1.000 eq.), paraformaldehyde (1.376 g; 45.8 mmol; 2.054 eq.), and acetic acid (150 $cm^3$). To this suspension hydrobromic acid (10 $cm^3$, 31 wt. % in acetic acid) is added. The reaction mixture is heated to 70 °C and stirred at this temperature for two hours. The reaction mixture is allowed to cool to 25 °C and precipitated into stirred water (300 $cm^3$). The precipitates are collected by filtration, dried under air, and dissolved in the minimum of hot-chloroform. The solution is dropped into cold (0 °C) methanol (100 $cm^3$) and the process of reprecipitation repeated in the same manner. The precipitates are recovered by filtration and dried under vacuum (8.51 g, 73%).

$^1H$ NMR, (400.6 MHz, $CDCl_3$) $\delta$ = 0.89 (t, 6H, $-OCH_2(CH_2)_6CH_3$), 1.28-1.83 (m, 24H, $-OCH_2(CH_2)_6CH_3$), 3.98 (t, 4H, $-OCH_2(CH_2)_6CH_3$), 4.53 (s, 4H, $-CH_2Br$), 6.85 (s, 2H, aromatic) ppm.

$^{13}C$ NMR, below, (100.16 MHz, $CDCl_3$) $\delta$ = 14.14 (s, $O-CH_2(CH_2)_6CH_3$), 22.69 (s, $O-CH_2(CH_2)_5CH_2CH_3$), 26.11 (s, $O-CH_2CH_2CH_2(CH_2)_4CH_3$), 28.77 (s, $-CH_2-Br$), 29.27 - 29.35 (m, O-CH2CH2CH2(CH2)2CH2CH2CH3), 31.84 (s, $O-CH_2(CH_2)_4CH_2CH_2CH_3$), 69.05 (s, $O-CH_2(CH_2)_6CH_3$), 114.69 (s, aromatic), 127.55 (s, *aromatic*-$CH_2Br$), 150.70 (s, *aromatic*-$OC_8H_{17}$) ppm.

Example 3 - 2,5-bis(octyloxy)terephthaldehyde

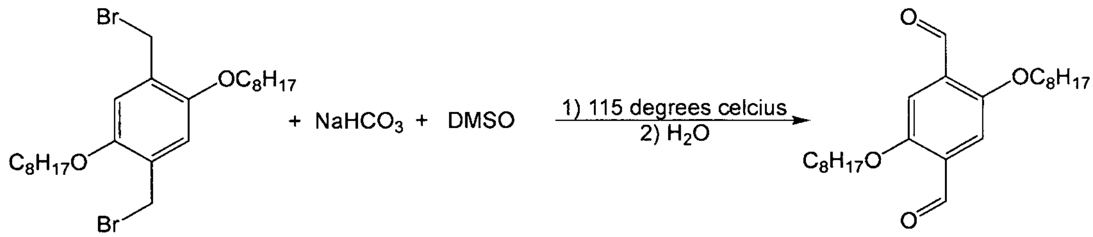


A dry 250 $cm^3$ round bottom flask is charged with 2,5-bis(bromomethyl)-1,4-bis(octyloxy)benzene (2.0 g; 3.8 mmol; 1.000 eq.) and sodium hydrogen carbonate (7.56 g; 90 mmol; 23.68 eq.).The vessel is evacuated and nitrogen purged three times and nitrogen purged dimethyl sulfoxide (100 $cm^3$) is added before the reaction mixture is degassed further for 15 minutes. The reaction mixture is heated to 115 °C and stirred at this temperature for 30 minutes. The reaction mixture is allowed to cool to 25 °C and precipitated into stirred water (2000 $cm^3$). The precipitates are collected by filtration, dried under air. The crude aldehyde is purified by silica gel column chromatography using petroleum ether/chloroform (1/2, V/V) as the eluent. The products are recovered and dried under vacuum (0.7 g, 47%).

$^1H$ NMR (400.6 MHz, $CDCl_3$) $\delta$ = 0.89 (t, 6H, $-OCH_2(CH_2)_6CH_3$), 1.29-1.83 (m, 24H, $-OCH_2(CH_2)_6CH_3$), 4.08 (t, 4H, $-OCH_2(CH_2)_6CH_3$), 7.43 (s, 2H, *aromatic),* 10.52 (s, 2H, *aldehyde).*

$^{13}C$ NMR (100.16 MHz, $CDCl_3$) $\delta$ = 14.24 (s, $O-CH_2(CH_2)_6CH_3$), 22.88 (s, $O-CH_2(CH_2)_5CH_2CH_3$), 26.32 (s, $O-CH_2CH_2CH_2(CH_2)_4CH_3$), 29.20-29.51 (m, $O-CH_2CH_2CH_2(CH_2)_2CH_2CH_2CH_3$), 31.75 (s, $O-CH_2(CH_2)_4CH_2CH_2CH_3$), 69.39 (s, $O-CH_2(CH_2)_6CH_3$), 111.85 (s, *aromatic),* 129.41 (s, *aromatic*-CHO), 155.24 (s, *aromatic*-$OC_8H_{17}$), 189.37 (s, *C*=O) ppm.

Example 4 - 1,4-bis(dodecyloxy)benzene

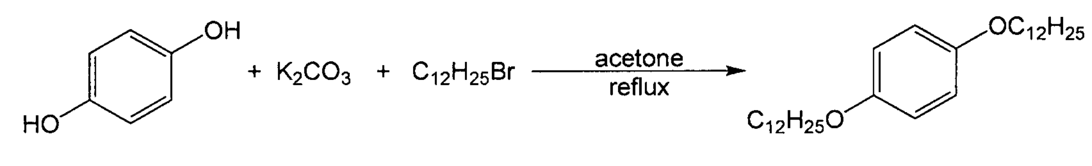


A 250 $cm^3$ three neck round bottom flask is charged with 1,4-hydroquinone (3.0 g; 27.2 mmol; 1.000 eq.), 1-dodecylbromide (17 g; 68.1 mmol; 2.5037 eq.), and potassium carbonate (11.4 g; 82.5 mmol; 3.033 eq) in acetone (100 $cm^3$). The reaction mixture is heated to reflux and stirred at this temperature for two days. After completion of the reaction, the reaction mixture is allowed to cool to 25 °C and precipitated into stirred water. The precipitates are collected by filtration, dried under air, and dissolved in the minimum of hot *n*-chloroform. The solution is dropped into cold (0 °C) methanol (100 $cm^3$) and the process of reprecipitation repeated in the same manner. The precipitates are recovered by filtration and dried under vacuum (7.29 g, 60%).

$^1$H NMR, (400.6 MHz, $CDCl_3$) $\delta$ = 0.88 (t, 6H, $-OCH_2(CH_2)_{10}CH_3$), 1.01-1.52 (m, 36H, $-OCH_2CH_2(CH_2)_9CH_3$), 1.70-1.80 (m, 4H,$-OCH_2CH_2(CH_2)_9CH_3$), 3.90 (t, 4H, $-OCH_2(CH_2)_{10}CH_3$), 6.82 (s, 4H, aromatic).

$^{13}$C NMR (100.16 MHz, $CDCl_3$) $\delta$ = 14.27 (s, $O-CH_2(CH_2)_{10}CH_3$), 22.84 (s, $O-CH_2(CH_2)_9CH_2CH_3$), 26.22 (s, $O-CH_2CH_2CH_2(CH_2)_8CH_3$), 29.36-29.96 (m, $O-CH_2CH_2CH_2(CH_2)_6CH_2CH_2CH_3$), 32.07 (s, $O-CH_2(CH_2)_8CH_2CH_2CH_3$), 68.82 (s, $O-CH_2(CH_2)_{10}CH_3$), 115.54 (s, *aromatic),* 153.35 (s, *aromatic*-$OC_{12}H_{25}$) ppm.

Example 5 - 1,4-bis(bromomethyl)-2,5-bis(dodecyloxy)benzene

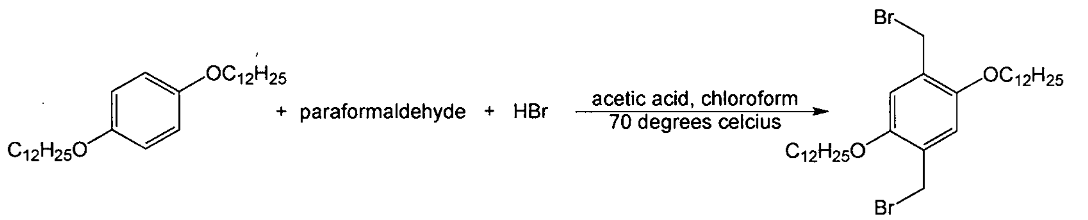


A dry 250 $cm^3$ three neck round bottom flask is charged with 1,4-bis(dodecyloxy)benzene (5 g; 11.2 mmol; 1.000 eq.), paraformaldehyde (2 g; 67.2 mmol; 6.0 eq.), acetic acid (30 $cm^3$) and chloroform (70 $cm^3$). To this suspension hydrobromic acid (8 $cm^3$, 31 wt. % in acetic acid) is added. The reaction mixture is heated to 70 °C and stirred at this temperature for two days. The reaction mixture is allowed to cool to 25 °C and precipitated into stirred water. The precipitates are collected by filtration, dried under air, and dissolved in the minimum of hot-chloroform. The solution is dropped into cold (0 °C) methanol (100 $cm^3$) and the process of reprecipitation repeated in the same manner. The precipitates are recovered by filtration and dried under vacuum (5.31 g, 75%).

$^1$H NMR (400.6 MHz, $CDCl_3$) $\delta$ = 0.88 (t, 6H, $-OCH_2(CH_2)_{10}CH_3$), 1.21-1.41 (m, 32H, $-OCH_2CH_2(CH_2)_9CH_3$), 1.76-1.85 (m, 8H,$-OCH_2CH_2(CH_2)_9CH_3$), 3.98 (t, 4H, $-OCH_2(CH_2)_{10}CH_3$), 4.52 (s, 4H,$-CH_2Br$), 6.85 (s, 2H, *aromatic).*

$^{13}$C NMR (100.16 MHz, $CDCl_3$) $\delta$ = 14.27 (s, $O-CH_2(CH_2)_{10}CH_3$), 22.85 (s, $O-CH_2(CH_2)_9CH_2CH_3$), 26.23 (s, $O-CH_2CH_2CH_2(CH_2)aCH_3$), 29.50 (d, J = 2.1 Hz, *aromatic-* $CH_2Br$), 29.65 - 29.93 (m, $O-CH_2CH_2CH_2(CH_2)_6CH_2CH_2CH_3$), 32.08 (s, $O-CH_2(CH_2)_8CH_2CH_2CH_3$), 69.18 (s, $O-CH_2(CH_2)_{10}CH_3$), 114.81 (s, *aromatic),* 127.68 (s, *aromatic*-CH2Br), 150.82 (s, *aromatic*-$OC_{12}H_{25}$) ppm.

Example 6 - 2,5-bis(dodecyloxy)terephthaldehyde

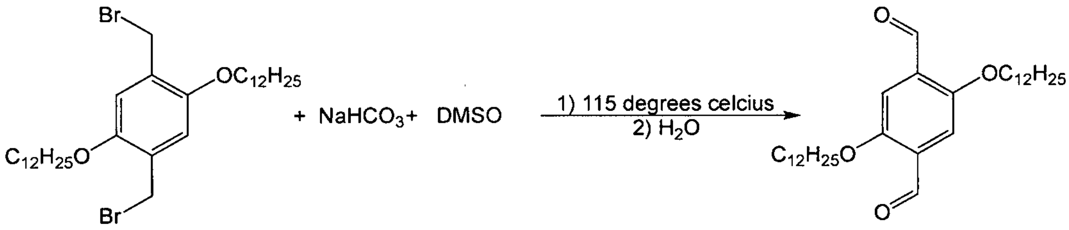


A dry 100 $cm^3$ round bottom flask is charged with 2,5-bis(bromomethyl)-1,4-bis(dodecyloxy)benzene (1.2 g; 1.89 mmol; 1.000 eq.), sodium hydrogen carbonate (2.39 g; 28.5 mmol; 15.08 eq.).The vessel is evacuated and nitrogen purged three times and nitrogen purged dimethyl sulfoxide (50 $cm^3$) is added before the reaction mixture is degassed further for 15 minutes. The reaction mixture is heated to 115 °C and stirred at this temperature for two hours. The reaction mixture is allowed to cool to 25 °C and precipitated into stirred water (500 $cm^3$). The precipitates are collected by filtration, dried under air. The crude aldehyde is purified by silica gel column chromatography using petroleum ether/chloroform (1/2, V/V) as the eluent. The products are recovered and dried under vacuum (0.2 g, 21%).

$^1$H NMR (400.6 MHz, $CDCl_3$) δ = 0.88 (t, 6H, $-OCH_2(CH_2)_{10}C\mathit{H}_3$), 1.26 -1.83 (m, 40H, $-OCH_2(C\mathit{H}_2)$io$CH_3$), 4.8 (t, 4H, $-OC\mathit{H}_2(CH_2)_{10}CH_3$), 7.43 (s, 2H, aromatic), 10.52 (s, 2H, *aldehyde)* ppm.

$^{13}$C NMR (100.16 MHz, $CDCl_3$) δ 14.27 (s, $O-CH_2(CH_2)_{10}CH_3$), 22.84 (s, $O-CH_2(CH_2)_9CH_2CH_3$), 26.17 (s, $O-CH_2CH_2CH_2(CH_2)_8CH_3$), 29.21-29.80 (m, $O-CH_2CH_2CH_2(CH_2)_6CH_2CH_2CH_3$), 32.07 (s, $O-CH_2(CH_2)_8CH_2CH_2CH_3$), 69.41 (s, $O-CH_2(CH_2)_{10}CH_3$), 111.78 (s, *aromatic),* 129.44 (s, *aromatic-CHO),* 155.39 (s, *aromatic*-$OC_{12}H_{25}$), 189.60 (s, C=O) ppm.

B) Polymer synthesis

Example 7 - Polyfullerene PPC1 (Reference Example)

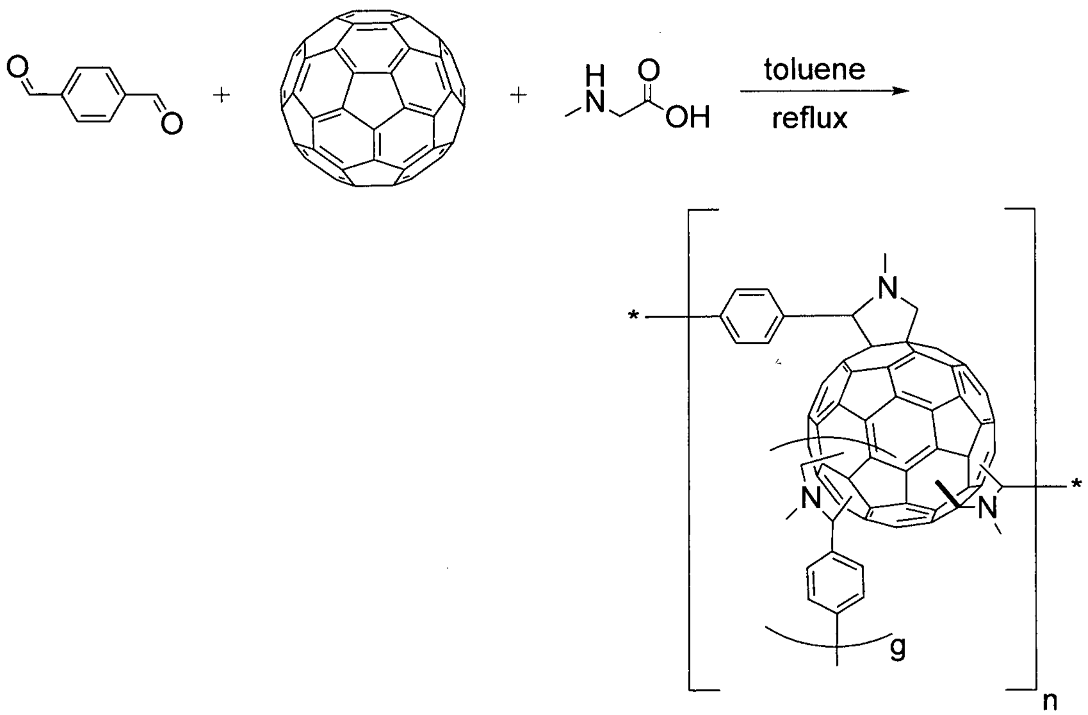


A dry 1000 $cm^3$ three neck round bottom flask is charged with $C_{60}$ (500.0 mg; 0.6938 mmol; 1.000 eq.), terephthalaldehyde (93.0 mg; 0.6938 mmol; 1.000 eq.), and *N*-methylglycine (123.6 mg; 1.3876 mmol; 2.000 eq.). The vessel is evacuated and nitrogen purged three times and distilled toluene (555 $cm^3$) is added before the reaction mixture

is degassed further for 15 minutes. The reaction mixture is heated at reflux for 18 hours. After completion of the reaction, the reaction mixture is allowed to cool to 25 °C and precipitated into stirred methanol (2000 $cm^3$). The polymer is collected by filtration, washed with methanol (2 x 50 $cm^3$) and dried under vacuum to give a solid. The polymer is then washed by Soxhlet extraction with *n*-hexane and then with methanol to remove unreacted materials. The brown solid is recovered from the Soxhlet filter and dried under vacuum (236 mg, 37.5%). The polymer is sparingly soluble in chlorobenzene, and only just soluble in tetrahydrofuran when transferred carefully to this solvent from a prior solution in chlorobenzene. GPC (30 °C, tetrahydrofuran) $M_n$ = 0.18 kg $mol^{-1}$, $M_w$= 0.82 kg $mol^{-1}$, Đ = 4.4. GPC (50 °C, chlorobenzene) $M_n$ = 30.7 kg $mol^{-1}$, $M_w$= 62.8 kg $mol^{-1}$, Đ = 2.0.

It is found that extensive washing for periods of more than several days, followed by extensive drying under vacuum do not remove the numerous impurities in the material, namely the starting materials and *n*-hexane.

$^1$H NMR (400.6 MHz, $C_6D_6$) $\delta$ = 2.36 (s, 3H, -N-$CH_3$), 4.08 (dd, *J* = 272 Hz, *J* = 8 Hz, 2H, -C*H*$_2$-N-), 4.59 (s, $^1$H, -CH-N-), 7.32 (s, 2H,-*aromatic*- C- pyrrolidine), 7.58 (d, -aromatic-CHO), 9.58 (s, 1H, C=O).

$^{13}$C NMR (400 MHz, $C_6D_6$) $\delta$ = 39.50 (s, -N-$CH_3$), 69.78 (s, -$CH_2$-N-), 83.09 (s, -CH-N-), 129.75-130.02 (m, aromatics), 143.30 (*unbound $C_{60}$*), 190.76 (s, C=O) ppm. 2D-HMQC NMR 2.36, 39.50 (-N-$CH_3$); 3.74 and 4.42, 69.78 (-$CH_2$-N-); 4.59, 83.09 (-CH-N-); 143.30 ($C_{60}$ impurity, no correlation with proton); 9.58, 190.76 (CH=O) ppm.

<u>Example 8 - Polyfullerene PPC2 (Reference example)</u>

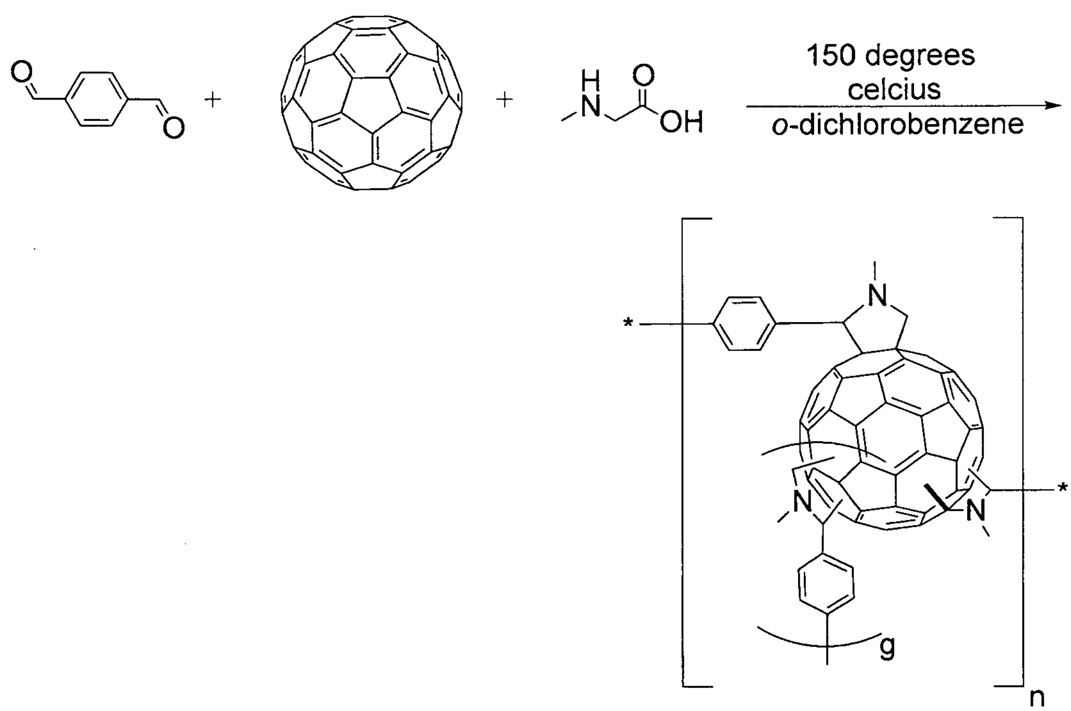


A dry 50 $cm^3$ three neck round bottom flask is charged with $C_{60}$ (500.0 mg; 0.6938 mmol; 1.000 eq.), terephthalaldehyde (93.0 mg; 0.6938 mmol; 1.000 eq.), and *N*-methylglycine (123.6 mg; 1.3876 mmol; 2.000 eq.). The vessel is evacuated and nitrogen purged three times and nitrogen purged o-dichlorobenzene (25 $cm^3$) is added before the reaction mixture is degassed further for 15 minutes. The reaction mixture is heated up to 150 °C and stirred at this temperature for 18 hours. After completion of the reaction, the reaction mixture is allowed to cool to 25 °C and precipitated into stirred methanol (250 $cm^3$). The polymer is collected by filtration and washed with methanol (2 x 50 $cm^3$) and dried under vacuum to give a solid. The polymer is then washed by Soxhlet extraction with n-hexane and then with methanol to remove unreacted materials. The brown solid is recovered from the Soxhlet filter and dried under vacuum (195 mg, 30%). GPC (30 °C, tetrahydrofuran) $M_n$ = 0.19 kg $mol^{-1}$, $M_w$= 1.85 kg $mol^{-1}$, Đ = 9.8.

Example 9 - Polyfullerene PPC3

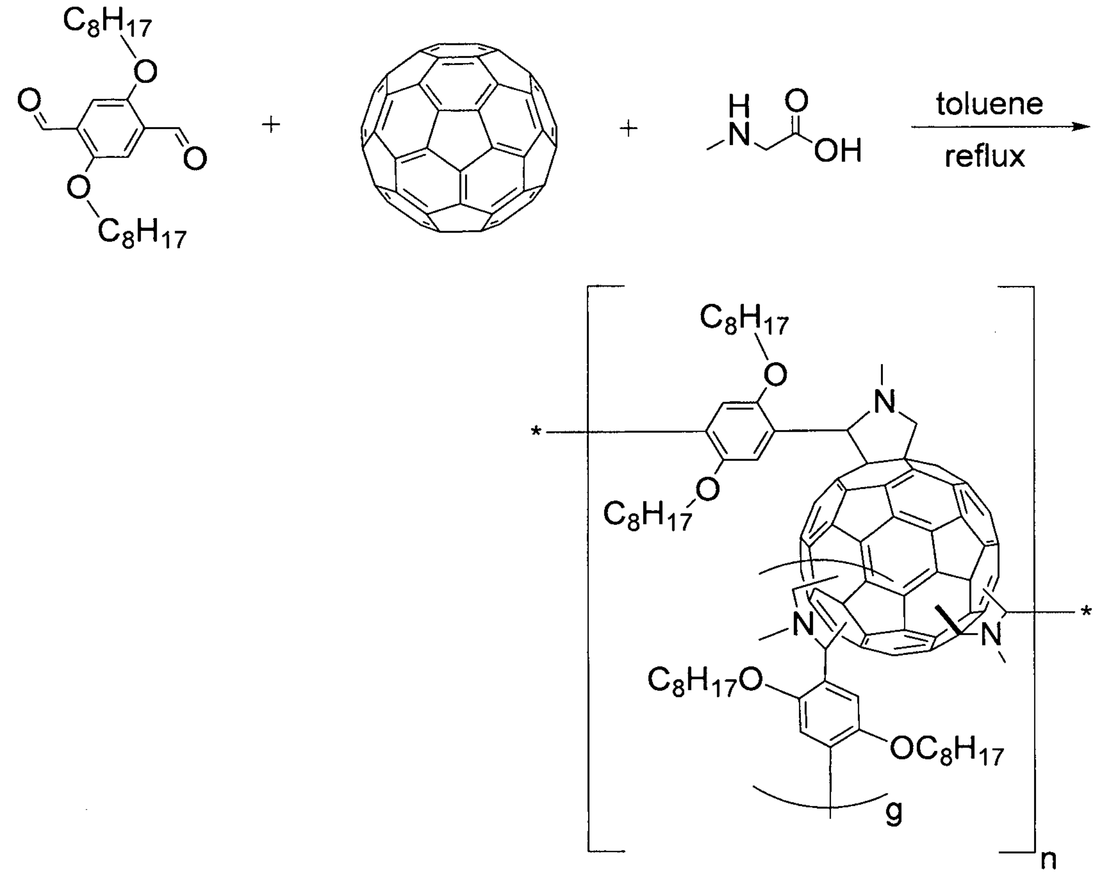


A dry 1000 $cm^3$ three neck round bottom flask is charged with $C_{60}$ (500.0 mg; 0.6938 mmol; 1.000 eq.), 2,5-dioctyloxyterephthalaldehyde (271.0 mg; 0.6938 mmol; 1.000 eq.), and *N*-methylglycine (123.6 mg; 1.3876 mmol; 2.000 eq.). The vessel is evacuated and nitrogen purged three times and distilled toluene (555 $cm^3$) is added before the reaction mixture is degassed further for 15 minutes. The reaction mixture is heated at reflux for 18 hours. After completion of the reaction, the reaction mixture is allowed to cool to 25 °C and precipitated into stirred methanol (2000 $cm^3$). The polymer is collected by filtration and washed with methanol (2 x 50 $cm^3$) and dried under vacuum to give a solid. The polymer is then washed by Soxhlet extraction with *n*-hexane and then with methanol to remove unreacted materials. The brown powder is recovered from the Soxhlet filter and dried under vacuum (328 mg, 40.6%). It is soluble in chlorobenzene, toluene, and will not precipitate when solutions are placed in tetrahydrofuran. GPC (30 °C, tetrahydrofuran) $M_n$ = 3.1 kg $mol^{-1}$, $M_w$= 3.4 kg $mol^{-1}$, Đ = 1.1. GPC (50 °C, chlorobenzene) $M_n$ = 0.5 kg $mol^{-1}$, $M_w$ = 0.5 kg $mol^{-1}$, Đ = 1.1.

$^1H$ NMR (400.6 MHz, 1,4-DCB-d4, 85 °C) δ (ppm): 0.84 (broad,-$OCH_2(CH_2)_6CH_3$), 1.27-1.75 (m, -$OCH_2(CH_2)_6CH_3$), 2.77 (N-$CH_3$), 3.74-4.81 (m, -$OCH_2(CH_2)_6CH_3$), -$CH_2$-N-), 5.65 (s, -CH-N-), 7.42 - 7.86 (s, *aromatics)* ppm.
$^{13}C$ NMR (100.16 MHz, 1,4-DCB-*d4*, 85 °C), δ: 13.42 (s, $OCH_2(CH_2)_6CH_3$), 22.24 (s, $OCH_2(CH_2)_5CH_2CH_3$), 25.73 (s, $OCH_2CH_2CH_2(CH_2)_4CH_3$), 28.91 (s, $OCH_2CH_2CH_2(CH_2)_4CH_3$), 31.43 (s, $OCH_2(CH_2)_4CH_2CH_2CH_3$), 39.25 (s, -N-$CH_3$), 68.54, 68.97, 69.62 (s,-$OCH_2(CH_2)_6CH_3$ and -$CH_2$-N-), 75.47, 76.12 (s, -CH-N-), 109.97, 115.64 (s, *aromatic),* 125.66 - 155.79 (m, *aromatic, $C_{60}$, aromatic*-$OC_8H_{17}$), 187.24 (C=O) ppm.
2D-HMQC NMR (1,4-DCB-*d4*, 85 °C), d = δ = 0.84, 13.42 (-$OCH_2(CH_2)_6CH_3$); 1.27-1.75, 22.24-31.43 (-$OCH_2(CH_2)_6CH_3$); 2.77, 39.25 (-N-$CH_3$), 3.74-4.81, 68.54-69.62 (-$OCH_2(CH_2)_6CH_3$), -$CH_2$-N-); 5.65 , 75.47-76.12 (-CH-N-), 7.42 - 7.86, 109.97 - 115.64 *(aromatics);* 10.55, 187.24 (CHO) ppm.

Example 10 - Polyfullerene PPC4

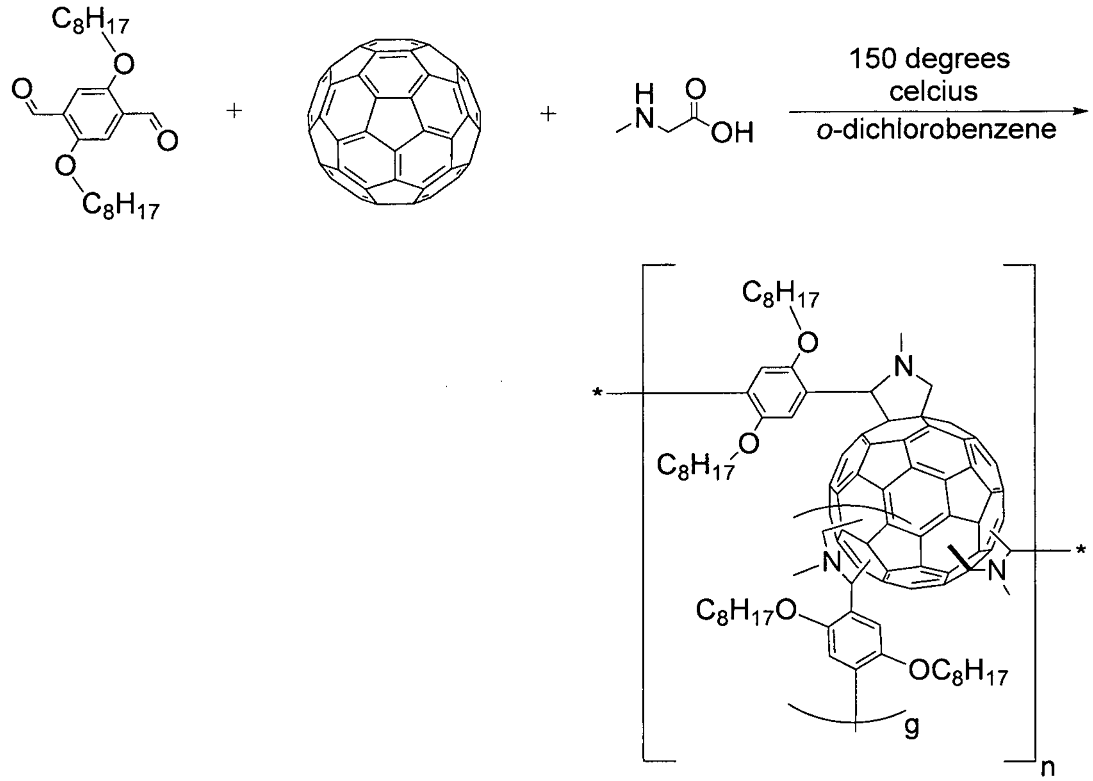


A dry 50 $cm^3$ three neck round bottom flask is charged with $C_{60}$ (500.0 mg; 0.6938 mmol; 1.000 eq.), 2,5-dioctyloxyterephthalaldehyde (271.0 mg; 0.6938 mmol; 1.000 eq.), and *N*-methylglycine (123.6 mg; 1.3876 mmol; 2.000 eq.). The vessel is evacuated and nitrogen purged three times and nitrogen purged o-dichlorobenzene (25 $cm^3$) is added before the reaction mixture is degassed further for 15 minutes. The reaction mixture is heated up to 150 °C and stirred at this temperature for 18 hours. After completion of the reaction, the reaction mixture is allowed to cool to 25 °C and precipitated into stirred methanol (250 $cm^3$). The polymer is collected by filtration and washed with methanol (2 x 50 $cm^3$) and dried under vacuum to give a solid. The polymer is then washed by Soxhlet extraction with *n*-hexane and then with methanol to remove unreacted materials. The black solid is recovered from the Soxhlet filter and dried under vacuum (463 mg, 57.5%). It is soluble in chlorobenzene, toluene, and will not precipitate when solutions are placed in tetrahydrofuran. GPC (30 °C, tetrahydrofuran) $M_n$ = 2.1 kg $mol^{-1}$, $M_w$ = 4.6 kg $mol^{-1}$, Đ = 2.2. GPC (50 °C, chlorobenzene) $M_n$ = 5.8 kg $mol^{-1}$, $M_w$ = 20.1 kg $mol^{-1}$, Đ = 3.5.

$^1H$ NMR (400.6 MHz, 1,4-DCB-*d4*, 85 °C) $\delta$ = 0.85 (broad,-$OCH_2(CH_2)_6CH_3$), 1.26 (broad, -$OCH_2(CH_2)_6CH_3$), 2.11-2.81 (broad, -N-$CH_3$), 3.72-4.81 (m, broad, -$OCH_2(CH_2)_6CH_3$), -$CH_2$-N-), 5.67 (broad,-CH-N-), 7.53 - 7.81 (m, broad, *aromatics)* ppm.

$^{13}C$ NMR (100.16 MHz, 1,4-DCB-*d4*, 85 °C) $\delta$ = 13.57 (s, $OCH_2(CH_2)_6CH_3$), 22.28 (s, $OCH_2(CH_2)_5CH_2CH_3$), 25.85 (s, $OCH_2CH_2CH_2(CH_2)_4CH_3$), 29.05 (s, $OCH_2CH_2CH_2(CH_2)_4CH_3$), 31.50 (s, $OCH_2(CH_2)_4CH_2CH_2CH_3$), 39.28 (s, -N-$CH_3$), 69.08 (broad,-$OCH_2(CH_2)_6CH_3$ and -$CH_2$-N-), 75.38 (broad, -CH-N-), 114.47 (broad, *aromatic),* 141.16 - 145.52 (m, *aromatic, $C_{60}$*), 152.43 (broad, *aromatic*-$OC_8H_{17}$) ppm.

2D-HMQC NMR (1,4-DCB-*d4*, 85 °C), d = $\delta$ = 0.85, 13.57 (-$OCH_2(CH_2)_6CH_3$); 1.26, 22.28, - 31.50 (-$OCH_2(CH_2)_6CH_3$); 2.81, 39.28 (-N-$CH_3$), 3.72-4.81, 69.08 (-$OCH_2(CH_2)_6CH_3$), -$CH_2$-N-); 5.67, 75.38 (-CH-N-), 7.53 - 7.81, 114.47 *(aromatics)* ppm.

Example 11 - Polyfullerene PPC5

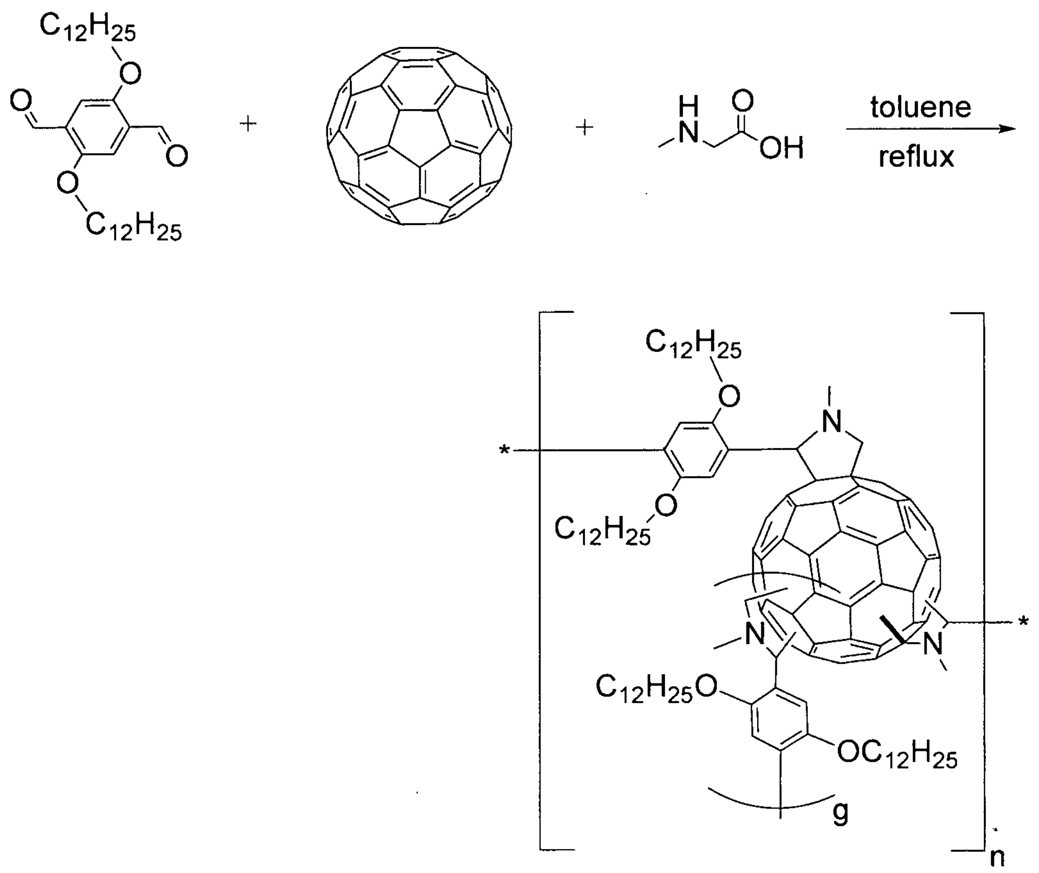


A dry 1000 $cm^3$ three neck round bottom flask is charged with $C_{60}$ (500.0 mg; 0.6938 mmol; 1.000 eq.), 2,5-dodecyloxyterephthalaldehyde (348.6 mg; 0.6938 mmol; 1.000 eq.), and *N*-methylglycine (123.6 mg; 1.3876 mmol; 2.000 eq.). The vessel is evacuated and nitrogen purged three times and distilled toluene (555 $cm^3$) is added before the reaction mixture is degassed further for 15 minutes. The reaction mixture is heated at reflux and stirred for 18 hours. After completion of the reaction, the reaction mixture is allowed to cool to 25 °C and precipitated into stirred methanol (2000 $cm^3$). The polymer is collected by filtration and washed with methanol (2 x 50 $cm^3$) and dried under vacuum to give a solid. The polymer is then washed by Soxhlet extraction with n-hexane and then with methanol to remove unreacted materials. The black solid is recovered from the Soxhlet filter and dried under vacuum (380 mg, 42.3%). It is soluble in chlorobenzene, toluene, and will not precipitate when solutions are placed in tetrahydrofuran. GPC (30 °C, tetrahydrofuran) $M_n$ = 2.8 kg $mol^{-1}$, $M_w$ = 4.6 kg $mol^{-1}$, Đ = 1.7.

$^1$H NMR (400.6 MHz, 1,4-DCB-*d4*, 85 °C) $\delta$ = 0.86 (broad,-$OCH_2(CH_2)_{10}CH_3$), 1.25-2.12 (broad, -$OCH_2(CH_2)_{10}CH_3$), 2.66-2.82 (broad, -N-$CH_3$), 3.39-4.80 (m, broad, -$OCH_2(CH_2)_{10}CH_3$), -$CH_2$-N-), 5.68 (broad, -*CH*-N-), 7.50- 7.82 (broad, *aromatics).*

$^{13}$C NMR (100.16 MHz, 1,4-DCB-*d4*, 85 °C) $\delta$ = 13.51 (s, O-$CH_2(CH_2)_{10}CH_3$), 22.25 (s, O-$CH_2(CH_2)_9CH_2CH_3$), 25.90 (s, O-$CH_2CH_2CH_2(CH_2)_8CH_3$), 28.97 - 29.34 (m, O-$CH_2CH_2CH_2(CH_2)_6CH_2CH_2CH_3$), 31.52 (s, O-$CH_2(CH_2)_8CH_2CH_2CH_3$), 39.26 (s, -$CH_3$-N-), 69.08 (broad, O-$CH_2(CH_2)_{10}CH_3$), 75.37 (broad, -CH-N-), 114.56 (broad, *aromatic),* 135.83-147.62 (m, *aromatic,* $C_{60}$), 152.51 (broad, *aromatic*-$OC_{12}H_{25}$) ppm.

2D-HMQC NMR (1,4-DCB-*d4*, 85 °C), d = $\delta$ = 0.86, 13.51 (-$OCH_2(CH_2)_{10}CH_3$); 1.25-2.12, 22.25-31.52 (-$OCH_2(CH_2)_{10}CH_3$); 2.82, 39.26 (-N-$CH_3$), 3.39-4.80, 69.08 (-$OCH_2(CH_2)_{10}CH_3$), -$CH_2$-N-); 5.68, 75.37 (-*CH*-N-), 7.50-7.82, 114.56 *(aromatics)* ppm.

Example 12 - Polyfullerene PPC6

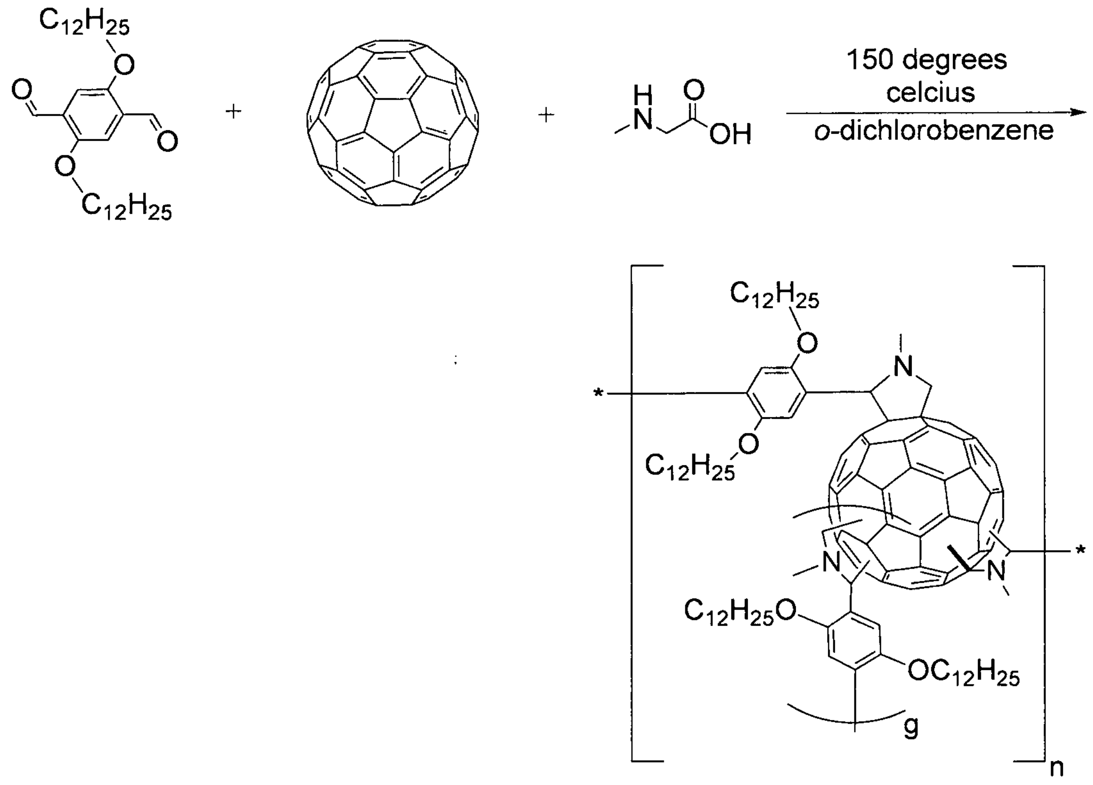


A dry 50 $cm^3$ three neck round bottom flask is charged with $C_{60}$ (500.0 mg; 0.6938 mmol; 1.000 eq.), 2,5-dodecyloxyterephthalaldehyde (348.8 mg; 0.6938 mmol; 1.000 eq.), and *N*-methylglycine (123.6 mg; 1.3876 mmol; 2.000 eq.). The vessel is evacuated and nitrogen purged three times and nitrogen purged o-dichlorobenzene (25 $cm^3$) is added before the reaction mixture is degassed further for 15 minutes. The reaction mixture is heated up to 150 °C and stirred at this temperature for 18 hours. After completion of the reaction, the reaction mixture is allowed to cool to 25 °C and precipitated into stirred methanol (250 $cm^3$). The polymer is collected by filtration and washed with methanol (2 x 50 $cm^3$) and dried under vacuum to give a solid. The polymer is then washed by Soxhlet extraction with *n*-hexane and then with methanol to remove unreacted materials. The black solid is recovered from the Soxhlet filter and dried under vacuum (310 mg, 35%). It is soluble in chlorobenzene, toluene, and will not precipitate when solutions are placed in tetrahydrofuran. GPC (30 °C, tetrahydrofuran) $M_n$ = 5.7 kg $mol^{-1}$, $M_w$= 10.8 kg $mol^{-1}$, Đ = 1.9. GPC (50 °C, chlorobenzene) $M_n$ = 6.7 kg $mol^{-1}$, $M_w$= 19.1 kg $mol^{-1}$, Đ = 2.9.

$^1$H NMR (400.6 MHz, 1,4-DCB-d4, 85 °C) δ = 0.87 (broad,-$OCH_2(CH_2)_{10}CH_3$), 1.26-2.12 (broad, -$OCH_2(CH_2)_{10}CH_3$), 2.64-2.82 (broad, -N-$CH_3$), 3.81 - 4.82 (m, broad, -$OCH_2(CH_2)_{10}CH_3$), -$CH_2$-N-), 5.38 - 5.68 (broad, -CH-N-), 7.51-7.82 (broad, *aromatics).*

$^{13}$C NMR (100.16 MHz, 1,4-DCB-*d4*, 85 °C) δ = 13.52 (s, O-$CH_2(CH_2)_{10}CH_3$), 22.26 (s, O-$CH_2(CH_2)_9CH_2CH_3$), 25.84 (s, O-$CH_2CH_2CH_2(CH_2)_8CH_3$), 28.98 - 29.34 (m, O-$CH_2CH_2CH_2(CH_2)_6CH_2CH_2CH_3$), 31.53 (s, O-$CH_2(CH_2)_8CH_2CH_2CH_3$), 39.28 (s, -$CH_3$-N-), 69.19 (broad, O-$CH_2(CH_2)_{10}CH_3$), 75.35 (broad, -CH-N-), 114.46 (broad, *aromatic),* 135.84 - 148.51 (m, *aromatic,* $C_{60}$), 152.38 (broad, *aromatic*-$OC_{12}H_{25}$) ppm.

2D-HMQC NMR ($CDCl_3$, ambient temperature) d = δ = 0.87, 13.52 (-$OCH_2(CH_2)_{10}CH_3$); 1.26 - 2.12, 22.26 - 31.53 (-$OCH_2(CH_2)_{10}CH_3$); 2.82, 39.28 (-N-$CH_3$), 3.81 - 4.82, 69.19 (-$OCH_2(CH_2)_{10}CH_3$), -$CH_2$-N-); 5.68, 75.35 (-CH-N-), 7.51 - 7.82, 114.46 *(aromatics)* ppm. 2D-HSQC NMR (1,4-DCB-*d4*, 85 °C) = 0.86, 14.34 (-$OCH_2(CH_2)_{10}CH_3$); 1.23, 22.89 - 32.11 (-$OCH_2(CH_2)_{10}CH_3$); 2.67, 40.37 (-N-$CH_3$), 3.90 - 4.96, 69.35 (-$OCH_2(CH_2)_{10}CH_3$), -$CH_2$-N-); 5.20 - 5.56, 75.74 (-CH-N-), 7.45 - 7.75, 114.29 *(aromatics)* ppm.

Example 13 - Polyfullerene PolyPCBM

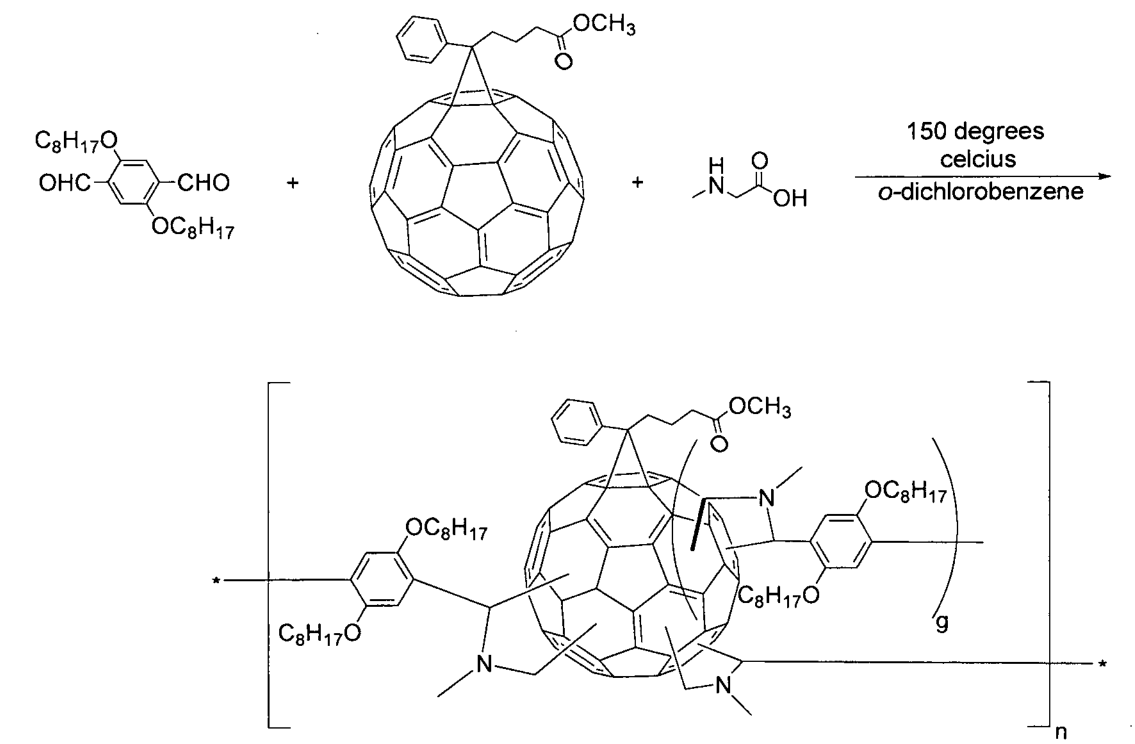


A dry 100 $cm^3$ three neck round bottom flask is charged with phenyl-$C_{61}$-butyric acid methyl ester (PCBM), (500.0 mg; 0.5489 mmol; 1.000 eq.), 2,5-bis(octyloxy)terephthaldehyde (214 mg, 0.5489 mmol, 1.000 eq.), and *N*-methylglycine (97.8 mg, 1.098 mmol, 2.000 eq.) The vessel is evacuated and nitrogen purged three times and o-dichlorobenzene (20 $cm^3$) is added before the reaction mixture is degassed further for 15 minutes. The reaction mixture is stirred and heated at 150 °C for 18 hours. After completion of the reaction, the reaction mixture is allowed to cool to 25 °C and precipitated into stirred methanol (250 $cm^3$). The polymer is collected by filtration and washed with methanol (2 x 50 $cm^3$) and dried under vacuum to give a solid. The polymer is then washed by Soxhlet extraction with acetone and then with methanol to remove unreacted materials. The brown powder is recovered from the Soxhlet filter and dried under vacuum (484 mg mg, 67%). It is soluble in chlorobenzene, toluene, tetrahydrofuran and chloroform. GPC (30 °C, tetrahydrofuran) $M_n$ = 5.9 kg $mol^{-1}$, $M_w$= 18.4 kg $mol^{-1}$, Đ = 3.1.

$^1H$ NMR (400.6 MHz, $CDCl_3$, ambient temperature) δ = 0.75 (broad,-$OCH_2(CH_2)_6C\mathit{H}_3$), 1.3 (broad, -$OCH_2(C\mathit{H}_2)_6CH_3$), 2.0-3.1 (broad, -N-$C\mathit{H}_3$,-C-$(C\mathit{H}_2)_3$-$COOCH_3$), 3.1-3.8 (-C-$(CH_2)_3$-$COOC\mathit{H}_3$), 3.8-4.3 (broad,-$OC\mathit{H}_2(CH_2)_6CH_3$), 4.3 - 6 (broad, -$C\mathit{H}_2$-N-, -C*H*-N-), 6.2 - 8.5 (broad, *aromatics),* 10.25-10.75 (broad, chain-end -CHO) ppm.

$^{13}C$ NMR (100.16 MHz, $CDCl_3$, ambient temperature) δ = 13 (broad, $OCH_2(CH_2)_6CH_3$), 23 (s, OCH2(CH2)5CH2CH3), 26 (s, $OCH_2CH_2CH_2(CH_2)_4CH_3$), 29 (s, $OCH_2CH_2CH_2(CH_2)_4CH_3$), 31 (broad, -C-$(C\mathit{H}_2)_3$-$COOCH_3$), 32 (broad, $OCH_2(CH_2)_4CH_2CH_2CH_3$), 34 (broad, -C-$(C\mathit{H}_2)_3$-$COOCH_3$), 39.28 (s, -N-$C\mathit{H}_3$), 53 (-C-$(CH_2)_3$-$COOC\mathit{H}_3$), 69 (broad,-$O\mathit{C}H_2(CH_2)_6CH_3$ and -$CH_2$-N-), 75 (broad, -*C*H-N-), 114 *(aromatic-C*-$(CH_2)_3$-$COOCH_3$), 128 (broad, *aromatic*-$OCH_2(CH_2)_6CH_3$), *aromatic-C*-$(CH_2)_3$-$COOCH_3$), 132 (broad, *aromatic*-C-$(CH_2)_3$-$COOCH_3$), 135-153 (m, *aromatic, $C_{60}$*), 152.43 (broad, *aromatic*-$OC_8H_{17}$), 174 (broad, chain-end-*C*HO) ppm.

C) Device fabrication

Bulk heteroiunction organic photovoltaic devices (OPVs) for fullerene mixtures

Organic photovoltaic (OPV) devices are fabricated on pre-patterned ITO-glass or ITO-pet substrates (13Ω/sq.). Substrates are cleaned using common solvents (acetone, iso-propanol, deionized-water) in an ultrasonic bath. A layer of commercially available PVE-002 (Merck) is applied as a uniform coating by doctor blade at 80 °C or zinc oxide. The PV-E002 Films are then annealed at 100 °C for 10 minutes in air and then transferred into a Nitrogen atmosphere while the zinc oxide films are . Active material solutions (i.e. polymer + fullerene) are prepared to fully dissolve the solutes at

a solution concentration between 10 and 30 mg.cm$^{-3}$ in o-xylene, 1-methylnaphthalene (1MN) or in any combination of the two solvents. Thin films are blade-coated in a nitrogen atmosphere or in air to achieve active layer thicknesses between 50 and 800 nm as measured using a profilometer. A short drying period follows to ensure removal of any residual solvent.

Typically, blade-coated films are dried at between 60 °C and 70 °C for 2 minutes on a hotplate. Next the devices are transferred into an air atmosphere. On top of the active layer a 50 nm to 500 nm layer of conducting polymer poly(ethylene dioxythiophene) doped with poly(styrene sulfonic acid) [PEDOT:PSS Clevios HTL Solar SCA 246-10 (Heraeus)] was spread and uniformly coated by spin-coating at 1100 rpm for 130 seconds or by doctor blade. Afterwards Ag (100 nm to 200 nm) cathodes are thermally evaporated through a shadow mask to define the cells. For the last step of the device fabrication, the devices are optionally encapsulated with a glass or plastic cover slide using UV-curing epoxy glue. Current-voltage characteristics are measured using a Keithley 2400 SMU while the solar cells are illuminated by a Newport Solar Simulator at 100 mW.cm$^{-2}$ white light. The solar simulator is equipped with AM1.5G filters. The illumination intensity is calibrated using a Si photodiode

Power conversion efficiency is calculated using the following expression

$$\eta = \frac{V_{oc} \times J_{sc} \times FF}{P_{in}}$$

where FF is defined as

$$FF = \frac{V_{\max} \times J_{\max}}{V_{oc} \times J_{sc}}$$

OPV device characteristics for a blend of polymer P1 or P3HT (see below), a polyfullerene (PPC1, PPC3, PCC4 or PPC5) and fullerene (PCBM-C60) coated from a formulation is shown in Table 1, Table 2 and Table 3.

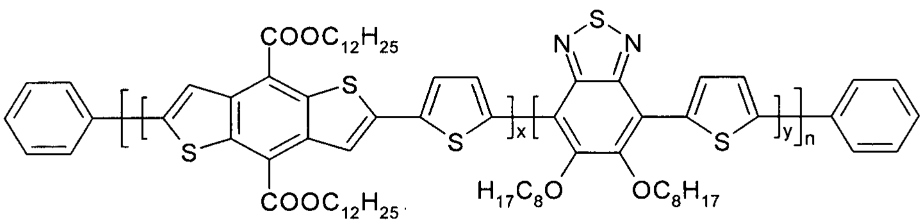

Polymer P1

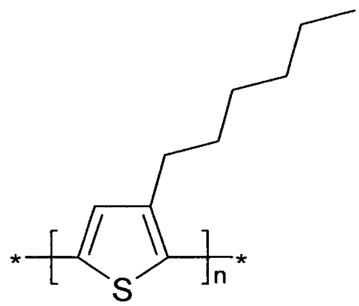

P3HT

Polymer P1 and its preparation are disclosed in WO 2011/131280.

Initial device properties

Example C1 - Comparison Example

A formulation consisting of 12.0 mg·cm$^{-3}$ PCBM-C60 and 15.0 mg·cm$^{-3}$ P3HT is prepared in o-xylene + 5% 1-methylnaphthalene. The formulation is stirred for 16 hours at 80 °C. The formulation is coated by doctor blade onto a zinc oxide layer supported by an ITO coated PET substrate at 65 °C. The device is finalized with a PEDOT:PSS Clevios HTL Solar SCA 388 (Heraeus) layer followed by a 150 nm silver layer. The resulting device performance was measured at 100 mW.cm$^{-2}$ under white light illumination in a solar simulator is equipped with AM1.5G filters. The performance measured as an average of 19 27.0 mm$^2$ devices is listed in Table 1.

Example D1

A formulation consisting of 1.27 mg·cm$^{-3}$ PPC3, 12.0 mg·cm$^{-3}$ PCBM-C60 and 15.0 mg·cm$^{-3}$ P3HT is prepared in o-xylene. The formulation is stirred for 16 hours at 90 °C. The formulation is coated by doctor blade onto a zinc oxide layer supported by an ITO coated PET substrate at 65 °C. The device is finalized with a PEDOT:PSS Clevios HTL Solar SCA 388 (Heraeus) layer followed by a 150 nm silver layer. The resulting device performance was measured at 100 mW.cm$^{-2}$ under white light illumination in a solar simulator is equipped with AM1.5G filters. The performance measured as an average of 19 27.0 mm$^2$ devices is listed in Table 1.

Table 1: Summary of device performance for Examples C1 and D1 before and after heating at 100 °C for 116 hours.

| Example | Polymer | Polyfullerene conc.(mg/cm$^3$) | Voc (mV) | Jsc (mA/cm$^2$) | FF (%) | PCE (%) |
|---|---|---|---|---|---|---|
| C1 (initial) | P3HT | 0 | 553 | 7.51 | 62 | 2.52 |
| D1 (initial) | P3HT | PPC3 1.27 | 548 | 7.55 | 60 | 2.48 |
| C1 (116 hours) | P3HT | 0 | 555 | 4.88 | 56 | 1.52 |
| D1 (116 hours) | P3HT | PPC3 1.27 | 547 | 7.42 | 61 | 2.48 |

**Fig. 1** shows the power conversion efficiency as a function of time the devices of Examples C1 and D1 during continuous heating at 100 °C.

Example C2 - Comparison Example

A formulation consisting of 15.0 mg·cm$^{-3}$ PCBM-C60 and 10.0 mg·cm$^{-3}$ P1 is prepared in o-xylene + 5% 1-methylnaphthalene. The formulation is stirred for 16 hours at 100 °C. The formulation is coated by doctor blade onto a zinc oxide layer supported by an ITO coated glass substrate at 70 °C. The device is finalized with a PEDOT:PSS Clevios HTL Solar SCA 388 (Heraeus) layer followed by a 150 nm silver layer. The resulting device performance was measured at 100 mW·cm$^{-2}$ under white light illumination in a solar simulator is equipped with AM1.5G filters. The performance measured as an average of 10 27.0 mm$^2$ devices is listed in Table 2.

Example D2

A formulation consisting of 0.38 mg·cm$^{-3}$ PPC3, 15.0 mg·cm$^{-3}$ PCBM-C60 and 10.0 mg·cm$^{-3}$ P1 is prepared in *o*-xylene + 5% 1-methylnaphthalene. The formulation is stirred for 16 hours at 100 °C. The formulation is coated by doctor blade onto a zinc oxide layer supported by an ITO coated glass substrate at 70 °C. The device is finalized with a PEDOT:PSS Clevios HTL Solar SCA 388 (Heraeus) layer followed by a 150 nm silver layer. The resulting device performance was measured at 100 mW·cm$^{-2}$ under white light illumination in a solar simulator is equipped with AM1.5G filters. The performance measured as an average of 14 27.0 mm$^2$ devices is listed in Table 2.

Example D3

A formulation consisting of 0.95 mg·cm$^{-3}$ PPC3, 15.0 mg·cm$^{-3}$ PCBM-C60 and 10.0 mg·cm$^{-3}$ P1 is prepared in o-xylene + 5% 1-methylnaphthalene. The formulation is stirred for 16 hours at 100 °C. The formulation is coated by doctor blade onto a zinc oxide layer supported by an ITO coated glass substrate at 70 °C. The device is finalized with a PEDOT:PSS Clevios HTL Solar SCA 388 (Heraeus) layer followed by a 150 nm silver layer. The resulting device performance was measured at 100 mW·cm$^{-2}$ under white light illumination in a solar simulator is equipped with AM1.5G filters. The performance measured as an average of 11 27.0 mm$^2$ devices is listed in Table 2.

Example D4

A formulation consisting of 1.9 mg·cm$^{-3}$ PPC3, 15.0 mg·cm$^{-3}$ PCBM-C60 and 10.0 mg·cm$^{-3}$ P1 is prepared in *o*-xylene + 5% 1-methylnaphthalene. The formulation is stirred for 16 hours at 100 °C. The formulation is coated by doctor blade onto a zinc oxide layer supported by an ITO coated glass substrate at 70 °C. The device is finalized with a PEDOT:PSS Clevios HTL Solar SCA 388 (Heraeus) layer followed by a 150 nm silver layer. The resulting device performance was measured at 100 mW.cm$^{-2}$ under white light illumination in a solar simulator is equipped with AM1.5G filters. The performance measured as an average of 4 27.0 mm$^2$ devices is listed in Table 2.

Table 2: Summary of device performance for Examples C2, D2-D4 before and after heating at 140 °C for 4 hours.

| Example | Polymer | Polyfullerene conc. (mg/cm$^3$) | Voc (mV) | Jsc (mA/cm$^2$) | FF (%) | PCE (%) |
|---|---|---|---|---|---|---|
| C2 (initial) | 1 | 0 | 703 | 7.45 | 57 | 2.96 |
| D2 (initial) | 1 | PPC3 0.38 | 702 | 8.00 | 57 | 3.19 |
| D3 (initial) | 1 | PPC3 0.95 | 674 | 7.72 | 55 | 2.88 |
| D4 (initial) | 1 | PPC3 1.9 | 641 | 7.15 | 51 | 2.35 |
| C2 (4 hours) | 1 | 0 | 858 | 2.96 | 48 | 1.22 |
| D2 (4 hours) | 1 | PPC3 0.38 | 855 | 3.07 | 48 | 1.25 |
| D3 (4 hours) | 1 | PPC3 0.95 | 839 | 3.23 | 45 | 1.23 |
| D4 (4 hours) | 1 | PPC3 1.9 | 695 | 4.61 | 43 | 1.37 |

**Fig. 2** shows the power conversion efficiency as a function of time for the devices of Examples C2 and D2-D4 during continuous heating at 140 °C.

Example D5

A formulation consisting of 18.0 mg·cm$^{-3}$ PCBM-C60 and 12.0 mg·cm$^{-3}$ P1 is prepared in a 85% o-xylene and 15% 1-methylnaphthalene solvent mixture. The formulation is stirred for 16 hours at 90 °C. The formulation is coated by doctor blade onto a PV-E002 layer supported by an ITO coated glass substrate at 70 °C. The device is finalized with a PEDOT:PSS Clevios HTL Solar SCA 388 (Heraeus) layer followed by a 100 nm silver layer. The resulting device performance was measured at 100 mW.cm$^{-2}$ under white light illumination in a solar simulator is equipped with AM1.5G filters. The performance measured as an average of four 15.0 mm$^2$ and four 7.5 mm$^2$ devices is listed in Table 3.

Example D6

A formulation consisting of 18.0 mg·cm$^{-3}$ PCBM-C60, 12.0 mg·cm$^{-3}$ P1 and 3.0 mg·cm$^{-3}$ PPC3 is prepared in a 85% o-xylene and 15% 1-methylnaphthalene solvent mixture. The formulation is stirred for 16 hours at 90 °C. The formulation is coated by doctor blade onto a PV-E002 layer supported by an ITO coated glass substrate at 70 °C. The device is finalized with a PEDOT:PSS Clevios HTL Solar SCA 388 (Heraeus) layer followed by a 100 nm silver layer. The resulting device performance was measured at 100 mW.cm$^{-2}$ under white light illumination in a solar simulator is equipped with AM1.5G filters. The performance measured as an average of four 15.0 mm$^2$ and three 7.5 mm$^2$ devices is listed in Table 3.

Example D7

A formulation consisting of 18.0 mg·cm$^{-3}$ PCBM-C60, 12.0 mg·cm$^{-3}$ P1 and 3.0 mg·cm$^{-3}$ PPC4 is prepared in a 85% *o*-xylene and 15% 1-methylnaphthalene solvent mixture. The formulation is stirred for 16 hours at 90 °C. The formulation is coated by doctor blade onto a PV-E002 layer supported by an ITO coated glass substrate at 70 °C. The device is finalized with a PEDOT:PSS Clevios HTL Solar SCA 388 (Heraeus) layer followed by a 100 nm silver layer. The resulting device performance was measured at 100 mW.cm$^{-2}$ under white light illumination in a solar simulator is equipped with AM1.5G filters. The performance measured as an average of four 15.0 mm$^2$ and three 7.5 mm$^2$ devices is listed in Table 3.

Example D8

A formulation consisting of 18.0 mg·cm$^{-3}$ PCBM-C60, 12.0 mg·cm$^{-3}$ P1 and 3.0 mg·cm$^{-3}$ PPC5 is prepared in a 85% o-xylene and 15% 1-methylnaphthalene solvent mixture. The formulation is stirred for 16 hours at 90 °C. The formulation is coated by doctor blade onto a PV-E002 layer supported by an ITO coated glass substrate at 70 °C. The device is finalized with a PEDOT:PSS Clevios HTL Solar SCA 388 (Heraeus) layer followed by a 100 nm silver layer. The resulting device performance was measured at 100 mW.cm$^{-2}$ under white light illumination in a solar simulator is equipped with AM1.5G filters. The performance measured as an average of four 15.0 mm$^2$ and three 7.5 mm$^2$ devices is listed in Table 3.

Example D9

A formulation consisting of 18.0 mg·cm$^{-3}$ PCBM-C60, 12.0 mg·cm$^{-3}$ P1 and 3.0 mg·cm$^{-3}$ PPC1 is prepared in a 85% *o*-xylene and 15% 1-methylnaphthalene solvent mixture. The formulation is stirred for 16 hours at 90 °C. The formulation is coated by doctor blade onto a PV-E002 layer supported by an ITO coated glass substrate at 70 °C. The device is finalized with a PEDOT:PSS Clevios HTL Solar SCA 388 (Heraeus) layer followed by a 100 nm silver layer. The resulting device performance was measured at 100 mW.cm$^{-2}$ under white light illumination in a solar simulator is equipped with AM1.5G filters. The performance measured as an average of four 15.0 mm$^2$ and three 7.5 mm$^2$ devices is listed in Table 3.

Table 3: Summary of device performance for Examples D5-D9.

| Example | Polymer | Polyfullerene conc. (mg/cm$^3$) | Voc (mV) | Jsc (mA/cm$^2$) | FF (%) | PCE (%) |
|---|---|---|---|---|---|---|
| D5 | 1 | 0 | 750 | 13.00 | 56.4 | 5.49 |
| D6 | 1 | PPC3 3.0 | 757 | 9.78 | 51.7 | 3.82 |
| D7 | 1 | PPC4 3.0 | 740 | 10.86 | 50.7 | 4.07 |
| D8 | 1 | PPC5 3.0 | 765 | 11.06 | 53.0 | 4.49 |
| D9 | 1 | PPC1 3.0 | 737 | 12.27 | 43.1 | 3.90 |

Example D10

A formulation consisting of 15.0 mg·cm$^{-3}$ P3HT and 12.0 mg·cm$^{-3}$ PPC3 is prepared in *o*-xylene. The formulation is stirred for 16 hours at 80 °C. The formulation is coated by doctor blade onto a zinc oxide layer supported by an ITO coated glass substrate at 65 °C. The device is finalized with a PEDOT:PSS Clevios HTL Solar SCA 388 (Heraeus) layer followed by a 150 nm silver layer. The resulting device performance was measured at 100 mW.cm$^{-2}$ under white light illumination in a solar simulator is equipped with AM1.5G filters. The performance measured as an average of four 27.0 mm$^2$ devices is listed in Table 4.

Example C3 - Comparison Example

A formulation consisting of 12.0 mg·cm$^{-3}$ PCBM-C60 and 15.0 mg·cm$^{-3}$ P3HT is prepared in *o*-xylene. The formulation is stirred for 16 hours at 80 °C. The formulation is coated by doctor blade onto a zinc oxide layer supported by an ITO coated PET substrate at 65 °C. The device is finalized with a PEDOT:PSS Clevios HTL Solar SCA 388 (Heraeus) layer followed by a 150 nm silver layer. The resulting device performance was measured at 100 mW.cm$^{-2}$ under white light illumination in a solar simulator is equipped with AM1.5G filters. The performance measured as an average of seven 27.0 mm$^2$ devices is listed in Table 4.

Table 4: Summary of device performance for Examples D10 before and after heating at 120 °C for 100 hours.

| Example | Polymer | Polyfullerene conc. (mg/cm$^3$) | Voc (mV) | Jsc (mA/cm$^2$) | FF (%) | PCE (%) |
|---|---|---|---|---|---|---|
| D10 (initial) | P3HT | PPC3 12 | 706 | 1.56 | 51 | 0.56 |
| D10 (100 hours) | P3HT | PPC3 12 | 648 | 1.55 | 44 | 0.44 |
| C3 (initial) | P3HT | 0 | 537 | 7.27 | 47 | 1.85 |

(continued)

| Example | Polymer | Polyfullerene conc. (mg/cm$^3$) | Voc (mV) | Jsc (mA/cm$^2$) | FF (%) | PCE (%) |
|---|---|---|---|---|---|---|
| C3 (100 hours) | P3HT | 0 | 338 | 1.37 | 33 | 0.15 |

**D) Findings**

The use of poly pyrrolidinofullerenes (PPC1, PPC3, PPC4, or PPC5) at low quantities (0.3 to 3.0 mg·cm$^{-3}$) significantly improves the thermal stability of the active layer and the resulting device. This improvement is specifically pronounced at long timeframes and at high temperatures. Low loadings of the PPC3 between 0.3 mg·cm$^{-3}$ and 1.0 mg·cm$^{-3}$ offers high performances and enhanced stability (see **Fig. 2**). These advantages are demonstrated for both polymers P1 and P3HT and at temperatures of 100°C up to 140°C. The use of different sidechains for example with polymer PPC5 can offer higher starting performances when combined with polymer P1 (see Table 3). The use of pyrrolidinofullerenes, for example PPC3, as the sole electron acceptor also demonstrates high thermal stability, albeit with lower power conversion efficiencies.

**Claims**

1. A polyfullerene consisting of di- or polyvalent units of formula I1 and divalent units of formula I2

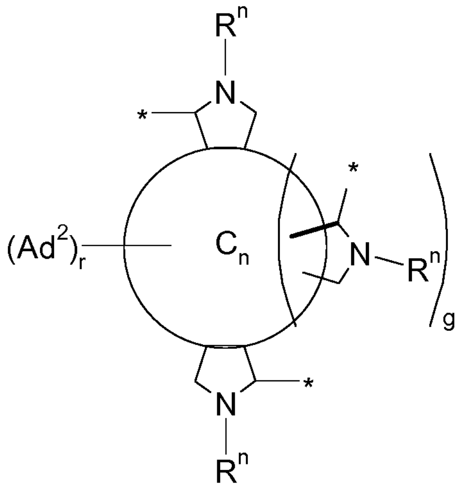

I1

*-Ar-* I2

wherein the individual radicals, independently of each other, and on each occurrence identically or differently, have the following meanings

$C_n$ a fullerene composed of n carbon atoms, optionally with one or more atoms trapped inside,
$R^n$ alkyl with 1 to 12 C-atoms,
g 0 or an integer ≥ 1,
Ar is selected of formula 17

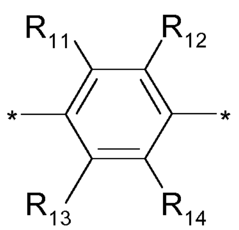

17

$R^{11}$, $R^{14}$ H,
$R^{12}$, $R^{13}$ halogen, CN, an alkyl group with 1 to 50 C atoms, which is straight-chain, branched or cyclic, and in which one or more $CH_2$ groups are optionally replaced by -O-, -S-,-C(=O)-, -C(=S)-, -C(=O)-O-, -O-C(=O)-, $-NR^0-$, $-C(=O)-NR^0-$, $-NR^0-C(=O)-$, $-SiR^0R^{00}-$, $-CF_2-$, $-CR^0=CR^{00}-$,$-CR^0=N-$, -N=N- or -C≡C- in such a manner that O and/or S atoms are not linked directly to one another, and/or in which one or more H atoms are optionally replaced by F, Cl or CN, and/or in which one or more C or H atoms are optionally replaced by a cationic or anionic group, a saturated or unsaturated carbo- or heterocyclic group, or an aryl, heteroaryl, aryloxy or heteroaryloxy group, wherein each of the aforementioned cyclic groups is mono- or polycyclic, does optionally contain fused rings, and is optionally substituted by one or more identical or different groups L,
L F, Cl, -CN, or an alkyl group with 1 to 20 C atoms, which is straight-chain, branched or cyclic, and in which one or more $CH_2$ groups are optionally replaced by -O-, -S-,-C(=O)-, -C(=S)-, -C(=O)-O-, -O-C(=O)-, $-NR^0-$, $-C(=O)-NR^0-$, $-NR^0-C(=O)-$, $-SiR^0R^{00}-$, $-CF_2-$, $-CR^0=CR^{00}-$,$-CR^0=N-$, -N=N- or -C≡C- in such a manner that O and/or S atoms are not linked directly to one another, and/or in which one or more H atoms are optionally replaced by F, Cl or CN, and/or in which one or more C or H atoms are optionally replaced by a cationic or anionic group,
$R^0$ and $R^{00}$ H or alkyl with 1 to 12 C-atoms,
$Ad^2$ a second adduct, or a combination of second adducts, appended to the fullerene $C_n$ with any connectivity,
r 0, an integer ≥ 1, or a non-integer > 0,

**2.** The polyfullerene of claim 1, which contains units of formula I1 wherein g is 0 and units of formula I1 wherein g is ≥1.

**3.** The polyfullerene of claim 1 or 2, wherein $C_n$ in formula I is C60 or C70.

**4.** The polyfullerene according to any one of claims 1 to 3, wherein $R^{12}$ and $R^{13}$ are selected from the group consisting of the following formulae

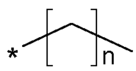
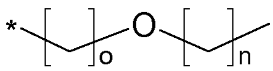
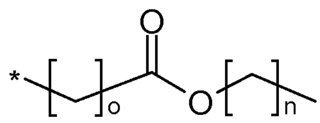

C-1 C-2 C-3

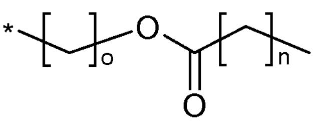
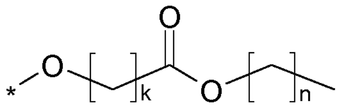
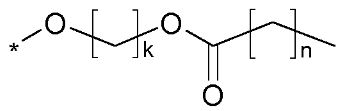

C-4 C-5 C-6

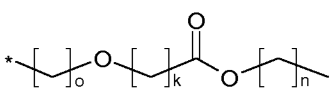
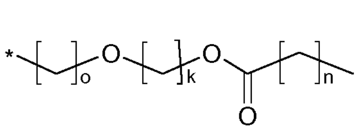
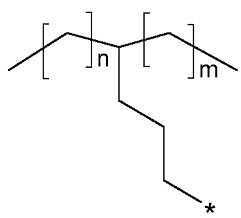

C-7 C-8 C-9

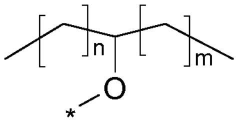
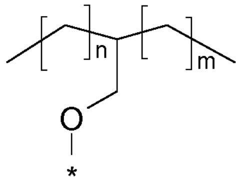
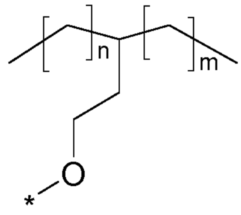

C-10 C-11 C-12

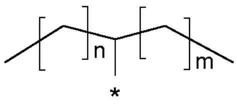
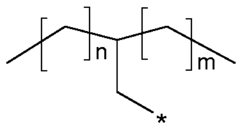
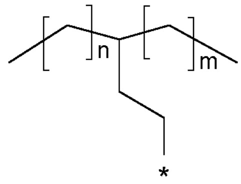

C-13 C-14 C-15

wherein

k is an integer from 1 to 20, preferably from 2 to 12,
m is 0 or an integer from 1 to 20, preferably from 2 to 12,
n is 0 or an integer from 1 to 30, preferably from 6 to 24,
o is 0 or an integer from 1 to 20, preferably from 2 to 12,

and wherein one or more H atoms are optionally replaced by F.

**5.** The polyfullerene according to any one of claims 1 to 4, wherein $R^{12}$ and $R^{13}$ are selected from F, Cl, CN, alkyl, alkoxy, thioalkyl, alkylcarbonyl, alkxoycarbonyl and alkylcarbonyloxy with 1 to 30, preferably 12 to 30 C atoms, which are optionally mono-, poly- or perfluorinated.

**6.** The polyfullerene according to any one of claims 1 to 5, wherein $R^{12}$ and $R^{13}$ denote alkoxy with 1 to 30 C atoms.

**7.** The polyfullerene according to any one of claims 1 to 6, wherein the fullerene $C_n$ in the unit of formula I1 contains one or more second adducts $Ad^2$ as defined in claim 1.

**8.** The polyfullerene according to claim 7, wherein the second adduct $Ad^2$ is selected from the following formulae

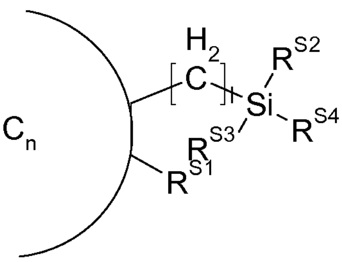
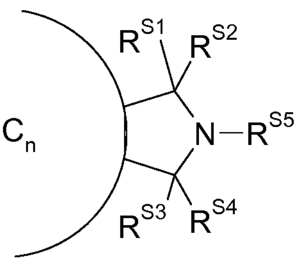

S-1 S-2

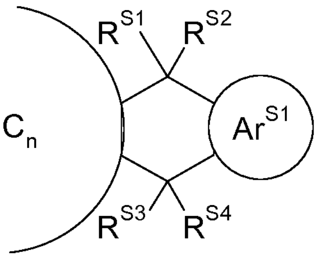

S-3

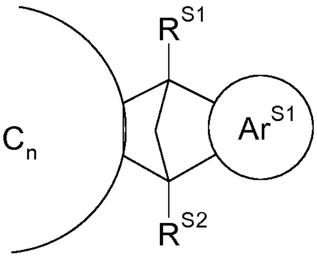

S-4

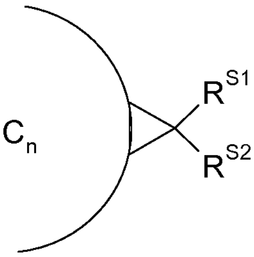

S-5

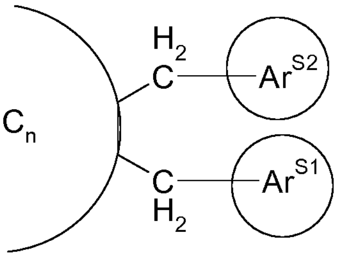

S-6

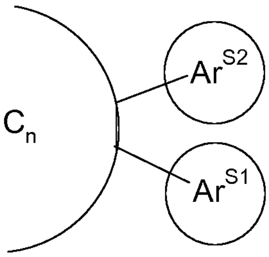

S-7

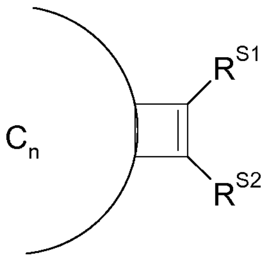

S-8

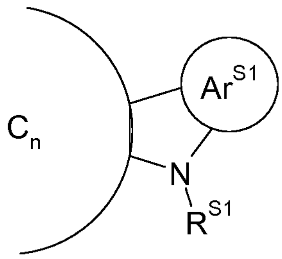

S-9

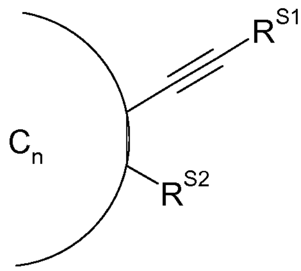

S-10

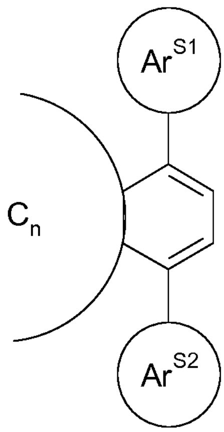

S-11

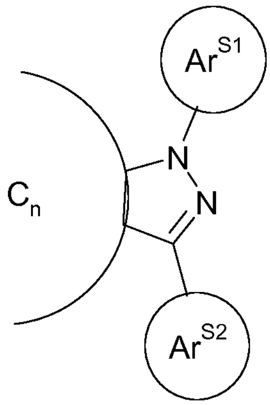

S-12

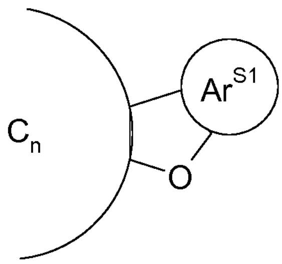

S-13

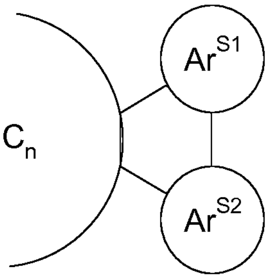

S-14

wherein $R^{S1}$, $R^{S2}$, $R^{S3}$, $R^{S4}$ and $R^{S5}$ independently of each other denote H, halogen or CN, or have one of the meanings of $R^{12}$ as given in claim 1, 4, 5 or 6, and $Ar^{S1}$ and $Ar^{S2}$ denote independently of each other a double bond, a saturated or unsaturated, non-aromatic carbo- or heterocyclic group, or an aryl, heteroaryl, aryloxy or heteroaryloxy group, wherein each of the aforementioned groups has 5 to 20 ring atoms, is mono- or polycyclic, does optionally contain fused rings, and is optionally substituted by one or more identical or different groups L as defined in claim 1.

**9.** The polyfullerene according to claim 8, wherein $R^{S1}$, $R^{S2}$, $R^{S3}$, $R^{S4}$ and $R^{S5}$ are independently of each other selected from alkyl, alkoxy, thioalkyl, alkoxycarbonyl and alkylcarbonyloxy with 1 to 30, preferably 2 to 20 C atoms, which are optionally mono-, poly- or perfluorinated, furthermore aryl, aryloxy, aryloxycarbonyl, arylcarbonyloxy, heteroaryl, heteroaryloxy, heteroaryloxycarbonyl and heteroarylcarbonyloxy with 5 to 15 ring atoms which are optionally substituted by one or more groups L as defined in claim 1.

**10.** The polyfullerene according to claim 8 or 9, wherein the fullerene $C_n$ in the unit of formula I1 contains one or more second adducts $Ad^2$ selected of formula S-5, wherein one substituent R is benzene, thiophene or naphthalene which are optionally substituted by one or more groups $R^{11}$, and the other substituent R is an ester group.

**11.** The polyfullerene according to claim 10, wherein the substituent R that is an ester group is selected from formula C-3 as defined in claim 4, wherein o is 1, 2, 3, 4, 5, or 6, and n is an integer from 1 to 12.

**12.** A mixture comprising an n-type organic semiconductor which is a polyfullerene according to any one of claims 1 to 11 and a p-type organic semiconductor, and optionally further comprising an n-type organic semiconductor which is a fullerene or fullerene derivative that is different from the polyfullerene.

**13.** The mixture according to claim 12, wherein the p-type organic semiconductor is a conjugated polymer.

**14.** The mixture according to claim 12 or 13, wherein the p-type organic semiconductor is selected from poly(3-substituted thiophene) and poly(3-substituted selenophene).

**15.** The mixture according to any one of claims 12 to 14, wherein the p-type organic semiconductor is a conjugated polymer comprising one or more units of formula 1 and one or more units of formula 2

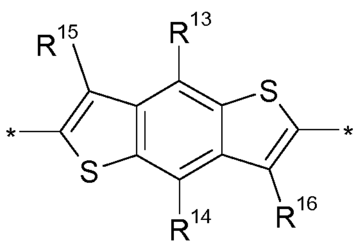

1

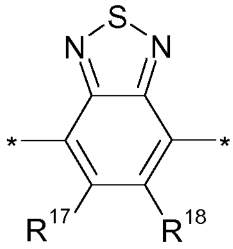

2

wherein the individual radicals, independently of each other, and on each occurrence identically or differently, have the following meanings

$R^{13-18}$ H, straight-chain or branched alkyl with 1 to 30 C atoms, in which one or more $CH_2$ groups are optionally replaced by -O-, -S-, -C(O)-, -C(S)-, -C(O)-O-, -O-C(O)-, $-NR^0-$, $-SiR^0R^{00}-$,$-CF_2-$, $-CHR^0=CR^{00}-$, $-CY^1=CY^2-$ or -C≡C- in such a manner that O and/or S atoms are not linked directly to one another, and in which one or more H atoms are optionally replaced by F, Cl or CN,
$R^0$, $R^{00}$ H or alkyl with 1 to 12 C-atoms,
$Y^1$, $Y^2$ H, F, Cl or CN.

**16.** The mixture according to claim 15, wherein the p-type organic semiconductor is a conjugated polymer comprising selected from the following subformulae

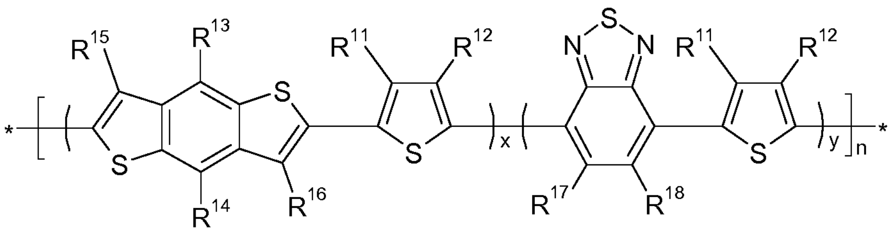

P1

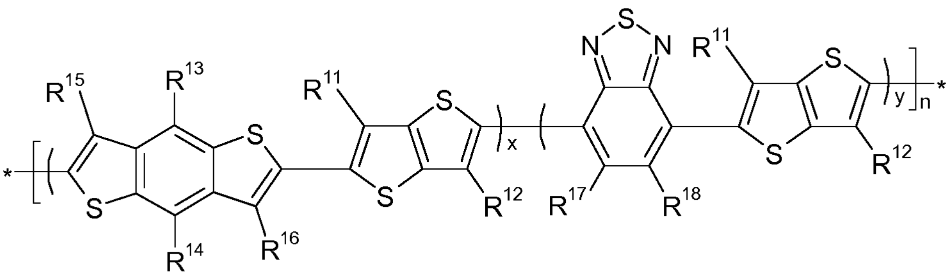

P2

wherein $R^{11-16}$ have one of the meanings of $R^{13}$ in claim 15, x is > 0 and ≤ 1, y is > 0 and < 1, x+y is 1, and n is an integer >1.

**17.** The mixture according to any of claims 12 to 16, further comprising an n-type organic semiconductor which is a fullerene or fullerene derivative which is different from the polyfullerene of claims 1 to 11.

**18.** The mixture according to claim 17, wherein the said fullerene or fullerene derivative is PCBM-C60 or PCBM-C70.

**19.** A formulation comprising a mixture or polyfullerene according to any of claims 1 to 18, and further comprising one or more organic solvents.

**20.** A bulk heterojunction (BHJ) which comprises, or is being formed from, a polyfullerene, mixture or formulation according to any of claims 1 to 19.

**21.** Use of a polyfullerene, mixture, formulation or BHJ according to any one of claims 1 to 20 in the photoactive layer of an organic electronic (OE) device that converts light into electric current.

22. A photoactive layer in an OE device that converts light into electric current, wherein said photoactive layer comprises, or is being formed from, a polyfullerene, mixture, formulation or BHJ according to any of claims 1 to 20.

23. An OE device that converts light into electric current, which comprises in its photoactive layer a polyfullerene, mixture, formulation or BHJ according to any of claims 1 to 20.

24. The OE device of claim 23, which is an organic photovoltaic device (OPV) or an organic photodetector (OPD).

25. The OE, OPV or OPD device of claim 23 or 24, which is an organic solar cell, dye sensitized solar cell (DSSC), perovskite-based solar cell, laser diode, Schottky diode, organic sensor or photoconductor.

**Patentansprüche**

1. Polyfulleren, bestehend aus zwei- oder mehrwertigen Einheiten der Formel I1 und zweiwertigen Einheiten der Formel I2

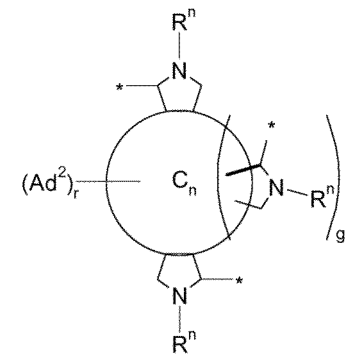

I1

*-Ar-* I2

wobei die einzelnen Radikale unabhängig voneinander und bei jedem Auftreten gleich oder verschieden die folgenden Bedeutungen aufweisen
$C_n$: ein Fulleren, zusammengesetzt aus n Kohlenstoffatomen, wahlweise mit einem oder mehreren im Inneren eingeschlossenen Atomen,
$R^n$: Alkyl mit 1 bis 12 C-Atomen,
g: 0 oder eine ganze Zahl $\geq 1$,
Ar ist ausgewählt aus Formel 17

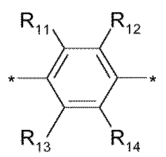

17

$R^{11}$, $R^{14}$: H,
$R^{12}$, $R^{13}$: Halogen, CN, eine Alkylgruppe mit 1 bis 50 C-Atomen, die geradkettig, verzweigt oder cyclisch ist und bei der eine oder mehrere $CH_2$-Gruppen wahlweise so durch -O-, -S-, -C(=O)-, -C(=S)-, -C(=O)-O-, -O-C(=O)-, $-NR^0-$, $-C(=O)-NR^0-$, $- NR^0-C(=O)-$, $-SiR^0R^{00}-$, $-CF_2-$, $-CR^0=CR^{00}-$, $-CR^0=N-$, -N=N- oder -C≡C- ersetzt sind, dass O- und/oder S-Atome nicht direkt miteinander verknüpft sind, und/oder bei der ein oder mehrere H-Atome wahlweise durch F, Cl oder CN ersetzt sind und/oder bei der ein oder mehrere C- oder H-Atome wahlweise durch eine kationische oder anionische Gruppe, eine gesättigte oder ungesättigte carbo- oder heterocyclische Gruppe oder eine Aryl-, Heteroaryl-, Aryloxy- oder Heteroaryloxy-Gruppe ersetzt sind, wobei jede der zuvor genannten cyclischen Gruppen mono- oder polycyclisch ist, wahlweise kondensierte Ringe enthält und wahlweise durch eine oder mehrere gleiche oder verschiedene Gruppen L substituiert ist,
L: F, Cl, -CN oder eine Alkylgruppe mit 1 bis 20 C-Atomen, die geradkettig, verzweigt oder cyclisch ist und bei

der eine oder mehrere $CH_2$-Gruppen wahlweise so durch -O-, -S-, -C(=O)-, -C(=S)-, -C(=O)-O-, -O-C(=O)-, $-NR^0-$, $-C(=O)-NR^0-$, $-NR^0-C(=0)-$, $-SiR^0R^{00}-$, $-CF_2-$, - $CR^0=CR^{00}-$, $-CR^0=N-$, -N=N- oder -C≡C- ersetzt sind, dass O- und/oder S-Atome nicht direkt miteinander verknüpft sind, und/oder bei der ein oder mehrere H-Atome wahlweise durch F, Cl oder CN ersetzt sind und/oder bei der ein oder mehrere C- oder H-Atome wahlweise durch eine kationische oder anionische Gruppe ersetzt sind,

$R^0$ und $R^{00}$: H oder Alkyl mit 1 bis 12 C-Atomen,

$Ad^2$: ein zweites Addukt oder eine Kombination von zweiten Addukten, angehängt an das Fulleren $C_n$ mit einer beliebigen Verbindungsfähigkeit,

r: 0, eine ganze Zahl ≥ 1 oder ein nicht ganzzahliger Wert > 0.

**2.** Polyfulleren nach Anspruch 1, das Einheiten der Formel I1, wobei g 0 ist, und Einheiten der Formel I1, wobei g ≥ 1 ist, enthält.

**3.** Polyfulleren nach Anspruch 1 oder 2, wobei $C_n$ in Formel I C60 oder C70 ist.

**4.** Polyfulleren nach einem der Ansprüche 1 bis 3, wobei $R^{12}$ und $R^{13}$ ausgewählt sind aus der Gruppe, bestehend aus den folgenden Formeln

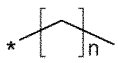
C-1

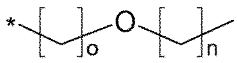
C-2

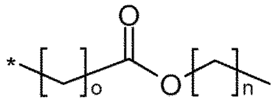
C-3

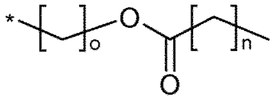
C-4

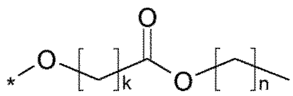
C-5

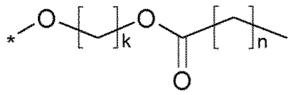
C-6

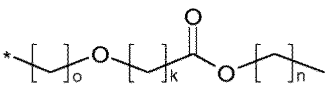
C-7

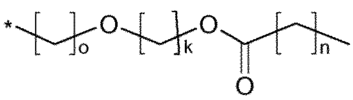
C-8

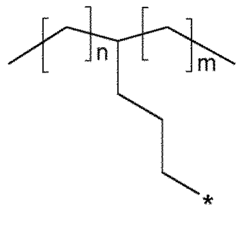
C-9

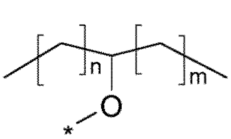
C-10

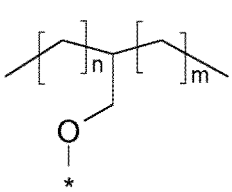
C-11

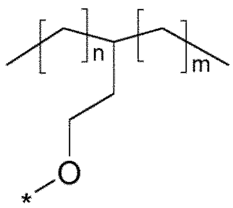
C-12

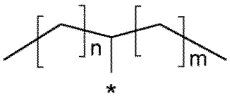 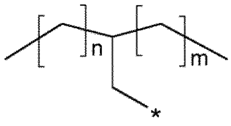 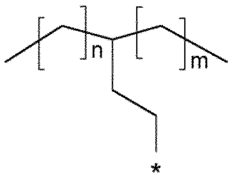

C-13 C-14 C-15

wobei

k eine ganze Zahl von 1 bis 20, vorzugsweise von 2 bis 12 ist,
m 0 oder eine ganze Zahl von 1 bis 20, vorzugsweise von 2 bis 12 ist,
n 0 oder eine ganze Zahl von 1 bis 30, vorzugsweise von 6 bis 24 ist,
o 0 oder eine ganze Zahl von 1 bis 20, vorzugsweise von 2 bis 12 ist,
und wobei ein oder mehrere H-Atome wahlweise durch F ersetzt sind.

**5.** Polyfulleren nach einem der Ansprüche 1 bis 4, wobei $R^{12}$ und $R^{13}$ ausgewählt sind aus F, Cl, CN, Alkyl, Alkoxy, Thioalkyl, Alkylcarbonyl, Alkoxycarbonyl und Alkylcarbonyloxy mit 1 bis 30, vorzugsweise 12 bis 30 C-Atomen, die wahlweise mono-, poly- oder perfluoriert sind.

**6.** Polyfulleren nach einem der Ansprüche 1 bis 5, wobei $R^{12}$ und $R^{13}$ Alkoxy mit 1 bis 30 C-Atomen bezeichnen.

**7.** Polyfulleren nach einem der Ansprüche 1 bis 6, wobei das Fulleren $C_n$ in der Einheit der Formel I1 ein oder mehrere zweite Addukte $Ad^2$ wie in Anspruch 1 definiert enthält.

**8.** Polyfulleren nach Anspruch 7, wobei das zweite Addukt $Ad^2$ aus den folgenden Formeln ausgewählt ist

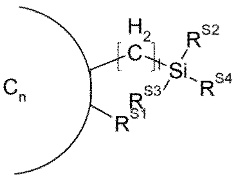 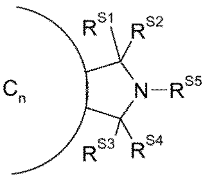

S-1 S-2

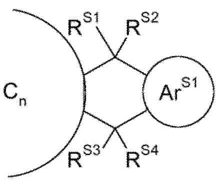 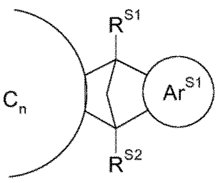

S-3 S-4

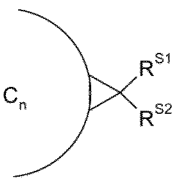 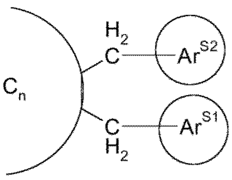 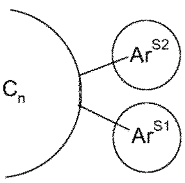

S-5 S-6 S-7

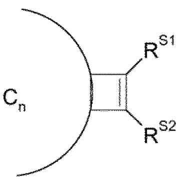

S-8

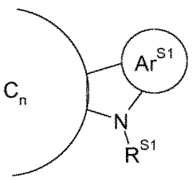

S-9

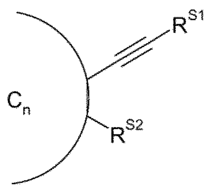

S-10

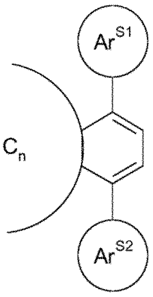

S-11

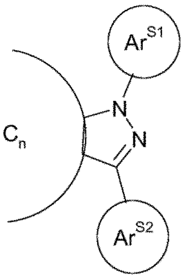

S-12

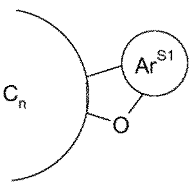

S-13

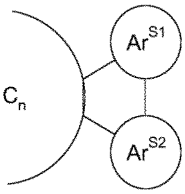

S-14

wobei $R^{S1}$, $R^{S2}$, $R^{S3}$, $R^{S4}$ und $R^{S5}$ unabhängig voneinander H, Halogen oder CN bezeichnen oder eine der Bedeutungen von $R^{12}$ wie in Anspruch 1, 4, 5 oder 6 angegeben aufweisen, und $Ar^{S1}$ und $Ar^{S2}$ unabhängig voneinander eine Doppelbindung, eine gesättigte oder ungesättigte, nicht aromatische carbo- oder heterocyclische Gruppe oder eine Aryl-, Heteroaryl-, Aryloxy- oder Heteroaryloxy-Gruppe bezeichnen, wobei jede der zuvor genannten Gruppen 5 bis 20 Ringatome aufweist, mono- oder polycyclisch ist, wahlweise kondensierte Ringe enthält und wahlweise durch eine oder mehrere gleiche oder verschiedenen Gruppen L wie in Anspruch 1 definiert substituiert ist.

**9.** Polyfulleren nach Anspruch 8, wobei $R^{S1}$, $R^{S2}$, $R^{S3}$, $R^{S4}$ und $R^{S5}$ unabhängig voneinander ausgewählt sind aus Alkyl, Alkoxy, Thioalkyl, Alkoxycarbonyl und Alkylcarbonyloxy mit 1 bis 30, vorzugsweise 2 bis 20 C-Atomen, die wahlweise mono-, poly- oder perfluoriert sind, weiterhin Aryl, Aryloxy, Aryloxycarbonyl, Arylcarbonyloxy, Heteroaryl, Heteroaryloxy, Heteroaryloxycarbonyl und Heteroarylcarbonyloxy mit 5 bis 15 Ringatomen, die wahlweise durch eine oder mehrere Gruppen L wie in Anspruch 1 definiert substituiert sind.

**10.** Polyfulleren nach Anspruch 8 oder 9, wobei das Fulleren $C_n$ in der Einheit der Formel I1 ein oder mehrere zweite Addukte $Ad^2$, ausgewählt aus Formel S-5, enthält, wobei ein Substituent R Benzol, Thiophen oder Naphthalin ist, die wahlweise durch eine oder mehrere Gruppen $R^{11}$ substituiert sind, und der andere Substituent R eine Estergruppe ist.

**11.** Polyfulleren nach Anspruch 10, wobei der Substituent R, der eine Estergruppe ist, ausgewählt ist aus Formel C-3 wie in Anspruch 4 definiert, wobei 0 1, 2, 3, 4, 5 oder 6 ist und n eine ganze Zahl von 1 bis 12 ist.

**12.** Mischung, umfassend einen organischen Halbleiter vom n-Typ, der ein Polyfulleren nach einem der Ansprüche 1 bis 11 ist, und einen organischen Halbleiter vom p-Typ, und wahlweise weiter umfassend einen organischen Halbleiter vom n-Typ, der ein Fulleren oder Fullerenderivat ist, das von dem Polyfulleren verschieden ist.

**13.** Mischung nach Anspruch 12, wobei der organische Halbleiter vom p-Typ ein konjugiertes Polymer ist.

**14.** Mischung nach Anspruch 12 oder 13, wobei der organische Halbleiter vom p-Typ ausgewählt ist aus Poly(3-substituiertem Thiophen) und Poly(3-substituiertem Selenophen).

**15.** Mischung nach einem der Ansprüche 12 bis 14, wobei der organische Halbleiter vom p-Typ ein konjugiertes Polymer ist, das eine oder mehrere Einheiten der Formel 1 und eine oder mehrere Einheiten der Formel 2 umfasst

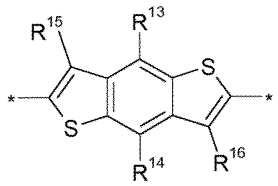

1

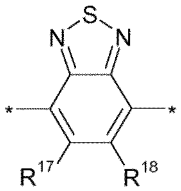

2

wobei die einzelnen Radikale unabhängig voneinander und bei jedem Auftreten gleich oder verschieden die folgenden Bedeutungen aufweisen

$R^{13-18}$: H, geradkettiges oder verzweigtes Alkyl mit 1 bis 30 C-Atomen, bei dem eine oder mehrere $CH_2$-Gruppen wahlweise so durch -O-, -S-, -C(O)-, -C(S)-, -C(O)-O-, -O-C(O)-, $-NR^0-$, $-SiR^0R^{00}-$, $-CF_2-$, $-CHR^0=CR^{00}-$, $-CY^1=CY^2-$ oder -C≡C- ersetzt sind, dass O- und/oder S-Atome nicht direkt miteinander verknüpft sind, und bei dem ein oder mehrere H-Atome wahlweise durch F, Cl oder CN ersetzt sind,

$R^0$, $R^{00}$: H oder Alkyl mit 1 bis 12 C-Atomen,

$Y^1$, $Y^2$: H, F, Cl oder CN.

**16.** Mischung nach Anspruch 15, wobei der organische Halbleiter vom p-Typ ein konjugiertes Polymer ist, umfassend ausgewählt aus den folgenden Unterformeln

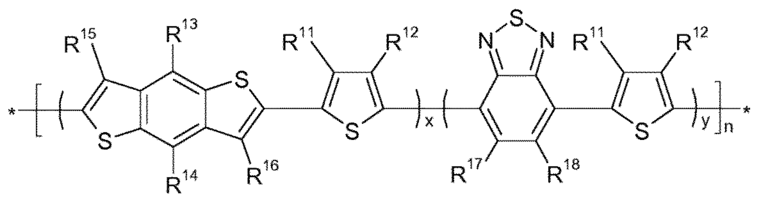

P1

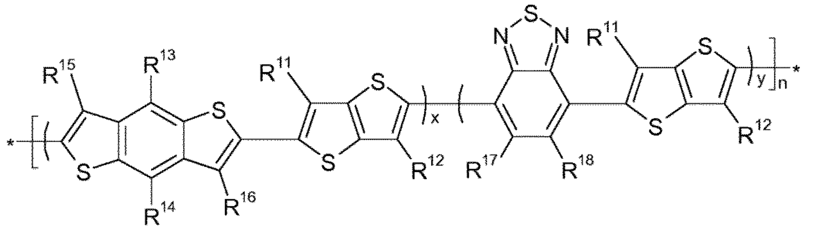

P2

wobei $R^{11-16}$ eine der Bedeutungen von $R^{13}$ in Anspruch 15 aufweisen, x > 0 und ≤ 1, y > 0 und < 1 und n eine ganze Zahl > 1.

**17.** Mischung nach einem der Ansprüche 12 bis 16, weiter umfassend einen organischen Halbleiter vom n-Typ, der ein Fulleren oder Fullerenderivat ist, das von dem Polyfulleren nach Anspruch 1 bis I1 verschieden ist.

**18.** Mischung nach Anspruch 17, wobei das Fulleren oder Fullerenderivat PCBM-C60 oder PCBM-C70 ist.

**19.** Formulierung, umfassend eine Mischung oder ein Polyfulleren nach einem der Ansprüche 1 bis 18 und weiter

umfassend ein oder mehrere organische Lösemittel.

**20.** Misch-Heteroübergang (bulk heterojunction, BHJ), der ein Polyfulleren, eine Mischung oder Formulierung nach einem der Ansprüche 1 bis 19 umfasst oder daraus gebildet ist.

**21.** Verwendung eines Polyfullerens, einer Mischung, Formulierung oder eines BHJ nach einem der Ansprüche 1 bis 20 in der photoaktiven Schicht einer organischen elektronischen (OE) Vorrichtung, die Licht in elektrischen Strom umwandelt.

**22.** Photoaktive Schicht in einer OE-Vorrichtung, die Licht in elektrischen Strom umwandelt, wobei die photoaktive Schicht ein Polyfulleren, eine Mischung, Formulierung oder einen BHJ nach einem der Ansprüche 1 bis 20 umfasst oder daraus gebildet ist.

**23.** OE-Vorrichtung, die Licht in elektrischen Strom umwandelt, welche in ihrer photoaktiven Schicht ein Polyfulleren, eine Mischung, Formulierung oder einen BHJ nach einem der Ansprüche 1 bis 20 umfasst.

**24.** OE-Vorrichtung nach Anspruch 23, die eine organische photovoltaische Vorrichtung (OPV) oder ein organischer Photodetektor (OPD) ist.

**25.** OE-, OPV- oder OPD-Vorrichtung nach Anspruch 23 oder 24, die eine organische Solarzelle, eine farbstoffsensibilisierte Solarzelle (dye sensitized solar cell, DSSC), eine perowskit-basierte Solarzelle, eine Laserdiode, eine Schottky-Diode, ein organischer Sensor oder ein Photoleiter ist.

## Revendications

**1.** Polyfullerène consistant en des motifs di- ou poly-valents de formule I1 et des motifs divalents de formule I2

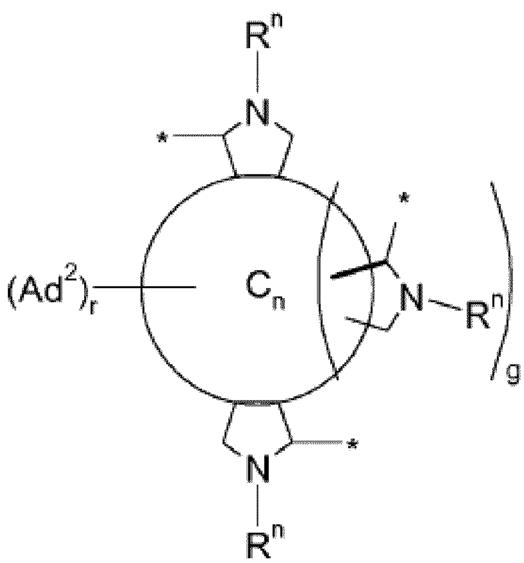

I1

*-Ar-* I2

dans lesquelles les radicaux individuels, indépendamment les uns des autres, et à chaque occurrence de manière identique ou différente, ont les significations suivantes

$C_n$ un fullerène composé de n atomes de carbone, facultativement avec un ou plusieurs atomes piégés à l'intérieur,

$R^n$ un alkyle présentant 1 à 12 atomes de carbone,

g 0 ou un nombre entier ≥ 1,

Ar est sélectionné parmi la formule 17

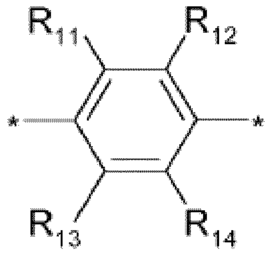

17

$R^{11}$, $R^{14}$ H,

$R^{12}$, $R^{13}$ un halogène, CN, un groupe alkyle présentant 1 à 50 atomes C, qui est à chaîne linéaire, ramifié ou cyclique, et dans lequel un ou plusieurs groupes $CH_2$ sont facultativement remplacés par -O-, -S-, -C(=O)-, -C(=S)-, -C(=O)-O-, -O-C(=O)-, $-NR^0-$, $-C(=O)-NR^0-$, $-NR^0-C(=O)-$, $-SiR^0R^{00}-$, $-CF_2-$, $-CR^0=CR^{00}-$, $-CR^0=N-$, -N=N- ou -C≡C- d'une manière telle que des atomes O et/ou S ne sont pas liés directement les uns aux autres, et/ou dans lequel un ou plusieurs atomes H sont facultativement remplacés par F, Cl ou CN, et/ou dans lequel un ou plusieurs atomes C ou H sont facultativement remplacés par un groupe cationique ou anionique, un groupe carbo- ou hétéro-cyclique saturé ou insaturé, ou un groupe aryle, hétéroaryle, aryloxy ou hétéroaryloxy, dans lequel chacun des groupes cycliques susmentionnés est mono- ou poly-cyclique, contient facultativement des cycles fusionnés, et est facultativement substitués avec un ou plusieurs groupes L identiques ou différents,

L F, Cl, -CN, ou un groupe alkyle présentant 1 à 20 atomes C, qui est à chaîne linéaire, ramifiée ou cyclique, et dans lequel un ou plusieurs groupes $CH_2$ sont facultativement remplacés par -O-, -S-, -C(=O)-, -C(=S)-, -C(=O)-O-, -O-C(=O)-, $-NR^0-$, $- C(=O)-NR^0-$, $-NR^0-C(=0)-$, $-SiR^0R^{00}-$, $-CF_2-$, $-CR^0=CR^{00}-$, $-CR^0=N-$, -N=N- ou -C≡C- d'une manière telle que des atomes O et/ou S ne sont pas liés directement les uns aux autres, et/ou dans lequel un ou plusieurs atomes H sont facultativement remplacés par F, Cl ou CN, et/ou dans lequel un ou plusieurs atomes C ou H sont facultativement remplacés par un groupe cationique ou anionique,

$R^0$ et $R^{00}$ H ou un alkyle présentant 1 à 12 atomes C,

$Ad^2$ un second adduit, ou une combinaison de seconds adduits, ajouté au fullerène $C_n$ avec n'importe quelle connectivité,

r 0, un nombre entier ≥ 1, ou un nombre non entier > 0,

**2.** Polyfullerène selon la revendication 1, qui contient des motifs de formule I1 dans laquelle g est 0 et des motifs de formule I1 dans laquelle g est ≥ 1.

**3.** Polyfullerène selon la revendication 1 ou 2, dans lequel $C_n$ dans la formule I est en C60 ou en C70.

**4.** Polyfullerène selon l'une quelconque des revendications 1 à 3, dans lequel $R^{12}$ et $R^{13}$ sont sélectionnés dans le groupe consistant en les formules suivantes

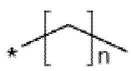

C-1

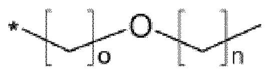

C-2

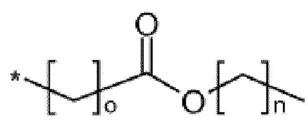

C-3

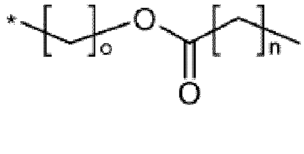

C-4

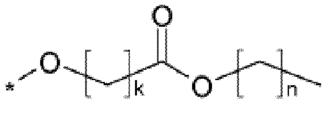

C-5

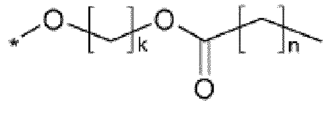

C-6

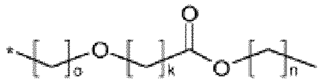

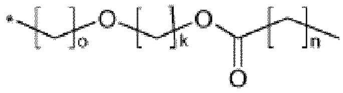

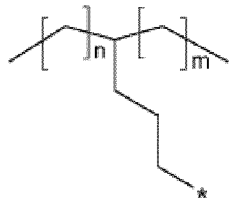

C-7 C-8 C-9

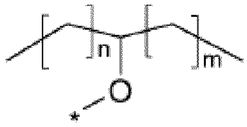

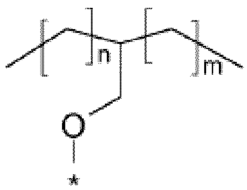

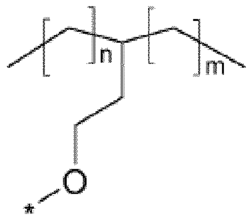

C-10 C-11 C-12

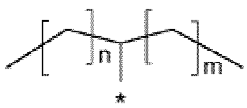

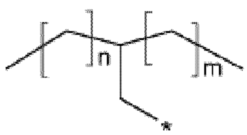

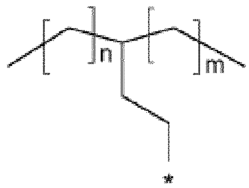

C-13 C-14 C-15

dans lesquelles

k est un nombre entier de 1 à 20, de préférence de 2 à 12,
m est 0 ou un nombre entier de 1 à 20, de préférence de 2 à 12,
n est 0 ou est un nombre entier de 1 à 30, de préférence de 6 à 24,
o est 0 ou un nombre entier de 1 à 20, de préférence de 2 à 12,
et dans lequel un ou plusieurs atomes H sont facultativement remplacés par F.

**5.** Polyfullerène selon l'une quelconque des revendications 1 à 4, dans lequel $R^{12}$ et $R^{13}$ sont sélectionnés parmi F, Cl, CN, un alkyle, un alcoxy, un thioalkyle, un alkylcarbonyle, un alcoxycarbonyle et un alkylcarbonyloxy présentant 1 à 30, de préférence 12 à 30 atomes C, qui sont facultativement mono-, poly- ou per-fluorés.

**6.** Polyfullerène selon l'une quelconque des revendications 1 à 5, dans lequel $R^{12}$ et $R^{13}$ indiquent un alcoxy présentant 1 à 30 atomes C.

**7.** Polyfullerène selon l'une quelconque des revendications 1 à 6, dans lequel le fullerène $C_n$ dans le motif de formule I1 contient un ou plusieurs seconds adduits $Ad^2$ tels que définis dans la revendication 1.

**8.** Polyfullerène selon la revendication 7, dans lequel le second adduit $Ad^2$ est sélectionné parmi les formules suivantes

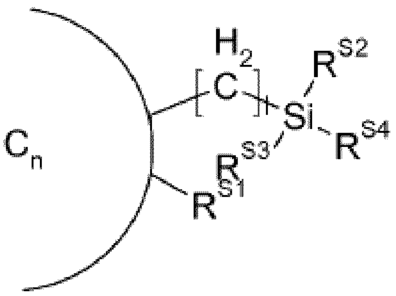

S-1

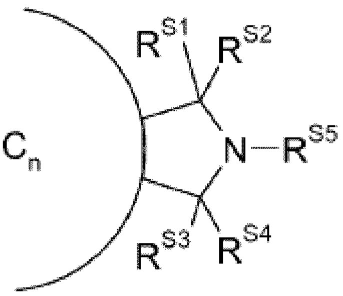

S-2

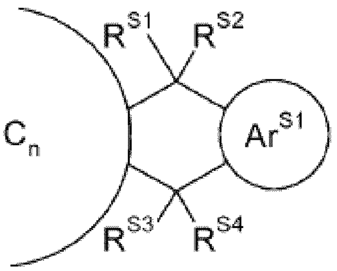

S-3

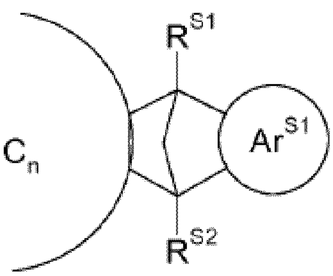

S-4

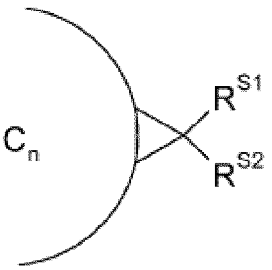

S-5

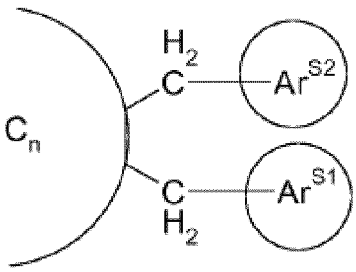

S-6

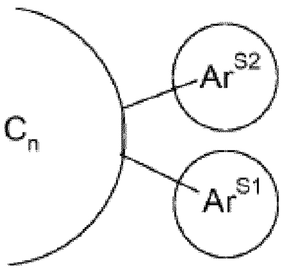

S-7

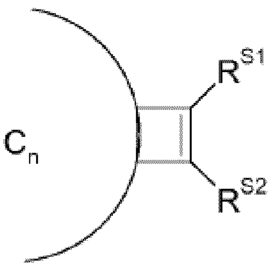

S-8

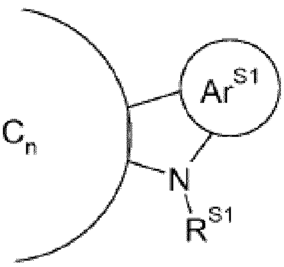

S-9

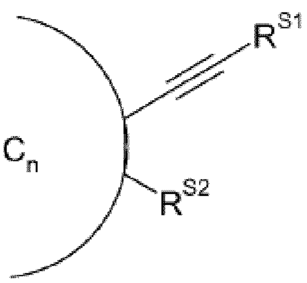

S-10

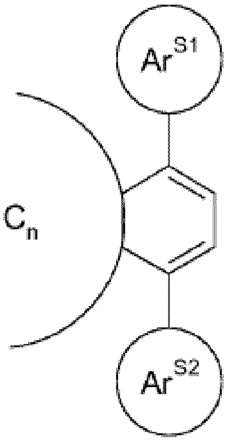

S-11

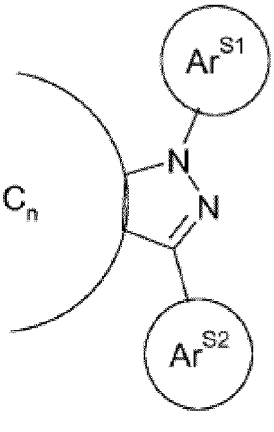

S-12

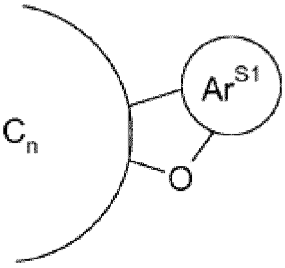

S-13

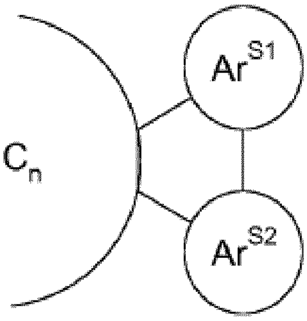

S-14

dans lesquelles $R^{S1}$, $R^{S2}$, $R^{S3}$, $R^{S4}$ et $R^{S5}$ indépendamment les uns des autres indiquent H, un halogène ou CN, ou ont l'une des significations de $R^{12}$ telles que données dans la revendication 1, 4, 5 ou 6, et $Ar^{S1}$ et $Ar^{S2}$ indiquent indépendamment l'un de l'autre une liaison double, un groupe carbo- ou hétéro-cyclique non aromatique, saturé ou insaturé, ou un groupe aryle, hétéroaryle, aryloxy ou hétéroaryloxy, dans lequel chacun des groupes susmentionnés présente 5 à 20 atomes de cycle, est mono- ou poly-cyclique, contient facultativement des cycles fusionnés, et est facultativement substitué avec un ou plusieurs groupes L identiques ou différents tels que définis dans la revendication 1.

**9.** Polyfullerène selon la revendication 8, dans lequel $R^{S1}$, $R^{S2}$, $R^{S3}$, $R^{S4}$ et $R^{S5}$ sont sélectionnés indépendamment les uns des autres parmi un alkyle, un alcoxy, un thioalkyle, un alcoxycarbonyl et un alkylcarbonyloxy présentant 1 à 30, de préférence 2 à 20 atomes C, qui sont facultativement mono-, poly- ou per-fluorés, en outre un aryle, un aryloxy, un aryloxycarbonyle, un arylcarbonyloxy, un hétéroaryle, un hétéroaryloxy, un hétéroaryl-oxycarbonyle et un hétéroarylcarbonyloxy présentant 5 à 15 atomes de cycle qui sont facultativement substitués avec un ou plusieurs groupes L tels que définis dans la revendication 1.

**10.** Polyfullerène selon la revendication 8 ou 9, dans lequel le fullerène $C_n$ dans le motif de formule I1 contient un ou plusieurs seconds adduits $Ad^2$ sélectionné parmi le formule S-5, dans lequel un substituant R est un benzène, un thiophène ou un naphtalène qui sont facultativement substitués avec un ou plusieurs groupes $R^{11}$, et l'autre substituant R est un groupe ester.

**11.** Polyfullerène selon la revendication 10, dans lequel le substituant R qui est un groupe ester est sélectionné parmi la formule C-3 telle que définie dans la revendication 4, dans laquelle 0 est 1, 2, 3, 4, 5 ou 6, et n est un nombre entier de 1 à 12.

**12.** Mélange comprenant un semi-conducteur organique de type n qui est un polyfullerène selon l'une quelconque des revendications 1 à 11 et un semi-conducteur organique de type p, et comprenant en outre facultativement un semi-conducteur organique de type n qui est un fullerène ou un dérivé de fullerène qui est différent du polyfullerène.

**13.** Mélange selon la revendication 12, dans lequel le semi-conducteur organique de type p est un polymère conjugué.

**14.** Mélange selon la revendication 12 ou 13, dans lequel le semi-conducteur organique de type p est sélectionné parmi un poly(thiophène substitué en 3) et un poly(sélénophène substitué en 3).

**15.** Mélange selon l'une quelconque des revendications 12 à 14, dans lequel le semi-conducteur organique de type p est un polymère conjugué comprenant un ou plusieurs motifs de formule 1 et un ou plusieurs motifs de formule 2

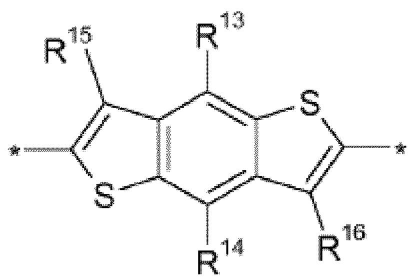

1

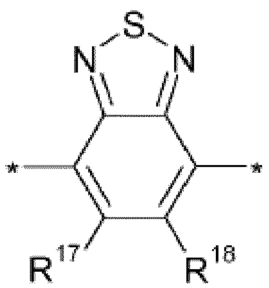

2

dans lequel les radicaux individuels, indépendamment les uns des autres, et à chaque occurrence de manière identique ou différente, ont les significations suivantes
$R^{13}$ à $R^{18}$ H, un alkyle à chaîne linéaire ou ramifié présentant 1 à 30 atomes C, dans lequel un ou plusieurs groupes $CH_2$ sont facultativement remplacés par -O-, -S-, - C(O)-, -C(S)-, -C(O)-O-, -O-C(O)-, $-NR^0-$, $-SiR^0R^{00}-$, $-CF_2-$, $-CHR^0=CR^{00}-$, $-CY^1=CY^2-$ ou C≡C- d'une manière telle que des atomes O et/ou S ne sont pas liés directement les uns aux autres, et dans lequel un ou plusieurs atomes H sont facultativement remplacés par F, Cl ou CN,
$R^0$, $R^{00}$ H ou un alkyle présentant 1 à 12 atomes C,
$Y^1$, $Y^2$ H, F, Cl ou CN.

**16.** Mélange selon la revendication 15, dans lequel le semi-conducteur organique de type p est un polymère conjugué comprenant sélectionné parmi les sous-formules suivantes

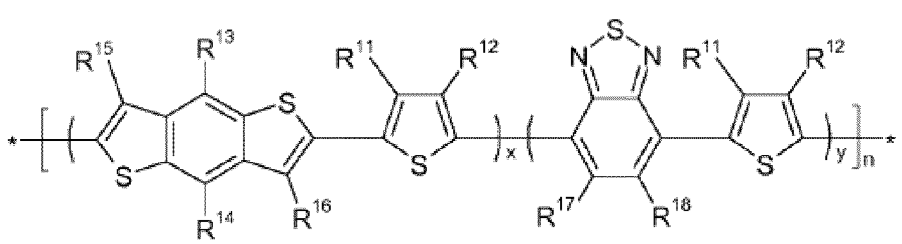

P1

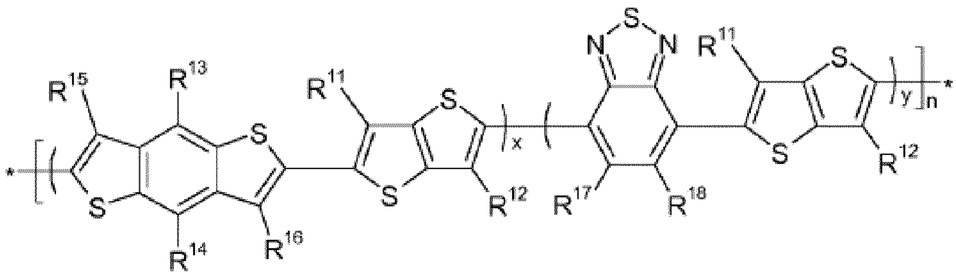

P2

dans lesquelles $R^{11}$ à $R^{16}$ ont l'une des significations de $R^{13}$ dans la revendication 15, x est > 0 et ≤ 1, y est > 0 et < 1, x + y est 1, et n est un nombre entier > 1.

**17.** Mélange selon l'une quelconque des revendications 12 à 16, comprenant en outre un semi-conducteur organique de type n qui est un fullerène ou un dérivé de fullerène qui est différent du polyfullerène selon les revendications 1 à 11.

**18.** Mélange selon la revendication 17, dans lequel ledit fullerène ou dérivé de fullerène est le PCBM-C60 ou le PCBM-C70.

**19.** Formulation comprenant un mélange ou un polyfullerène selon l'une quelconque des revendications 1 à 18, et comprenant en outre un ou plusieurs solvants organiques.

**20.** Hétérojonction en volume (BHJ) qui comprend un polyfullerène, un mélange ou une formulation selon l'une quelconque des revendications 1 à 19 ou est formée à partir d'un polyfullerène, d'un mélange ou d'une formulation selon l'une quelconque des revendications 1 à 19.

**21.** Utilisation d'un polyfullerène, d'un mélange, d'une formulation ou d'une BHJ selon l'une quelconque des revendications 1 à 20 dans la couche photoactive d'un dispositif électronique organique (EO) qui convertit une lumière en courant électrique.

**22.** Couche photoactive dans un dispositif EO qui convertit une lumière en courant électrique, dans laquelle ladite couche photoactive comprend un polyfullerène, un mélange, une formulation ou une BHJ selon l'une quelconque des revendications 1 à 20 ou est formée à partir d'un polyfullerène, d'un mélange, d'une formulation ou d'une BHJ selon l'une quelconque des revendications 1 à 20.

**23.** Dispositif EO qui convertit une lumière en courant électrique, qui comprend dans sa couche photoactive un polyfullerène, un mélange, une formulation ou une BHJ selon l'une quelconque des revendications 1 à 20.

**24.** Dispositif EO selon la revendication 23, qui est un dispositif photovoltaïque organique (OPV) ou un photodétecteur organique (OPD).

**25.** Dispositif EO, OPV ou OPD selon la revendication 23 ou 24, qui est une cellule solaire organique, une cellule solaire à colorant (DSSC), une cellule solaire à base de pérovskite, une diode laser, une diode Schottky, un capteur organique ou un photoconducteur

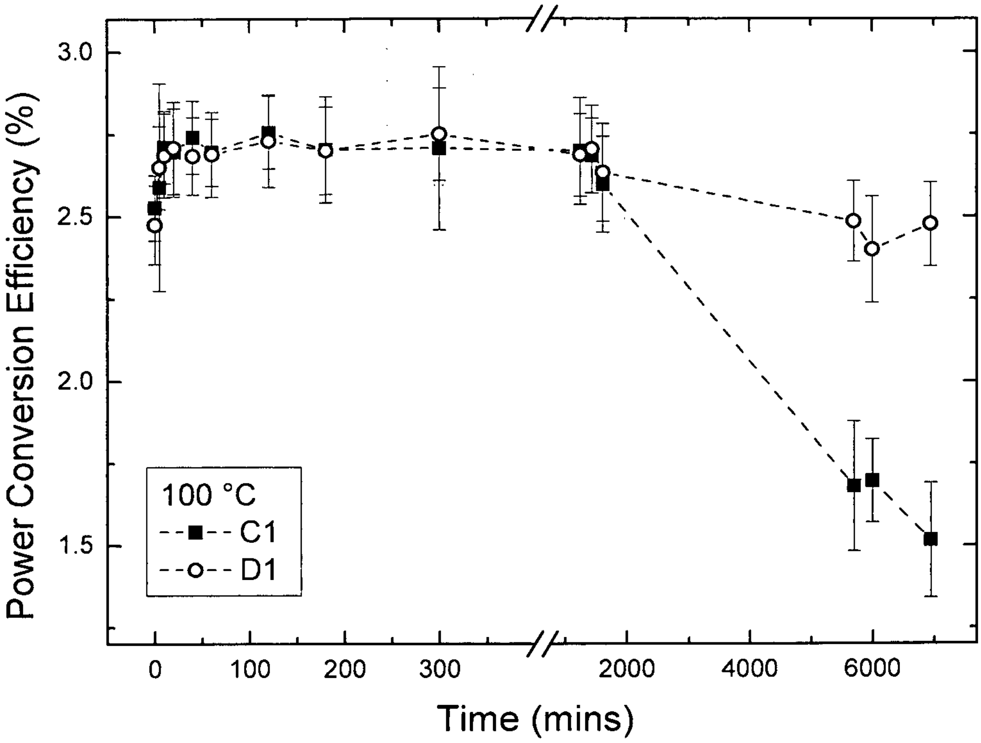


Figure 1

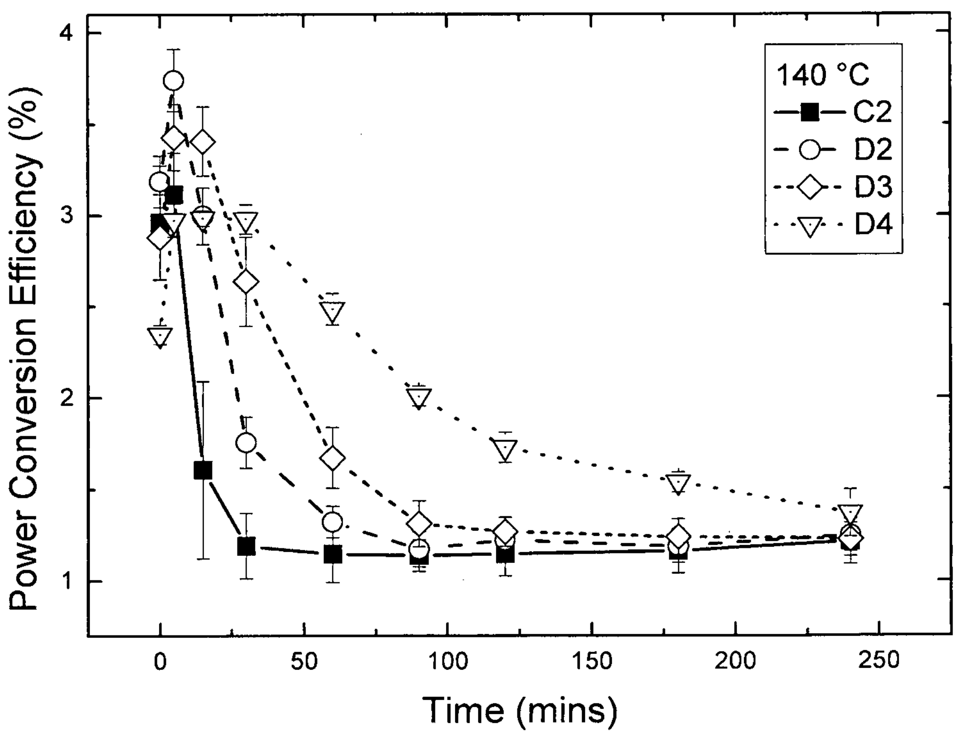


Figure 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011126993 A
- WO 2012056904 A1
- US 20130306944 A1
- WO 2010008672 A
- WO 2010049323 A
- WO 2011131280 A
- WO 2011052709 A
- WO 2011052710 A
- US 20110017956 A
- WO 2012030942 A
- US 8334456 B2
- WO 0053656 A1
- WO 2004022626 A1
- WO 03048225 A2
- WO 2005014688 A2
- WO 2005055248 A1
- WO 2012095796 A1
- WO 2013021971 A1
- WO 2013171520 A1


### Non-patent literature cited in the description


- *Adv. Funct. Mater.,* 2011, vol. 21, 1723-1732
- *Chem. Rev.,* 2006, vol. 106, 5136-5190
- *Chem. Commun.,* 2010, vol. 46, 6723-6725
- *J. Polym. Sci. Pol. Chem.,* 2009, vol. 47 (9), 2304-2317
- *Pure Appl. Chem.,* 1996, vol. 68, 2291
- International Union of Pure and Applied Chemistry, Compendium of Chemical Technology, Gold Book, Version 2.3.2. 19 August 2012, 477, , 480
- **J. THEWLIS.** Concise Dictionary of Physics. Pergamon Press, 1973
- *Pure Appl. Chem.,* 1994, vol. 66, 1134
- **J. M. G. COWIE.** Polymers: Chemistry & Physics of Modern Materials. Blackie, Glasgow, 1991
- *Pure Appl. Chem.,* 2009, vol. 81, 351
- *Adv. Energy Mater.,* 2014, vol. 4, 1300693
- **C. THILGEN ; F. DIEDERICH.** *Top. Curr. Chem.,* 1999, vol. 199, 135-171
- *ACS Nano,* 2014, vol. 8 (2), 1297-1308
- *J. Chem. Soc., Chem. Commun.,* 1977, 683-684
- **T. YAMAMOTO et al.** *Prog. Polym. Sci.,* 1993, vol. 17, 1153-1205
- **Z. BAO et al.** *J. Am. Chem. Soc.,* 1995, vol. 117, 12426-12435
- *Adv. Mater.,* 2013, vol. 25 (17), 2385-2396
- *Adv. Ener. Mater.*
- *Adv. Mater.,* 2013, vol. 25 (48), 7038-7044
- *J. Mater. Chem.,* 2011, vol. 21, 12331
- *J. Appl. Phys.,* 2013, vol. 113, 124509
- *Adv. Energy Mater.,* 2012, vol. 2, 82-86
- **WALDAUF et al.** *Appl. Phys. Lett.,* 2006, vol. 89, 233517
- **DENNLER et al.** *Proceedings of the IEEE,* 2005, vol. 93 (8), 1429
- **HOPPE et al.** *Adv. Func. Mater,* 2004, vol. 14 (10), 1005
- **J. PEET et al.** *Nat. Mater.,* 2007, vol. 6, 497
- **FRÉCHET.** *J. Am. Chem. Soc.,* 2010, vol. 132, 7595-7597
- *Chem. Rev.,* 2010, vol. 110, 6595-6663
- *Angew. Chem. Int. Ed,* 2014, vol. 53, 2-15